(19) Europäisches Patentamt
European Patent Office
Office européen des brevets

(11) EP 1 667 241 B1

(12) EUROPEAN PATENT SPECIFICATION

(45) Date of publication and mention of the grant of the patent:
**07.12.2016 Bulletin 2016/49**

(21) Application number: **04771806.9**

(22) Date of filing: **18.08.2004**

(51) Int Cl.:
***H01L 33/00*** *(2010.01)* ***H01L 33/20*** *(2010.01)*
***H01L 21/20*** *(2006.01)* *H01L 33/22 (2010.01)*
*H01L 33/38 (2010.01)*

(86) International application number:
**PCT/JP2004/011845**

(87) International publication number:
**WO 2005/018008 (24.02.2005 Gazette 2005/08)**

# (54) SEMICONDUCTOR LIGHT EMITTING DIODE AND METHOD OF MANUFACTURING THE SAME

HALBLEITER-LEUCHTDIODE UND VERFAHREN ZU DEREN HERSTELLUNG

DIODE ÉLECTROLUMINESCENTE SEMI-CONDUCTRICE ET SON PROCÉDÉ DE FABRICATION

(84) Designated Contracting States:
**AT BE BG CH CY CZ DE DK EE ES FI FR GB GR HU IE IT LI LU MC NL PL PT RO SE SI SK TR**

(30) Priority: **19.08.2003 JP 2003294775**

(43) Date of publication of application:
**07.06.2006 Bulletin 2006/23**

(73) Proprietor: **Nichia Corporation**
**Anan-shi Tokushima 774-8601 (JP)**

(72) Inventors:
- **Tanaka, Hisanori**
**Anan-shi,**
**Tokushima 7748601 (JP)**
- **Hosokawa, Yasunobu**
**Anan-shi,**
**Tokushima 7748601 (JP)**
- **Shibutani, Yuuki**
**Anan-shi,**
**Tokushima 7748601 (JP)**

(74) Representative: **Eisenführ Speiser**
**Patentanwälte Rechtsanwälte PartGmbB**
**Johannes-Brahms-Platz 1**
**20355 Hamburg (DE)**

(56) References cited:

| | |
|---|---|
| **WO-A1-02/103813** | **JP-A- 2002 280 611** |
| **JP-A- 2003 197 961** | **US-A- 6 091 085** |
| **US-A1- 2003 057 444** | **US-B1- 6 514 782** |

- **GUAN J J ET AL: "CHEMICAL PROCESSING AND MATERIALS COMPATIBILITY OF HIGH-K DIELECTRIC MATERIALS FOR ADVANCED GATE STACKS", DIFFUSION AND DEFECT DATA. SOLID STATE DATA. PART B, SOLID STATEPHENOMENA, VADUZ, LI, vol. 76-77, 1 January 2001 (2001-01-01), pages 19-22, XP008075750, ISSN: 1012-0394**
- **YAMADA, M. ET AL: 'InGaN-Based Near-Ultraviolet and Blue-Light-Emitting Diodes with high external quantum efficiency using a patterned sapphire substrate and a mesh electrode' THE JAPAN SOCIETY OF APPLIED PHYSICS vol. 41, no. 12B, 2002, pages L 1431 - L 1433, XP001162408**
- **TADATOMO, K. ET AL: 'High output power InGaN ultraviolet light-emitting diodes fabricated on patterned substrates using metalorganic vapor phase epitaxi' THE JAPAN SOCIETY OF APPLIED PHYSICS vol. 40, no. 6B, 15 June 2001, pages L 583 - L 585, XP001078012**

EP 1 667 241 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The present invention relates to a semiconductor light emitting device having protrusions provided on a substrate and, more particularly, to a semiconductor light emitting diode (LED) that improves its external efficiency by having the protrusions provided on the substrate.

A semiconductor light emitting device, in the present case, a light emitting diode (LED) essentially comprises an n-type semiconductor layer, an active layer and a p-type semiconductor layer laminated on a substrate in this order. Electrodes are formed on the p-type semiconductor layer and on the n-type semiconductor layer. Light is generated in a light emitting region of the active layer through recombination of holes injected from the p-type semiconductor layer and electrons injected from the n-type semiconductor layer. The light is extracted to the outside from the surface whereon the electrode is formed, or from the back surface of the substrate where semiconductor layer is not formed.

A light emitting diode having such a structure as described above requires to control the laminated structure of semiconductor at atomic-layer level, and for this purpose, it is a common practice to process the substrate surface to mirror finish. The semiconductor layers and the electrodes are formed parallel to each other on the substrate, and a light-propagating portion is formed so that light propagates through the semiconductor portion. The light-propagating portion is formed so that a semiconductor layer having a high refractive index is sandwiched between the substrate and the electrode, both of which have lower refractive indices. The waveguide is interposed between the p-type semiconductor layer-electrode interface and the substrate-electrode interface.

When light generated in the semiconductor layer enters with an angle of incidence not smaller than the critical angle with respect to the interfaces with the electrodes or the interface with the substrate, the light laterally propagates while repeating total reflection within the semiconductor layer. As a result, light is trapped within the waveguide and cannot be extracted to the outside efficiently. In addition, part of light is absorbed while laterally propagating with repeating total reflection within the semiconductor layer, resulting in lower external quantum efficiency.

A method of roughing the top surface and side faces of the light emitting diode chip has been proposed, but it causes damage on the semiconductor layer and results in cracks and/or other trouble. This leads to partial breakage of p-n junction and reduction in effective light emitting region.

Yamada M. et al.: "InGaN-Based Near-Ultraviolet and Blue-Light-Emitting Diodes with High External Quantum Efficiency Using a Patterned Sapphire Substrate and a Mesh Electrode", Japanese Journal of Applied Physics, Vol. 41, no. 12B, Part 2, 15 December 2002, pages L1431-L1433, XP001162408, discloses improving the extraction efficiency of emission light from the InGaN-based light-emitting diode (LED) chips grown on sapphire substrates. Two new techniques were adopted in the fabrication of these LEDs. One is to grow nitride films on the patterned sapphire substrate (PSS) in order to scatter emission light. Another is to use a rhodium (Rh) mesh electrode for p-GaN contact instead of Ni/Au translucent electrode in order to reduce the optical absorption by the p-contact electrode. Fabricated were near-ultraviolet (n-UV) and blue LEDs using the above-mentioned techniques. When the n-UV (400 nm) LED was operated at a forward current of 20 mA at room temperature, the output power and the external quantum efficiency were estimated to be 22.0 mW and 35.5%, respectively. When the blue (460 nm) LED was operated at a forward current of 20 mA at room temperature, the output power and the external quantum efficiency were estimated to be 18.8 mW and 34.9% respectively.

US 2003/0057444 A1 discloses that a high external quantum efficiency is stably secured in a semiconductor light emitting device. At least one recess and/or protruding portion is created on the surface portion of a substrate for scattering or diffracting light generated in a light emitting region. The recess and/or protruding portion has a shape that prevents crystal defects from occurring in semiconductor layers.

WO 02/103813 A1 discloses a nitride semiconductor light emitting element being enhanced in light picking-up efficiency and capable of a high-output light emission, comprising, formed on a substrate, a first conductive-type layer, an active layer, and a second conductive-type layer, wherein a third nitride semiconductor layer of InAlGaN functioning as a current constricting layer having an opening is provided between a first nitride semiconductor layer and a second nitride semiconductor layer on the layer within the second conductive layer, and an electrode and a window or a translucent film provided in the window are partly provided on the surface of the second conductive-type layer, thereby enabling a large quantity of light to be picked up from the upper surface.

Guan J. J. et al.: "Chemical Processing and Materials Compatibility of High-K Dielectric Materials for Advanced Gate Stacks", Solid State Phenomena, Vols 76-77 (2001) pages 19-22, XP008075750, discloses that the compatibility of a series of candidate high K gate dielectrics $ZrO_2$, $TiO_2$, $Al_2O_3$, $Ta_2O_5$ and BST with various commonly used processing chemicals was investigated as part of an effort to develop an advanced MOSFET fabrication process. It was found that the thin films of refractory metal oxides $ZrO_2$, $Ta_2O_5$ and $TiO_2$ exhibit an extremely low etch rate in HF, and are essentially inert in other widely used process chemistries such as SC1, SC2, SPM. In contrast, BST and $Al_2O_3$ are not stable in most of the aqueous process chemistries with BST in particular dissolving readily in acidic chemistries such as HF, SC2 and SPM, with an etch rate > 100 nm/min. As a result, the fabrication of model gate stacks with $Ta_2O_5$

and BST as gate dielectrics using a conventional flow normally used for the $SiO_2$/poly MOSFET gate stack appears to be very problematic. Among the issues unveiled was that $Ta_2O_5$ gate dielectric remaining after electrode etch processing for a gate stack of poly/W/$Ta_2O_5$/Si was very difficult to remove using the wet chemistries, preventing normal screen oxide preparation for LDD (or S/D extension) implant. NMOSFETs were successfully fabricated by implanting dopant through the remaining dielectric layer that acts as the screen oxide to form LDD. Transistor data comparable to a $SiO_2$ baseline were obtained. For BST based gate stacks, any aqueous acidic wet clean chemistries will be expected to cause serious undercutting of the gate dielectric due to dissolution.

Japanese Unexamined Patent Publication (Kokai) No. 11-274568 (JP H11 274568 A) proposes a method of increasing the external quantum efficiency by creating recess or protrusion on the surface of a substrate so that light generated in the light emitting region is scattered. This method employs a mechanical process or etching for randomly roughing the surface of a sapphire substrate of a GaN-based LED comprising the sapphire substrate, an n-type GaN layer, a p-type GaN layer and a transparent electrode that are laminated in this order. This process is supposed to scatter the light incident on the sapphire substrate so as to increase the external quantum efficiency.

However, when recess or protrusion having insufficient accuracy due to fine structure thereof is formed on the substrate surface without controlling the shape, the recess or protrusion may have significant notches formed on the side face thereof, resulting in rugged circumference (see appended Fig. 14). A GaN layer grown on such a substrate surface is likely to have pits and/or voids, which in turn make it easier for cracks to occur during regrowth of GaN. This results in lower crystallinity of GaN which decreases the efficiency of light emission (internal quantum efficiency) and thus the external quantum efficiency decreases contrary to the intention. These cracks also lower the reliability of the semiconductor device. Influence of lowering crystallinity of the semiconductor is not limited to light emitting devices such as light emitting diode, but adversely affects other semiconductor devices of light sensor and electronic devices.

When recess or protrusion is formed on the substrate surface whereon a semiconductor is to be grown, the semiconductor may grow with anomaly that may result in various troubles. For example, such troubles may result as deterioration of surface morphology caused by pits formed in the semiconductor layer surface and the like; occurrence of void caused by insufficient semiconductor growth without filling the recess; threading dislocation and other crystalline defect caused in the semiconductor layer by defective growth of the semiconductor; or occurrence of a partial abnormal growth in the wafer surface. Undesirable surface morphology due to pit or other like formed in the surface or poor crystallinity due to crystal defects lead to increase in the electrostatic discharge damage due to leakage current or decreased efficiency of light emission due to subsequently deteriorated crystallinity of the active layer or the like, which may result in unsatisfactory properties of the semiconductor device. Voids caused by recess or protrusion may cause poor crystallinity and/or pit and may also hamper the optical effect of the recess or protrusion in the substrate. When a partial abnormal growth occurs in the wafer, lower yield of device production results.

In consideration of the problems described above, an object of the present invention is to provide a semiconductor light emitting diode (LED) characterized by high reliability including electrostatic discharge tolerance, better crystallinity and high efficiency of light emission, by suppressing the generation of pits and voids in the semiconductor layer due to the formation of protrusions on substrate surface. Another object of the present invention is to provide a semiconductor light emitting diode (LED) that can be manufactured with a high yield of production which achieving stable external quantum efficiency, and a method of manufacturing the same.

According to a first aspect of the invention, there is provided a semiconductor light-emitting diode as set out in claim 1.

According to a second aspect of the invention, there is provided a method of manufacturing a light emitting diode as set out in claim 17.

The semiconductor light emitting diode of an embodiment of the present invention comprises a substrate having protrusions formed in the surface thereof and semiconductor layers formed, from materials different from that of the substrate, on the substrate surface, wherein the side face of the protrusions includes at least two faces of different angles of inclination. The expression "includes at least two faces of different angles of inclination" means that the side face of said protrusions is constituted from two or more sloped surfaces of different angles of inclination with respect to the bottom of each protrusion. Fig. 5A shows an example of cross section of such a protrusion, in which case the side face of the protrusion includes two sloped surfaces having different angles of inclination $\theta_1$ and $\theta_2$. The number of sloped surfaces is not limited to two, but may be larger. That is, angles of inclination are not limited to $\theta_1$ and $\theta_2$, and n kinds of angles of inclination up to $\theta_n$ (n is an integer) may be provided.

The protrusions formed on the substrate surface preferably have convex side faces (that swell toward the outside) as shown in Fig. 5A and Fig. 15. In case, which does not form part of the present invention, a recess is formed in the substrate surface, it is preferable that the inner surface of the recess protrudes toward the inside of the recess. This is because, for example in the case, forming part of the present invention, of a protrusion as shown in Fig. 17A and Fig. 17B, after the semiconductor layer 42 has grown up to the apex of the side face of the protrusion 20, the semiconductor layer 41 grown from the top of the protrusion and the layer 42 grown from the valley between adjacent protrusions join in such a manner that decreases the inclination angle of the side face of the protrusion, so that the joint can be formed smoothly. This enables to suppress the occurrence of abnormal crystal growth such as voids and pits and deterioration of crystallinity. The protruding (swelling) shape of the side face of the protrusions includes not only the beak-shaped protrusion such as shown in Fig. 5A but also convex curved surface as shown in Fig. 15. The protruding (swelling) shape of the side face refers to such a shape as illustrated by a sectional view of Fig. 15 where the side face is on the outside of the straight line that connects the edge of the top face and the edge of the base (or, in the case of a recess, not forming part of the present invention, the side face is on the inside of the straight line that connects the edge of the surface that surrounds top opening and the edge of the bottom). In other words, in the case of protrusions, as defined by the present invention, cross section of the protrusion is wider than a normal trapezoid. In the case of recess, not forming part of the present invention, cross section of the recess is narrower than a normal inverted trapezoid. According to an embodiment of the present invention, a plurality of protruding portions may be provided on the side face of the protrusion. It is preferable, however, that the side face of the protrusion has a single protruding portion as shown in Fig. 5A and Fig. 15, to ensure stable growth of semiconductor on the substrate.

As mentioned previously, the protrusions are preferably formed with high density in order to achieve a high efficiency of extracting light. That is, it is preferable to form small protrusions at small intervals. However, as the protrusions become smaller, it becomes difficult to form satisfactory protrusions due to the limitation of the machining accuracy, and notches are likely to be formed on the side face of the protrusions. In case, not forming part of the present invention, the side face 21 of a protrusion has a constant angle of inclination as shown in Fig. 4B and Fig. 4C, notches 24 formed along the sloped side face 21 reach the top face 20 of the protrusion. This results in rugged circumference of the top face of the protrusion 20 as the notches cut into the circumference of the top face. Such notches are not formed regularly in the substrate surface, but are formed with irregular shapes and sizes. Therefore, occurrence of pits and voids cannot be suppressed simply by controlling the conditions of growing the semiconductor layers.

In contrast, two or more sloped surfaces 22, 23 of different angles of inclination are formed on the side face of the protrusion as shown in Fig. 4A according to an embodiment of the present invention. Thus the notches 24 generated in the lower sloped surface 22 are less likely to reach the top surface of the protrusion 20. In other words, notches down the slope are formed only on the lower first sloped surface among the first and second sloped surfaces 22, 23. The notches extend to reach the boundary of the second sloped surface 23, but do not extend into the second sloped surface. Consequently, the upper second sloped surface 23 is free from notches running along the slope, resulting in smaller roughness of the sloped surface 23.

Abnormal morphology such as pits can be suppressed by growing semiconductor layer on the surface having such protrusions. Forming the protrusions on the substrate surface leads to no significant increase in dislocations formed in the semiconductor layer. This is supposedly because surface roughness of the upper sloped surface is made smaller than that of the lower sloped surface, and the circumference of the top surface of the protrusion is formed smoothly. The expression that "the circumference is formed smoothly" means that there are no substantial notches in the circumference.

In case the protrusion has curved side face, it is supposed that the semiconductor growing from the valley between protrusions has smoother and smaller changes in the shape of the growing region, thus resulting in satisfactory growth. Notches formed on the side face of the protrusion can also be reduced by forming the protrusion with curved side face.

In accordance with the present invention, it is preferable to form at least a first sloped surface and a second sloped surface, from the bottom of the substrate, on the side face of the protrusions with angle of inclination $\theta_1$ of the first sloped surface with respect to the bottom of the protrusions and angle of inclination $\theta_2$ of the second sloped surface with respect to the bottom of the protrusions satisfying the relation $\theta_1 > \theta_2$. Propagation of notches generated on the side face of the protrusions from the first sloped surface to the second sloped surface can be prevented by such a constitution of the sloped surfaces. It is preferable to make the first angle of inclination $\theta_1$ larger since it decreases the depth and size of the notches formed in the first sloped surface.

At least a first sloped surface 22 and a second sloped surface 23 are formed, from the bottom of the substrate, on the side face of the protrusions with surface roughness $Ra_1$ of the first sloped surface 22 and surface roughness $Ra_2$ of the second sloped surface 23 satisfying the relation $Ra_1 > Ra_2$. Generation of voids and the like can be greatly reduced when growing the semiconductor by making the surface roughness $Ra_2$ of the second sloped surface smaller. It is supposed that generation of voids is suppressed because variations in the semiconductor growth rate between the protrusions are suppressed, and the junction between semiconductors is formed at constant point. In case, not according to the present invention, the side face of the protrusion is formed from a single sloped surface as shown in Fig. 14, surface roughness $Ra_3$ of the side face becomes larger than the surface roughness $Ra_1$ or $Ra_2$ of at least one of the sloped surfaces in the case, in accordance with the present invention, of forming two sloped surfaces as described above. Moreover, since the large surface roughness continues to the top surface of the protrusion, not formed in accordance with the present invention, occurrence of voids cannot be avoided even when the conditions of growing the semiconductor is controlled, thus resulting in lower output power. In accordance with the present invention, surface roughness $Ra_2$ of the second sloped surface is preferably 0.1 $\mu$m or less, more preferably 0.01 $\mu$m or less and most preferably 0.005 $\mu$m or less.

As mentioned above, if notches formed on the side face of the protrusion grow upward along the slope to the top surface of the protrusion, crystallinity of the semiconductor to be grown in the subsequent process becomes lower. If notches formed on the first sloped surface do not grow into the second sloped surface, however, good crystallinity of the semiconductor can be achieved. This is because stress generated when growing the semiconductor is relaxed by the first sloped surface where the notches are generated, and generation of voids is suppressed by the second sloped surface where notches are not generated.

Protrusions in accordance with the present invention, as defined by the appended claims, are formed on the substrate surface. It is advantageous to form such protrusions, since it makes it easier to grow the semiconductor layer without voids. When there are voids in the semiconductor layer around a recess or a protrusion, crystallinity of the semiconductor becomes lower and the function of recess or protrusion to scatter or diffract light is impeded, resulting in lower output power of the light emitting device. In order to prevent defects from growing in the semiconductor layer, it is preferable to make the second sloped surface provided on the side face of the protrusions flat. [Plan-view shape of protrusion]

In order to prevent defects from developing in the semiconductor layer, it is preferable to make the second sloped surface in the side face of the protrusions flat. It is also preferable that the protrusions have such a shape that is constituted from straight line segments which cross a plane substantially parallel to the stable growth plane of the semiconductor layer, as viewed from above the protrusions. The "straight line segments which cross a plane substantially parallel to the stable growth plane as viewed from above the substrate" means straight lines that are not parallel to the intersect of the substrate surface and the stable growth plane and are inclined from the line of intersection. The stable growth plane refers to the facet surfaces formed as relatively smooth surfaces during the growth of semiconductor on the substrate. The stable growth plane generally appears as a facet in the course of growth. In the case of gallium nitride semiconductor, for example, any plane (particularly M-plane) parallel to A-axis in the substrate surface is the stable growth plane. Therefore, it is preferable to form the protrusions in polygonal shape constituted from sides (= straight line segments) that are not parallel to a plane parallel to A-axis, namely straight line segments that are not parallel to A-axis. This is because, when the protrusions are formed in a shape consisting of straight line segments that are substantially parallel to the stable growth plane of the semiconductor layer, crystal defects are likely to occur in the portion when growing the semiconductor layer. Crystal defects in the semiconductor layer decrease the internal quantum efficiency, and eventually decrease the external quantum efficiency. Here A-axis refers to the direction normal to the A plane. In case A-axis is inclined from the substrate surface, the angle from the projection of A-axis onto the substrate surface may be considered. Straight line that is not parallel to a plane parallel to A-axis refers to a straight line that is not parallel to A-axis or to the projection of A-axis onto the substrate surface. A plane that is parallel to a plane parallel to A-axis refers to a plane of which intersect with the substrate surface is a straight line that is parallel to A-axis or to the projection of A-axis onto the substrate surface.

Configuration in plan view of the protrusion viewed from above the substrate may be circle, triangle, parallelogram, hexagon or the like. Occurrence of pits and other defects can be suppressed by forming the protrusion in polygons such as triangle, parallelogram or hexagon. More preferably, the protrusion is formed in equilateral triangle, rhombus or equilateral hexagon. Occurrence of pits can be significantly suppressed and the second sloped surface can be easily formed when the protrusions are formed in circles. It also makes it possible to increase the density of protrusions, namely increase the number of protrusions in a unit area, and increase the length and surface area of the side face, thereby increasing the effect of the protrusions to extract light and increasing the output power when it is used as a light emitting element.

In this patent specification, to form the protrusions in polygons or circles means that they have polygonal or circular shape when viewed from above the substrate. When the protrusion is formed to have polygonal shape in plan view, the shape may not be exact polygon in geometrical meaning, and may be rounded at edges for the reason of manufacturing process.

The protrusions are preferably formed in a repetitive pattern of the same shape, such as the pattern of a plurality of protrusions shown in Fig. 7. While a single protrusion may serve the purpose, the efficiency to scatter or diffract light can be improved and external quantum efficiency can be improved further by forming the protrusions in a repetitive pattern. Even when the protrusions are formed in a repetitive pattern, occurrence of crystal defects due to the protrusions can be suppressed by having at least the first and second sloped surfaces, more preferably by having swelled side faces, further preferably by having curved and swelled side faces of protrusions, so entire surface of the substrate can be used as the light emitting surface.

[Size and spacing of protrusions]

Height of the protrusions is preferably 100 Å (10 nm) or more, and more preferably in a range from 1000 to 10000 Å (100 to 1000 nm).

With the wavelength of emitted light (206 nm to 632 nm in the case of a light emission layer made of AlGaInN-based material) denoted as X, sufficient scattering or diffraction of light cannot be achieved unless the height is at least λ/4 or larger. Specifically, since light propagates within the semiconductor layer on the substrate as described above, the height is preferably λ/4n or larger, where n is the refractive index of the medium of propagation. On the other hand, if height of the protrusions goes beyond the range, it becomes necessary to increase the thickness of the semiconductor layer, namely the underneath layer for the structure of element, required for depositing over the protrusions to form a flat surface. When the laminated structure is formed without forming a flat surface over the protrusions of the substrate, it becomes difficult for current to flow along the layer, resulting in lower efficiency of light emission.

Size of the protrusion viewed from above the substrate, or length La of one of the sides that constitute the base of the protrusion, is preferably at least λ/4 or larger, where X is the wavelength of light emitted in the semiconductor (370 nm to 460 nm). When size of the the protrusion is smaller than λ/4, sufficient scattering or diffraction of light cannot be achieved. Here, λ/4 translates into λ/4n, where n is the refractive index of the semiconductor layer that serves as the medium of propagation for the emitted light. Length $L_b$ of one of the sides that constitute the top face of the the protrusion is preferably 1.5 $\mu$m or larger. Forming the protrusions in such a size makes it possible to suppress the occurrence of voids coming up with semiconductor growth. It is more preferable to set the ratio $L_t/L_b$ of length ($L_b$) of bottom of the protrusion to length ($L_t$) of top surface of the protrusion in a range of $1 < L_t/L_b < 2$, and more preferably $1.1 < L_t/L_b < 1.8$. This constitution makes it possible to suppress the occurrence of voids more effectively and to increase the output power by as much as 10% or more.

In order to achieve sufficient scattering or diffraction of light, distance between the protrusions as viewed from above the substrate is preferably λ/4 or larger, similarly to that described above. For example, distance between the protrusions is preferably in a range from 0.5 $\mu$m to 5 $\mu$m inclusive, and more preferably from 1 $\mu$m to 3 $\mu$m inclusive. When the distance is within such a range, the semiconductor layer can be grown efficiently and, consequently, the efficiency of scattering or diffraction can be improved. The distance between the protrusions refers to the minimum distance between adjacent protrusions.

[Sectional shape of protrusion]

Cross sectional shape of the protrusions is preferably trapezoid having side face that consists of two or more faces of different angles of inclination, as in the case of the protrusion shown in Fig. 5A, or a trapezoid having a curved side face that consists of first and second angles of inclination $\theta_1$ and $\theta_2$ as shown in Fig. 15. In the case of a recess, not forming part of the present invention, it preferably has a shape of inverted trapezoid having a side face similar to that described above. Such a trapezoid cross sectional shape makes it possible to further improve the efficiency of scattering or diffraction of light. The cross sectional shape of the protrusions or recess may not be exact trapezoid or inverted trapezoid in geometrical meaning, and may be rounded at edges for the reason of manufacturing process.

In case at least the first sloped surface and the second sloped surface, in this order from the bottom of the substrate, are formed on the side face of the protrusion with angle of inclination $\theta_1$ of the first sloped surface with respect to the bottom of the protrusion and angle of inclination $\theta_2$ of the second sloped surface with respect to the bottom of the protrusion, output power due to scattering or diffraction is improved when angle of inclination $\theta_1$ is larger than 30° and smaller than 90°. When the angle of inclination $\theta$ of the protrusion is too large, the efficiency of scattering or

diffraction decreases contrary to expectation, and pits are more likely to occur in the semiconductor layer. Thus angle of inclination $\theta_1$ is preferably in a range from 45° to 80° inclusive, and preferably in a range from 50° to 70° inclusive. Angle of inclination $\theta_2$ is preferably in a range from 10° to 30° inclusive. Forming the protrusions with angles in such ranges on the substrate surface enables to suppress the occurrence of pits. Angle of inclination $\theta_3$ of the second sloped surface with respect to the top surface of the protrusion is preferably 90° or larger.

In accordance with the present invention, the protrusions each have a convex side face so that the width of the cross section increases at the middle as shown in Fig. 5A or Fig. 15. It is preferable that the inclination angle $\theta_m$ between the line connecting the edge of the bottom and the edge of the top face of the protrusion and the bottom plane of the protrusion is within a range from 20 to 80°, more preferably from 30 to 60°, as shown in Fig. 15. If the inclination angle is too large, light reflecting surface (side face of the protrusion) occupies a smaller proportion of substrate surface, resulting in lower effect of extracting light. If the inclination angle is too small as shown in Figs. 17A, 17B, the semiconductor grown from the valley between adjacent protrusions joins with the semiconductor grown from the top of the protrusion in such a manner as the former creeps below the latter in larger area, leading to the occurrence of defective growth and/or voids.

[Types of substrate and semiconductor]

According to an embodiment of the present invention, there are no limitations to the kinds of materials used to make the substrate and semiconductor. The semiconductor formed on the substrate surface may be a semiconductor based on group III-V elements or a semiconductor based on group II-VI elements. Semiconductors based on group III-V elements include nitride semiconductors, among which GaN-based semiconductor, in particular, is preferably used. The stable growth plane of GaN-based semiconductor is generally M-plane {1-100} of hexagonal crystal system. The notation {1-100} represents all of (1-100), (01-10), (-1010), etc. M-plane is one of the planes that are parallel to A-axis in the substrate surface. Other planes that include A-axis of GaN semiconductor in the substrate surface, namely planes other than M-plane, such as the facet of {1-101} plane may also become the stable growth plane, depending on the growing condition.

As for the substrate, a sapphire substrate, a Si substrate, a SiC substrate or a spinel substrate can be used. For example, a sapphire substrate having a C plane (0001) as the principal plane can be used. In this case, the M-plane that is the stable growth plane of GaN-based semiconductor layer is the plane parallel to A plane {11-20} of the sapphire substrate. The A plane {11-20} represents all of (11-20), (1-210), (-2110), etc.

When nitride semiconductor is grown on C plane of a sapphire substrate, for example, crystal growth begins at hexagonal spots enclosed by planes that include A-axis of the nitride semiconductor, like islands, and the islands eventually join with each other to form a homogeneous semiconductor layer. Therefore, in accordance with the present invention, it is preferable to form the protrusion in such a planar configuration as a polygon (triangle, hexagon, etc.) that is constituted from sides which are perpendicular to straight lines connecting the center and vertices of an equilateral hexagon that is defined by A-axis of the nitride semiconductor as its sides. Side face of the protrusion is formed so as to comprise at least two sloped surfaces, in a protruding shape having two or more inclination angles or in a convex curved surface. The sapphire substrate having the protrusions formed thereon allows to grow nitride semiconductor having flat surface and high crystallinity on the surface thereof. [Structure of light emitting diode having substrate with protrusions]

An embodiment of the present invention provides a semiconductor light emitting diode having high efficiency of extracting light. In this case, while an ohmic electrode 14 formed on the light extracting surface of the semiconductor light emitting device may be formed on substantially the entire surface of the semiconductor layer 13 as shown in Fig. 8A and Fig. 8B, it is preferable to form the ohmic electrode in such a shape that has through holes 18. When a semiconductor layer is formed on the substrate having the protrusions formed thereon, and the electrode having the holes are formed thereon over the entire surface, the efficiency of extracting light is greatly improved by the mutually enhancing effects of both features.

The reason for the above is as described below. When a transparent electrode is formed over the entire surface of the semiconductor layer, part of the light directed upward through scattering or diffraction by the protrusions on the substrate surface is absorbed by the transparent electrode, resulting in lower intensity of the optical output. When an opening is formed in a transparent electrode, or an opening is formed in an opaque electrode having high reflectivity, light directed upward through scattering or diffraction can be extracted to the outside efficiently without being absorbed by the electrode, resulting in improved efficiency of extracting light. It is preferable that at least one protrusion, that is formed on the substrate surface, is included in the opening 18 of the electrode.

In the case of a semiconductor device that employs nitride semiconductor, the ohmic electrode formed on the p-type semiconductor may be made of an alloy that includes at least one kind selected from among a group consisting of Ni, Pd, Co, Fe, Ti, Cu, Rh, Ir, Au, Ru, V, W, Zr, Mo, Ta, Pt, Ag, oxide or nitride of these elements. Electrically conductive metal oxides (oxide semiconductors) such as indium tin oxide (ITO), ZnO, $In_2O_3$ and $SnO_2$ may also be used. Moreover, an alloy layer or a multi-layer film that includes one of the above can also be used. The translucent electrode is preferably made of ITO film in the visible light region. The reflective electrode is preferably made of Al, Ag or Rh for improving the efficiency of extracting light and other

The semiconductor light emitting diode of embodiments of the present invention has an effect of improving the crystallinity of the light emitting region (active layer) and increasing the output power by forming the protrusions that scatter or diffract light in the interface between the semiconductor layer and the substrate instead of the interface between the semiconductor layer and the electrode. According to an embodiment of the present invention, light is scattered or diffracted by the protrusions and is extracted efficiently upward from the semiconductor layer or downward from the substrate, resulting in greatly improved external quantum efficiency, in contrast to a flat substrate of the prior art in which light is transmitted laterally. According to an embodiment of the present invention, first, intensity of light directed upward or downward from the substrate is increased by scattering or diffraction by the protrusions, and accordingly luminance of the light emission surface of the light emitting diode viewed squarely in front thereof (front brightness) is increased. Second, light transmitted along the semiconductor layer is decreased by the effect of scattering or diffraction by the protrusions, thereby reducing the absorption loss due to the transmission, and increasing the optical output.

In addition, according to an embodiment of the present invention, the protrusions are formed to have a side face comprising two or more sloped surfaces, preferably with protruding curved surfaces on the substrate surface, so as to suppress the formation of notches on the side face of the protrusion (Fig. 12, Fig. 13). As a result, the space surrounding the protrusions can be completely filled with the semiconductor layer without causing voids. Thus high external quantum efficiency is achieved and high output power can be maintained stably. When the protrusions are formed in a circular shape, occurrence of pits can be greatly reduced. This improves the yield of production. [Method of manufacturing substrate with protrusions]

Method of manufacturing the substrate used in the light emitting diode in accordance with the present invention will be described below. While protrusions are formed in the example described below, the same method can be applied to a case of forming recesses, although these do not form part of the present invention.

First, an example shown in Figs. 2A through 2D will be described. In this example, the protrusions are formed by etching in two steps. As shown in Figs. 2A and 2B, a protective film 25 of a specified shape is formed as an etching mask on the substrate. Then as shown in Fig. 2C, the substrate is etched so as to form projections 20 (first step). Then as shown in Fig. 2D, after removing the protective film 25 as a whole, the substrate is etched further so as to form the protrusions 20 having two sloped surfaces (second step).

Now an example shown in Figs. 18A through 18D will be described. In this example, the protrusions are formed by etching in three steps. As shown in Fig. 18A, the protective film 25 of a specified shape is formed as an etching mask on the substrate. Then the substrate is etched so as to form the projections 20 as shown in Fig. 18B (first step). In the first step, a part of the protective film 25 is etched to reduce the area thereof. Then the substrate is etched so as to form the protrusions 20 having two sloped surfaces while leaving the protective film remain or after removing the protective film as a whole (second step). In the second step, etching is carried out by exposing at least part or whole of the top face 20t of the protrusion, the side face of the protrusion and the portion between the protrusions (in other words, valley).

As can be seen from Fig. 18B (or Fig. 2C), the inclination angle $\theta_{m1}$ of the sloped surface of the protrusion 20 formed in the first step is larger than the inclination angle $\theta_{m2}$ of the sloped surface of the protrusion 20 as a whole formed in the second step ($\theta_{m1} > \theta_{m2}$). Here, the inclination angle $\theta_{m2}$ of the sloped surface of the protrusion 20 as a whole formed in the second step means the inclination angle between the line connecting the edge of the bottom and the edge of the top face of the protrusion and the bottom face of the protrusion.

Fig. 18E shows a partially enlarged view of boxed part by dotted line in Fig. 18C. As shown in Fig. 18E, after second step, there may be a case where relatively sharp V-shaped notch 27a is formed at the edge of the first sloped surface 22 of the larger inclination angle on the base, namely on the periphery of the valley $20b_2$ between the protrusions. This is because notch is formed to extend along the first sloped surface 22 and the first sloped surface 22 has greater inclination angle than the second sloped surface 23, and therefore the joint of the first sloped surface 22 and the flat surface 20b2 of the substrate is etched with preference.

Then as shown in Fig. 18E, in order to integrate the two side faces 22 and 23 of the protrusion into a single smooth and convex curved surface 26, etching is carried out while exposing at least part or whole of the top face 20t of the protrusion, the side face of the protrusion and the portion between the protrusions (in other words, recess) (third step). This results in the formation of smooth curved side face 26 of the protrusion 20 as shown in Fig. 18D. The curved surface 26 has the first inclination angle $\theta_1$ on the bottom face side and the second inclination angle $\theta_2$ on the top face side. Fig. 18F shows a partially enlarged view of boxed part by dotted line in Fig. 18D. As described above, there may be a case where notch 27a is formed on the periphery of the valley $20b_2$ between the protrusions 20 in the second step. The notch 27a may lead to abnormal growth of the semiconductor. After the third step, however, the notch 27a is smoothed into smooth notch 27b as shown in Fig. 18F. Thus the abnormal growth of the semiconductor is suppressed.

In the third step, etching is carried out while exposing a part of the top face 20t of the protrusion, the side face of the protrusion and the portion between the protrusions after at least the first and second sloped surfaces 22, 23 have been formed on the side face of the protrusion 20, so as to form the side face of the protrusion 20 in a convex surface 26. At this time, the side face 26 of the protrusion 20 is preferably formed in such a configuration as the inclination angle $\theta_2$ on the top face side is smaller than the inclination angle $\theta_1$ on the bottom side ($\theta_1 > \theta_2$). Also it is preferable to make the inclination angle $\theta_{m3}$ of the entire side face of the protrusion 20 smaller than the inclination angle $\theta_{m2}$ of the sloped surface of the protrusion 20 formed after the second step ($\theta_{m2} > \theta_{m3}$), as shown in Fig. 18E and Fig. 18F. Making the inclination angle $\theta_{m3}$ smaller is advantageous for making the notch 27a smoother (27b, Fig. 18F).

The inclination angle $\theta_m$ of the entire side face of the protrusion 20 can be made progressively smaller ($\theta_{m1} > \theta_{m2} > \theta_{m3}$) through the three etching steps of the first through third steps as described above. In the side face of the protrusion thus obtained, the inclination angle $\theta_2$ on the top face side becomes smaller than the inclination angle $\theta_1$ on the bottom side. These are preferable because the side face of the protrusion having such a configuration further suppresses the occurrence of voids, crystalline defects and surface pits in the semiconductor crystal that is grown over the protrusions, and provides better properties of the semiconductor device.

While the above description has dealt with inclination angle of the side face of the protrusion 20, the discussion may also be based on the ratio of length $L_t$ of the top face of the protrusion and the length $L_b$ of the bottom of the protrusion. Ratio of bottom length to the length of top face ($L_{b1}/L_{t1}$) in the first process is preferably smaller than the ratio of lengths in the second process ($L_{b2}/L_{t2}$) (($L_{b1}/L_{t1}$) < ($L_{b2}/L_{t2}$)). Similarly, relationship

$((L_{b2}/L_{t2}) < (L_{b3}/L_{t3}))$ preferably holds between the second step and the third step. This results in larger spacing between the top faces of the protrusions, so as to allow the satisfactory crystal growth of the semiconductor in the space between the protrusions, resulting in the better crystal growth of the semiconductor.

The multi-step etching process described above achieves smooth side face of the protrusions.

In the first step, rough side face 21 having notches 24 formed thereon is likely to be formed because of the accuracies of etching and masking (Fig. 4B, Fig. 4C). The subsequent second step and third step of etching are carried out with at least a part of the top face 20t of the protrusion exposed, and therefore the notches 24 formed on the side face of the protrusion are smoothed. For example, in the second step, edge of the top face 20t of the protrusion 20 and corners of the notch 24 formed on the side face of the protrusion 20 are etched with preference. As a result, sharp edges are rounded as if chamfered. Thus as shown in Fig. 4A and Fig. 5A, the second sloped surface 23 is formed on the side face of the protrusion 20 and, at the same time, the first sloped surface 22 is smoothed. At this time, as shown in Fig. 2D and Fig. 18F, the inclination angle $\theta_m$ of the entire side face of the protrusion also decreases. Further in the third step, angular joint between the first sloped surface 22 and the second sloped surface 23 is rounded, and the notch 27a formed on the periphery of the base of the protrusion 20 in the second step is smoothed..

While the example described above dealt with a case where the protective film 25 is removed in the first step or the second step, timing of removing the protective film 25 can be selected as required. It is preferable to remove the protective film 25 simultaneously during the etching process to form the protrusion, since it eliminates the separate process of removing the protective film. In case the protective film 25 is left to remain in the first step, the remaining protective film 25 makes it easier to form the second sloped surface in the second etching step. The protective film 25 left to remain in the first step can also protect the top face 20t of the protrusion during the second step. Further in the second step, the protective film 25 may be left to remain so as to be removed in the third etching step. The protective film may further be left to remain in the third step. In the first to third step, the protective film may also be left in a shape that is suitable for the respective step in order to obtain a desired shape of protrusion (particularly the side face shape).

In accordance with the present invention, the side face of the protrusions 20 is formed in a shape protruding (swelling) toward the outside as shown in Figs. 2D, 4A, 5A, 15 and 18C. For example, the side face of the protrusion 20 is formed from the first sloped surface 22 on the bottom side and the second sloped surface 23 on the top face side. More preferably, such a side face 26 is formed that consists of the first sloped surface 22 and the second sloped surface 23 which are connected smoothly as shown in Fig. 18D.

In the manufacturing method described above, the plan-view configuration of the protrusion 20 may be selected as required, such as triangle, polygon, circle or the like. In case the plan-view configuration of the protrusion 20 has sharp corner, significant change in the shape can be caused during the multi-step etching operation, leading to significant variability in shapes of the protrusions among wafers or within a wafer, resulting in lower yield of production. The plan-view configuration of the protrusion 20 having sharp corner has disadvantage also with respect to crystal growth. That is, the nitride semiconductor grown on the top face 20t of the protrusion of the substrate has hexagonal crystal structure. In case the plan-view configuration of the protrusion is triangle as shown in Fig. 19D, gap is produced between the hexagonal semiconductor crystal and the triangular top face of the protrusion, thus making the semiconductor crystal likely to grow unevenly. Uneven growth of the semiconductor crystal increases the chance of abnormal growth such as pits when islands of semiconductor crystal join with each other to form a layer. In case the plan-view configuration of the protrusion is circle as shown in Figs. 19A through 19C, on the other hand, gap between the hexagonal semiconductor crystal and the edge of the top face of the protrusion becomes smaller, thus making segregation of the semiconductor crystal less likely to occur. As a result, the semiconductor can be grown with abnormal growth such as pits being suppressed. Therefore, it is preferable that the plan-view configuration of the protrusion 20 (particularly the top face) does not have sharp corners. The shape is, for example, a polygon having vertices of right angles or obtuse angle (for example, polygon having four or more vertices), preferably a polygon having rounded vertices, more preferably ellipse, and most preferably circle.

[Arrangement of protrusions]

Figs. 19A through 19D show examples of arrangement of protrusions. The arrangement of the protrusions is preferably as follows. A circle 31, sandwiched between adjacent protrusions 20 and circumscribed with the base of the protrusions 20, is referred to as the first circle. A circle 32, that is circumscribed with the periphery of the bases of at least three protrusions 20, and preferably has the largest diameter in the region between the protrusions 20, is referred to as the second circle. Diameter of the second circle 32 is larger than that of the first circle 31. A circle 33, sandwiched between adjacent protrusions 20 and circumscribed with the peripheries of the top faces of the protrusions 20, is referred to as the third circle. The protrusions 20 are preferably arranged so that diameter of the third circle 33 becomes larger than that of the second circle 32.

In the example shown in Fig. 19A, for example, circles of which diameters are the shortest line segments that connect the bases of two protrusions 20 are referred to as the first circle 31, and the shortest line segments that connect the bases of two top faces are referred to as the third circle 33. In a region surrounded by three protrusions 20, a circle that is circumscribed with the periphery of the bases of the three protrusions 20, and has the largest diameter in the region between the protrusions is taken as the second circle 32. Diameters of the first circle $R_1$, the second circle $R_2$ and the third circle $R_3$ satisfy the relation $R_3 > R_2 > R_1$. Crystal quality will be better when this relation is satisfied.

Fig. 19B shows semiconductor crystal grown to a height halfway up the protrusions 20 on a substrate 10 of Fig. 19A. Semiconductor crystal 42 grown from the region between the protrusions 20 and semiconductor crystal 41 grown from the top face 20t of the protrusions are shown. As can be seen from Fig. 19B, since the protrusions are disposed at a distance from each other, the islands of crystal 41 on the top faces of the protrusions grow in the direction of thickness and in the lateral direction as well so as to approach each other. Therefore, the islands of semiconductor crystal 41 growing from the top faces of the protrusions eventually join with each other as the growth proceeds, as indicated by growth prediction circles of dashed lines in Fig. 19D. On the other hand, the semiconductor crystal 42 growing from the region between the protrusions 20 grows in the direction of thickness. If the islands of semiconductor crystal 41 growing from the top faces of the protrusions join with each other before thickness of the semiconductor crystal 42 reaches the height of the protrusion, voids are generated. Therefore, occurrence of voids can be suppressed by increasing the distance between protrusions 20. However, in order to ensure the effect of the substrate with protrusions to extract light, it is preferable to dispose the protrusions 20 as dense as possible. Therefore, it is advantageous to prevent voids and other crystalline defects from occurring while increasing the density of the protrusions.

According to the present invention, the protrusions having specific roughnesses and inclined side faces are provided. Thus surface area of the semiconductor crystal 42 growing from the region between the protrusions increases as thickness thereof increases. Also, the area surrounded by the top faces of the protrusions increases. The two conditions described above (high density of protrusions and large distance between protrusions) can be satisfied at the same time.

Particularly as shown in Figs. 17A and 17B, when the side face of the protrusion is formed to protrude toward the outside, the semiconductor crystal 41 grown from the top face of the protrusion and the semiconductor crystal 42 grown from the region between the protrusions grow favorably, and it is made possible to prevent the occurrence of abnormal growth and voids. Figs. 17A and 17B are schematic sectional views showing the semiconductor crystal grown halfway up the protrusion 20 on the substrate, showing a part of the cross section of Fig. 19B.

In Figs. 19B through 19D, the crystal 41 grown on the top face 20t of the protrusion is indicated with hexagon, in order to illustrate the typical form of nitride semiconductor. An embodiment of the present invention can be applied to a case where the crystal grows in other form. In particular, an embodiment of the present invention can be preferably applied to a system where the crystal grows relatively isotropically.

Fig. 19C shows a case where the protrusions are disposed in an arrangement different from that of Fig. 19A. Fig. 19C shows the semiconductor crystal that has been grown halfway up the protrusion 20, similarly to Fig. 19B. In the example shown in Fig. 19A, axes 51 and 52 that connect the centers of adjacent protrusions 20 intersect with each other at about 60°, while the protrusions are located at substantially equal spacing on vertices of equilateral triangles. Arrangement of the protrusions in Fig. 19A is a periodically repeated pattern of parallelogram (dashed line 53 in the drawing) as a unit in the directions of the axes 51, 52. In Fig. 19C, axes 51 and 52 that connect the centers of adjacent protrusions 20 intersect with each other perpendicularly, while the protrusions are located at substantially equal spacing on vertices of squares. Arrangement of the protrusions in Fig. 19C is a periodically repeated pattern of square (dashed line 53 in the drawing) as a unit in the directions of the axes 51, 52.

In Fig. 19C, when circles of which diameters are the shortest line segments that connect the bases and top faces of two protrusions 20 are taken as the first circle 31 and the third circle 33, respectively, the first circle 31 and the third circle 33 are concentric with the center located at the middle point of the line segment that connects the centers of the two protrusions. The circle (the second circle 32) that has the largest diameter in the region between the protrusions is a circle that is circumscribed with the periphery of the bases of four protrusions. In Fig. 19C, too, diameters $R_1$, $R_2$ and $R_3$ of the first circle, the second circle and the third circle, respectively, satisfy the relation $R_3 > R_2 > R_1$.

In Fig. 19C, with a circle that is circumscribed with the periphery of the bases of the three protrusions taken as the second circle 32, the protrusions may also be arranged so as to satisfy the relation $R_3 > R_2 > R_1$. This improves a quality of crystal growth.

The embodiments shown in Fig. 19B(A) and Fig. 19C have common features as follows. First, consider perpendicular bisector of the line segment that connects the centers of the two protrusions 20 that are circumscribed with the second circle 32 having the largest diameter. Then the centers of the first, second and third circles lie on the perpendicular bisector. Second, the second circle 32 intersects with the third circle 33 that is interposed by the protrusions 20 that are circumscribed with the second circle 32. An arrangement having these two features are preferable because it cause favorable changes in the area and in shape of the crystal 42 growing from the region between the protrusions in the course of growth, thus enabling it to obtain light emitting diode having excellent crystallinity.

Fig. 19D shows an example where the protrusions 20 having triangular shape in plan view are arranged. In Fig. 19D, axes 51 and 52 of the periodical structure of protrusions intersect with each other at about 120º. Unit of the periodical structure is a rhombic cell indicated by dashed line 43. The sides that constitute the protrusion 20 are parallel to the sides that constitute the adjacent protrusions 20, with narrow paths formed between adjacent sides. There are the first circle 31 and the third circle 33 on the path. Circumscribed with six protrusions is the second circle 32. In contrast to the arrangements shown in Fig. 19B and Fig. 19C, the second circle 32 and the third circle 33 are spaced from each other. The first through third circles in overlapping relationship are selected as follows. First, of the plurality of protrusions that are circumscribed with the second circle, two adjacent ones are selected and the first circle and the third circle interposed by the two protrusions are considered. For the first circle 31 and the third circle 33, those which are located furthest from the adjacent second circle 32 (in Fig. 19D, the second circles 32 located at both ends of the side of the triangle) are taken. In Fig. 19D, for example, the first circle 31 and the third circle 33 have centers located on the line segment that connects the middle points of the sides of the protrusions.

The same overlapping configuration applies also to the cases of Fig. 19A and Fig. 19C.

In Fig. 19D, diameters $R_1$, $R_2$ and $R_3$ of the first, second and third circles satisfy the relation $R_2 = R_3$ and $R_2 > R_1$. As shown in Fig. 19D, in case the first and third circles are included in the narrow path and the second circle do not overlap each other, the islands of semiconductor crystal 41 growing from the top faces of the protrusions may join with each other before the semiconductor crystal 42 growing from the region between the protrusions reaches the top face of the protrusion. If this happens, voids are likely to occur in the region 44 enclosed by dashed line in Fig. 19D. Even if diameter of the second circle 32 is increased for the purpose of preventing the occurrence of voids, growth in the second circle 32 becomes faster than growth in the first circle 31, and this difference in the growth rate within the plane may increase the chance of voids to occur, contrary to the intention. This is because, in case the second circle 32 and the third circle 33 do not overlap each other, growth of crystal in around the center of narrow path (around the center of the first circle 31, region indicated by dashed line 44) tends to lag behind the crystal growth in the second circle 32. As a result, the region enclosed by dashed line 44 in Fig. 19D can be blocked not only at the top by crystal 41 that has grown from the top face of the protrusion, but also on the side by the crystal grown from the region of the second circle 32. This may results in the occurrence of voids.

Crystallinity of the semiconductor that grows on the substrate having protrusions depends also on the arrangement of the protrusions on the substrate surface. It is preferable to set the plan-view configuration and arrangement of the protrusions so that narrow path is not formed between the protrusions as shown in Fig. 19A, 19C. By disposing the protrusions in such an arrangement as diameters of the first, second and third circles satisfy the relationship described above, and preferably the second circle and the third circle overlap each other, it is made possible to further improve the crystallinity of the semiconductor and obtain further better semiconductor element.

While the description in this specification is focused on the case of forming the protrusions in accordance with the present invention on the substrate, the description is applicable to the case of forming recesses, although not forming part of the present invention, on the substrate as well. Those skilled in the art should be able to interpret the description in order to understand the variation.

Fig. 1 is a cross sectional view showing an embodiment of a semiconductor light emitting diode (LED) according to the present invention.

Figs. 2A through 2E are diagrams showing a process of manufacturing the semiconductor LED shown in Fig. 1.

Figs. 3A through 3D are diagrams schematically showing the propagation of light according to an embodiment of the present invention in comparison to the prior art.

Fig. 4A is a perspective view showing an example of pattern of protrusions in an embodiment of the present invention, and Figs. 4B and 4C are perspective views showing examples, not in accordance with the present invention, of pattern of protrusions in case the side face of protrusion consists of a single sloped surface of the same angle of inclination.

Fig. 5A is a sectional view showing an example of pattern of protrusions in an embodiment of the present invention, and Fig. 5B is a sectional view showing an example, not in accordance with the present invention, of pattern in case the side face of protrusion consists of a single sloped surface of the same angle of inclination.

Fig. 6 is a cross sectional view showing a semiconductor light emitting diode according to an embodiment of the present invention.

Figs. 7A through 7D are perspective views showing other examples of pattern of protrusions in accordance with the present invention.

Figs. 7E through 7H are perspective views showing other examples, not in accordance with the present invention, of pattern of recesses.

Figs. 8A through 8C are diagrams showing variations of the configuration of p-side ohmic electrode.

Figs. 9A through 9D are diagrams showing other variations of the configuration of p-side ohmic electrode.

Figs. 10A and 10B are diagrams showing further variations of the configuration of p-side ohmic electrode.

Figs. 11A and 11B are schematic diagrams explanatory of the direction of arranging the protrusions (or recesses, although not forming part of the present invention) that are formed in hexagonal shape on a substrate.

Fig. 12 is an SEM photograph of protrusions according to an embodiment of the present invention.

Fig. 13 is an SEM photograph of protrusions according to another embodiment of the present invention.

Fig. 14 is an SEM photograph of protrusions not in accordance with the present invention.

Fig. 15 is a schematic sectional view showing cross section of protrusions in an embodiment of the present invention.

Figs. 16A and 16B are perspective views showing the protrusions in an embodiment of the present invention.

Figs. 17A and 17B are schematic sectional partial views showing a protrusion formed on the substrate in an embodiment of the present invention, and the semiconductor grown thereon.

Figs. 18A through 18F are schematic sectional views showing manufacturing process for the substrate according to an embodiment of the present invention.

Figs. 19A through 19D are schematic top views showing the pattern of protrusions formed on the substrate top surface according to an embodiment of the present invention.

Fig. 20 is a graph showing electrostatic destruction characteristic according to an embodiment of the present invention.

Fig. 21 is a graph showing luminance of light emitting diode according to an embodiment of the present invention.

Figs. 22A through 22C are a top view showing the structure of light emitting diode according to an embodiment of the present invention (Fig. 22A), a sectional view showing the layer structure thereof (Fig. 22B) and a circuit diagram of the layer structure thereof (Fig. 22C).

Fig. 23 is a schematic diagram showing the light emitting diode according to an embodiment of the present invention.

Fig. 24 is a schematic sectional view showing the light emitting diode according to an embodiment of the present invention.

Figs. 25A and 25B are a top view showing the light emitting diode according to an embodiment of the present invention (Fig. 25A) and a partially sectional schematical view showing the structure thereof along line A-A (Fig. 25B).

As described above, according to the present invention, undesirable light propagation in the light emitting diode can be suppressed by forming protrusions in the substrate surface, which results in an improved light extracting efficiency. Also, occurrence of pits or voids due to the protrusions can be suppressed. Therefore, a high-performance semiconductor light emitting diode can be provided.

Now embodiments of the present invention will be described in detail with reference to the accompanying drawings. Fig. 1 shows a preferred embodiment of the semiconductor light emitting diode according to the present invention, wherein an n-type semiconductor layer 11, an active layer 12 and a p-type semiconductor layer 13 are formed successively on a substrate 10. The substrate 10 has protrusions 20 formed in a repetitive pattern in the surface thereof.

Height of the protrusions 20 (depth of recess if the space between two protrusions is regarded as recess) is preferably in a range from 0.1 $\mu$m to 2 $\mu$m inclusive. Length "a" of one side of the protrusion 20 if it is a polygon, or diameter of the protrusion if it is circle is preferably in a range from 1 $\mu$m to 10 $\mu$m inclusive. Distance between adjacent protrusions 20 is preferably in a range from 1 $\mu$m to 10 $\mu$m inclusive.

The process of manufacturing the semiconductor LED shown in Fig. 1 will now be described with reference to Figs. 2A through 2E. First, as shown in Fig. 2A, a protective film 25 is formed as an etching mask on the substrate 10. The substrate 10 may be made of sapphire, Si, SiC or the like.

Then as shown in Fig. 2B, the protective film 25 is formed into a pattern. The pattern of the protective film 25 in plan view may be, for example, as shown in Figs. 7A through 7D regarding protrusions to be formed in accordance with the present invention, or as shown in Figs 7E through 7H regarding recesses, however not forming part of the present invention (hatching in Figs. 7A through 7H indicates the region where the protective film is formed). Figs. 7A through 7D show examples of the protective film when protrusions are formed on the substrate. When the protrusions (or recesses, which do not form part of the present invention) are formed in circular or polygonal shape, it is preferable to arrange them in a hexagonal pattern in order to reduce pits. In the example shown in Fig. 2B, the protective film is formed in a circular pattern as shown in Fig. 7A.

Then as shown in Fig. 2C, surface of the substrate 10 exposed through the protective film 25 is etched. At this time, the protective film 25 is also etched to some extent. In accordance with the present invention, dry etching is employed in this etching process. Specifically, gas phase etching, plasma etching, reactive plasma etching (such as RIE, magnetron RIE), ECR plasma etching, sputter etching, ion beam etching and photo-etching. Reactive ion etching (RIE), above all, is preferably used. For the etching gas, $Cl_2$ compound or F compound such as $Cl_2$, $SiCl_4$, $BCl_3$, HBr, $SF_6$, $CHF_3$, $C_4F_8$ or $CF_4$ can be used. An inert gas such as Ar may also be used. In the first and second steps of etching, a gas having high selective etching capability for the substrate and the mask is preferably used, such as a mixture gas of $SiCl_4$ and $Cl_2$, in the case of sapphire substrate and mask made of $SiO_2$. In the third step, a gas having selectivity different from that of the second step, preferably a gas having lower selectivity is used, such as $CF_4$, $CHF_3$ or Ar can

be used. After etching the exposed surface of the substrate, the protective film is removed and the substrate is dry etched further. This results in the formation of the protrusions 20 having two sloped surfaces in the surface of the substrate 10. Instead of this method, the protrusions 20 having two sloped surfaces may also be formed by continuing the dry etching still after the protective film has been completely removed in the process shown in Fig. 2C. The protrusions 20 having two sloped surfaces may also be formed by changing the etching rate or apparatus amid the course. Although not forming part of the present invention, recesses having two sloped surfaces may be formed by changing the etching rate or other method. For example, after etching the substrate to some extent, etching may be continued with a slower etching rate, so as to form recesses having two sloped surfaces.

Then as shown in Fig. 2E, the n-type semiconductor layer 11, the active layer 12 and the p-type semiconductor layer 13 are formed successively one on another in this order on the substrate 10 whereon the protrusions 20 are formed in an ordered pattern.

Growth of a semiconductor, including GaN semiconductor, on a substrate is significantly affected by the surface condition of the substrate. In case the side face (sloped surface) of the protrusion is formed in one step as shown in Fig. 5B, not in accordance with the present invention , significant notches are formed on the side face of the protrusion along the slope as shown in the SEM photograph of Fig. 14. This situation is schematically shown in Fig. 4B and Fig. 4C. Presence of the notches increases the possibility of voids to be generated when growing the semiconductor. This is because not only the surface roughness of the side face is different between adjacent protrusions 20, but also there is significant difference in the surface roughness within a single protrusion. In consequence, semiconductor grows at different rates near the side face of the protrusion, fast at one point and slowly at another, so that the semiconductor grown at the fast growing point spreads over the slow growing point. As a result, voids can easily develop in the semiconductor.

In this embodiment, in contrast, the side face (sloped surface) of the protrusions is formed in two steps as shown in Fig. 5A. Therefore, while the first sloped surface near the substrate includes some notches, the second sloped surface located above is almost free from notches, as shown in Fig. 12. This situation is schematically shown in Fig. 4A, which is a perspective view showing the protrusion 20 schematically. The first sloped surface 22 and the second sloped surface 23 are formed in this order from the bottom of the substrate. Although the first sloped surface 22 includes some notches 24, the second sloped surface 23 is almost free from notches. Thus in this embodiment, generation of voids is suppressed by the second sloped surface 23 that is free from notches.

Then the device forming process is carried out with electrode formed, so as to finish the LED chip. Holes and electrons are injected from the n-type semiconductor layer 11 and the p-type semiconductor layer 13 into the active layer 12, where both charges recombine thereby to emit light. The light is extracted through the sapphire substrate 10 or the electrode formed on the p-type semiconductor layer 13.

In the case of a semiconductor light emitting device of the prior art having flat substrate, as shown in Fig. 3A, light that is generated in the active layer 12 and is incident on the interface between the p-type semiconductor layer 13 and the electrode or on the interface between the n-type semiconductor layer 11 and the substrate 10 with an angle of incidence equal to or larger than the critical angle is captured within the waveguide so as to propagate laterally.

In case the protrusions 20 are formed on the surface of the substrate 10 as shown in Fig. 3B or Fig. 3C, light that is incident on the interface between the p-type semiconductor layer 13 and the electrode or on the interface between the n-type semiconductor layer 11 and the substrate 10 with an angle of incidence equal to or larger than the critical angle is scattered or diffracted. Most of the scattered or diffracted light is incident on the interface between the p-type semiconductor layer 13 and the electrode or on the interface between the n-type semiconductor layer 11 and the substrate 10 with an angle of incidence smaller than the critical angle, and can be extracted to the outside. In case the side face of the protrusion 20 is formed from a sloped surface with a single angle of inclination as shown in Fig. 3B or Fig. 3C, however, voids are likely to be generated in the semiconductor layer 11. When voids are generated in the semiconductor layer, crystallinity of the semiconductor becomes lower and the quantum efficiency decreases. In this embodiment, for this reason, side face of the protrusion is formed from two sloped surfaces of different angles of inclination so as to suppress the generation of voids, as shown in Fig. 3D. This constitution makes it possible to efficiently extract light that has been generated in the active layer and improve the crystallinity of the semiconductor, thereby providing a semiconductor light emitting diode of higher output power.

In case the contact electrode provided on the p-type semiconductor layer 13 is a transparent electrode, the device is mounted face up but, in the case of reflecting electrode, the device is mounted face down. The present invention is effective in either mode of mounting. Even in the case of reflective electrode, the LED can be mounted face up when the electrode has opening or notch. In this case, too, the present invention achieves conspicuous effect.

The embodiment described above is an example where the protrusion 20 has a circular shape in plan view, although the protrusions 20 may also be formed in a polygonal shape. In case the substrate 10 is made of sapphire and the semiconductor 11 is made of GaN, in particular, the GaN grows with an offset angle of 30 degrees from the lattice of the sapphire substrate. Therefore, it is preferable to form the protrusions 20 on the sapphire substrate 10 in such a shape as follows. Shape of the protrusions 20 in plan view is formed in a polygon that has sides substantially parallel to A planes (11-20), (1-210) and (-2110) of GaN and vertices in stable growth planes (1-100), (01-10) and (-1010) of GaN. This polygon does not have any side that is parallel to the stable growth planes (1-100), (01-10) and (-1010) of GaN, namely M-plane. By forming the protrusions 20 in such a shape, it is made possible to grow a flat GaN layer with high crystallinity.

Specifically, in case the protrusion 20 has a shape of equilateral triangle in plan view, it is preferable to form the equilateral triangle from sides that cross (are not parallel to) M-plane which is the stable growth plane of GaN, when viewed from above. It is more preferable to form the equilateral triangle from sides that are perpendicular to straight lines connecting the center and vertices of an equilateral hexagon that is defined by planes parallel to A-axis (more specifically, by intersection lines between the planes and the substrate surface) of the nitride semiconductor as its sides, in other words, a equilateral hexagon that is defined by A-axis of the nitride semiconductor as its sides. By forming the protrusions 20 in such a shape, it is made possible to grow a flat GaN layer that fills the surrounding of the protrusions 20 with high crystallinity.

This is supposedly because the growing rate of GaN becomes higher in a portion where GaN grown from the top face of the protrusion 20 and GaN grown on the flat surface where the protrusion 20 is not grown join. While GaN is grown from the top face of the protrusion 20 in hexagonal crystal structure consisting of sides that are parallel to A-axis, growing rate of GaN is higher near the side face of the protrusion 20 where GaN grown from the top face of the protrusion 20 and GaN grown on the flat surface join each other. As a result, growth of GaN near the side face of the protrusion 20 catches up the growth in other regions so that flat GaN layer is obtained.

The protrusions 20 may also be formed in an equilateral hexagonal shape. In this case, if the orientation flat "a" of the sapphire substrate 10 having principal plane in C-face lies in A face, for example, the equilateral hexagonal shape may be arranged in direction shown in either Fig. 11A or Fig. 11B. In case GaN is grown on C plane of the sapphire substrate as described previously, A plane of the sapphire substrate and M-plane of GaN become parallel to each other. Therefore, it is preferable to arrange the protrusion (or recess) of equilateral hexagon as shown in Fig. 11A, in which case the sides that constitute the equilateral hexagon cross at right angles to one of the M-planes that are stable growth plane of GaN, when viewed ) from above the substrate. In other words, this means that the equilateral hexagon is formed from sides that are perpendicular to the straight lines that connect the center and vertices of an equilateral hexagon that is defined by M-planes of GaN as its sides, when viewed from above the substrate.

The above embodiments of the present invention will now be described in more detail below.

[Embodiment 1]

In the first embodiment of the present invention, the side face of the protrusions consists of at least two sloped surfaces (first sloped surface 22, second sloped surface 23) as shown in Fig. 4A and Fig. 5A. The inclination angle $\theta_2$ on the top face side of the protrusion is smaller than the inclination angle $\theta_1$ on the bottom side. The inclination angle $\theta$ is the angle between the side face and the bottom of the protrusion. In case, not forming part of the present invention, recesses are formed in the substrate, inner wall of the recess is also formed so that the inclination angle $\theta_2$ of the upper inner wall is larger than the inclination angle $\theta_1$ of the lower inner wall. The inclination angle $\theta_1$ of the inner wall is the complementary angle of the angle $\phi_i$ between the inner wall and the bottom surface of the recess.

$$\theta_i = 180^\circ - \phi_i \ (i = 1,\ 2)$$

When the inclination angle $\theta_3$ is defined as the angle between the top face and the side face of the protrusion, in case the top face is substantially parallel to the substrate surface, the angle $\phi_2$ between the upper inner wall and the bottom surface of the recess is nearly equal to the inclination angle $\theta_3$ of the protrusion. Preferably, the first sloped surface 22 and the second sloped surface 23 are located at the top and bottom of the protrusion (or of the recess, respectively) . This makes manufacturing easier, causes the semiconductor layer to grow favorably to near the protrusions and enables it to suppress the occurrence of pit and voids.

[Embodiment 2]

In the second embodiment of the invention, side face of the protrusions is formed in a curved surface. In case entire side face of the protrusions is formed in a single curved surface, radius of curvature may be made larger on the top face side and smaller on the bottom side. Alternatively, such a configuration may also be employed as the bottom side is flat, i.e., upper side of the side face is curved and the lower side is flat. Moreover, a plurality of curved portions and a plurality of flat portions may be formed on the side face of the protrusions.

For example, in the structure of the first embodiment where the first and second sloped surfaces are formed, the second sloped surface may be formed in a curved surface with the first sloped surface consisting of substantially flat surface. Condition of the side face may be selected as required in accordance to the substrate material, etching condition, material of the semiconductor layer and other factors.

It is preferable to form the entire side face in a curved surface and make the inclination angle $\theta_2$ on the top face side of the protrusions smaller than the inclination angle $\theta_1$ on the bottom side, as shown in Fig. 15. This configuration makes the changes in the shape and surface area of the semiconductor layer growing on the substrate smoother. That is, better crystal can be grown while suppressing the occurrence of abnormal crystal growth. The inclination angle $\theta_m$ can be decreased when the side face is formed in a single curved surface rather than having a partially curved portion or a plurality of curved surfaces. If the inclination angle $\theta_m$ can be decreased, ratio of the area of the side face to the area of the substrate surface can be increased so as to achieve higher efficiency of extracting light.

[Embodiment 3 (Structure of light emitting diode )]

Constitution of the semiconductor light emitting diode according to the present invention will be described in detail. There are no specific requirements for the size and thickness of the substrate 10 which may be of any constitution as long as it allows epitaxial growth of semiconductor thereon. The substrate used to grow the nitride semiconductor thereon may be made of an insulating material such as sapphire or spinel ($MgAl_2O_4$) having principal plane in C plane, R plane or A plane, or an oxide such as lithium niobate or neodymium gallate that forms lattice junction with silicon carbide (6H, 4H, 3C), silicon, ZnS, ZnO, Si, GaAs, diamond, or oxide substrates such as lithium niobate or neodymium gallate which can provide a good lattice match with nitride semiconductor. A substrate made of nitride semiconductor such as GaN or AlN may also be used provided that it is thick enough to form devices thereon (over several tens of micrometers). A substrate made of different material may be cut with offset angle. If C plane of sapphire is used, offset angle is preferably in a range from 0.01° to 3.0°, and more preferably from 0.05° to 0.5°.

The semiconductor light emitting diode according to the present invention may have such a structure as electrodes of different types of electrical conductivity are provided on the same side of the substrate as shown in Fig. 6, Fig. 25A and Fig. 25B. An electrically conductive substrate may also be used with electrodes for first conductivity type layer and second conductivity type layer provided on opposite sides of the substrate, respectively.

In case nitride semiconductor is used as the semiconductor, it is preferable to use nitride semiconductor having composition represented by general formula $In_xAl_yGa_{1-x-y}N$ ($0 \le x$, $0 \le y$, $x + y \le 1$). B, P or As may be included in the nitride semiconductor as mixed crystal. The n-type nitride semiconductor 11 and the p-type nitride semiconductor 13 may be formed in either single layer or multi-layer structure. The nitride semiconductor is doped with n-type impurity or p-type impurity. As the n-type impurity, group IV elements or group VI element such as Si, Ge, Sn, S, O, Ti, Zr may be used and preferably Si, Ge or Sn are used and more preferably Si is used. While there is no restriction on the p-type impurity, Be, Zn, Mn, Cr, Mg or Ca may be used and Mg is preferably used. Thus both types of nitride semiconductor can be formed. The active layer 12 is preferably formed in single quantum well (SQW) structure or multiple quantum well (MQW) structure.

The embodiments shown in Fig. 6 and Fig. 25 have such a structure as the light emitting element 101 is formed on the substrate 10, with electrodes 16, 14 provided on the layers 11, 13 of different conductivity types, respectively, of the light emitting element. While the device structure made by stacking the p-type layer 13 and the n-type layer 11 in a particular order is described as an example in this ) specification, the order of stacking the layer is not restricted to that described in the specification. The light emitting diode may have any proper structure as long as it has at least the layer of first conductivity type 11 and the layer of second conductivity type 13. More preferably, the active layer 12 is provided between the layer of first conductivity type 11 and the layer of second conductivity type 13. Alternatively, a base layer 11a that provides a base for the element structure 101 may be formed between the substrate 10 and the n-type layer 11b of the layer of first conductivity type as shown in Fig. 25B.

Now the method of manufacturing the light emitting diode shown in Fig. 6 will be described below.

It is preferable to form a buffer layer (not shown) before growing the n-type nitride semiconductor 11 on the substrate 10. The buffer layer is preferably made of a nitride semiconductor represented by general formula $Al_aGa_{1-a}N$ ($0 \le a \le 0.8$), more preferably a nitride semiconductor represented by general formula $Al_aGa_{1-a}N$ ($0 \le a \le 0.5$). Thickness of the buffer layer is preferably in a range from 0.002 to 0.5 $\mu$m, more preferably from 0.005 to 0.2 $\mu$m, and most preferably 0.01 to 0.02 $\mu$m. Semiconductor layers of better crystallinity can be formed on the substrate by making the thickness of the buffer layer smaller than the height of the protrusions of the substrate. For example, the semiconductor layer of satisfactory crystal structure can be made with less voids, pits and dislocations. The buffer layer is grown at a temperature preferably in a range from 200 to 900°C, and more preferably from 400 to 800°C. This makes it possible to reduce dislocations and pits generated on the nitride semiconductor. An $Al_xGa_{1-x}N$ ($0 \le x \le 1$) layer may also be formed by ELO (epitaxial lateral overgrowth) method on the substrate made of different material. The ELO (epitaxial lateral overgrowth) method is a process of growing nitride semiconductor in lateral direction so as to bend and converge threading dislocation and decrease dislocations. The buffer layer may be formed in multiple layer structure, such that includes a low-temperature growth layer and a high-temperature growth layer. The high-temperature growth layer may be a GaN layer grown without doping or one that is doped with an n-type impurity. Thickness of the high-temperature growth layer is preferably 1 $\mu$m or larger, and more preferably 3 $\mu$m or larger. The high-temperature growth layer is grown at a temperature preferably in a range from 900 to 1100°C, and more preferably at 1050°C or higher.

Then the n-type semiconductor layer 11 is grown. First, an n-type contact layer is grown. The n-type contact layer has such a composition that has band gap energy larger than that of the active layer, preferably $Al_jGa_{1-j}N$ ($0 < j < 0.3$). While there is no limitation to the thickness of the n-type contact layer, it is preferably 1 $\mu$m or larger, and more preferably 3 $\mu$m or larger. Then an n-type cladding layer is grown. The n-type cladding layer includes Al. While there is no limitation to the concentration of the n-type impurity, it is preferably in a range from $1 \times 10^{17}$ to $1 \times 10^{20}/cm^3$, more preferably from $1 \times 10^{18}$ to $1 \times 10^{19}/cm^3$. The n-type impurity may also be included with graded concentration. When the Al content is graded, the cladding layer can also perform a better function of carrier confinement.

The active layer 12 used in the present invention is preferably formed in such a quantum well structure that consists of at least a well layer having composition of $Al_aIn_bGa_{1-a-b}N$ ($0 \le a \le 1$, $0 \le b \le 1$, $a + b \le 1$) and a barrier layer having composition of $Al_cIn_dGa_{1-c-d}N$ ($0 \le c \le 1$, $0 \le d \le 1$, $c + d \le 1$). Output power of the light emitting diode can be made higher by forming the active layer from nitride semiconductor without doping or while doping with an n-type impurity. More preferably, the well layer is grown without doping and the barrier layer is grown while doping with an n-type impurity in order to increase the output power and light emission efficiency of the light emitting diode. When Al is included in the well layer of the light emitting diode , it is made possible to emit light in a wavelength region where it is difficult to emit light with the conventional well layer made of InGaN, namely wavelengths near 365 nm, that corresponds to the band gap energy of GaN, and shorter.

Thickness of the well layer is preferably in a range from 1 nm to 30 nm inclusive, more preferably from 2 nm to 20 nm inclusive and most preferably from 3.5 nm to 20 nm inclusive. When smaller than 1 nm in thickness, the layer cannot satisfactorily function as the well layer. When the thickness is 2 nm or more, relatively homogeneous layer can be obtained without fluctuation in thickness. When the thickness is 3.5 nm or more, output power can be increased further. This is because a thicker well layer allows for injection of more carriers so as to emit light with high efficiency and high internal quantum efficiency through recombination of carriers as in an LD driven with a high current, and this effect is remarkable particularly in a multiple quantum well structure. In the case of single quantum well structure, the effect of increasing the output power similarly to the above can be achieved by setting the thickness to 5 nm or more. When the well layer is thicker than 30 nm, on the other hand, crystallinity of quaternary mixed crystal of InAlGaN becomes lower, resulting in lower performance of the device. By setting the thickness of the well layer to 20 nm or less, it is made possible to grow the crystal while suppressing the occurrence of crystal defects. While there is no limitation to the number of well layers, it is preferable to provide four or more well layers which enables it to set the thickness of the well layer to 10 nm or less and decrease the thickness of the active layer. This is because the thicker the layers that constitute the active layer, the thicker the active layer and higher the value of Vf becomes. In the case of multiple quantum well structure, it is preferable that at least one of the plurality of well layers is not thicker than 10 nm, and it is more preferable that all well layers are not thicker than 10 nm.

The barrier layer, similarly to the well layer, is preferably doped with an n-type impurity or undoped. In case the barrier layer is doped with an n-type impurity, concentration of the n-type impurity is preferably $5 \times 10^{16}/cm^3$ or higher. In the case of LED, the concentration is preferably in a range from $5 \times 10^{16}$ to $2 \times 10^{18}/cm^3$. In the case of high output LED, the impurity concentration is preferably in a range from $5 \times 10^{17}$ to $1 \times 10^{20}/cm^3$, and more preferably in a range from $1 \times 10^{18}$ to $5 \times 10^{19}/cm^3$. In this case, it is preferable that the well layer either does not substantially include n-type impurity or is undoped. When the barrier layer is doped with an n-type impurity, either all barrier layers in the active layer may be doped, or some of the barrier layers may be doped while leaving the others undoped. In case only some of the barrier layers are doped with n-type impurity, it is preferable to dope the barrier layers that are located on the n-type layer side in the active layer. When the $n^{th}$ barrier layer Bn (n is a positive integer) from the n-type layer side is doped, for example, preferably the first through $n^{th}$ barrier layers are all doped with impurity, such a light emitting diode can be made as electrons are efficiently injected into the active layer so as to achieve high efficiency of light emission and high internal quantum efficiency. With regard to the well layer, too, an effect similar to that of the barrier layer can be achieved by doping the $m^{th}$ well layer Wm (m is a positive integer) from the n-type layer side. Similar effect can also be achieved by doping both the barrier layer and the well layer.

Then a plurality of layers as described below are formed as the p-type nitride semiconductor layer 13 on the active layer 12. As for the p-type cladding layer, while there are no limitations to the composition as long as it has band gap energy larger than that of the active layer so as to be capable of confining the carrier within the active layer, the composition is preferably $Al_kGa_{1-k}N$ ($0 \le k < 1$), and more preferably $Al_kGa_{1-k}N$ ($0 < k < 0.4$). While there is no limitation to the thickness of the p-type cladding layer, it is preferably in a range from 0.01 to 0.3 $\mu$m, and more preferably from 0.04 to 0.2 $\mu$m. Concentration of the p-type impurity is preferably in a range from $1 \times 10^{18}$ to $1 \times 10^{21}/cm^3$, more preferably from $1 \times 10^{19}$ to $5 \times 10^{20}/cm^3$. The p-type impurity in the range described above enables to decrease the bulk resistivity without deteriorating the crystallinity. The p-type cladding layer may be formed either in single layer structure or multiple layer structure (super lattice structure). In the case of multiple layer structure, it may comprise a layer represented by $Al_kGa_{1-k}N$ described above and other nitride semiconductor layers having a band gap energy smaller than that of the former. The layers of smaller band gap energy have a composition represented by $In_1Ga_{1-l}N$ ($0 \leq 1 < 1$) or $Al_mGa_{1-m}N$ ($0 \leq m < 1$), similarly to the case of the n-type cladding layer. Thickness of each layer constituting the multiple layer structure in the case of super lattice structure is preferably 100 Å (10 nm) or less, more preferably 70 Å (7 nm) or less and most preferably in a range from 10 to 40 Å (1 to 4 nm). In case the p-type cladding layer is formed in multiple layer structure consisting of layers having larger band gap energy and layers having smaller band gap energy, the p-type impurity may be added to at least either the layers having larger band gap energy or the layers having smaller band gap energy. When both the layers having larger band gap energy and the layers having smaller band gap energy are doped, the doses may be the same or different.

Then a p-type contact layer is formed on the p-type cladding layer. The p-type contact layer is preferably formed in composition of $Al_fGa_{1-f}N$ ($0 \leq f < 1$), and more preferably $Al_fGa_{1-f}N$ ($0 \leq f < 0.3$) which enables to achieve good ohmic contact with the p electrode 14 that is an ohmic electrode. Concentration of the p-type impurity is preferably $1 \times 10^{17}/cm^3$ or higher. It is preferable that the p-type contact layer has such a graded composition as the p-type impurity concentration is higher and mix proportion of Al is lower on the electrically conductive substrate side. In this case, the composition may be graded either continuously or stepwise. For example, the p-type contact layer may be constituted from a first p-type contact layer that makes contact with the ohmic electrode and has high p-type impurity concentration and low Al content, and a second p-type contact layer that has low p-type impurity concentration and high Al content. The first p-type contact layer enables to achieve good ohmic contact and the second p-type contact layer suppresses self-absorption of the emitted light.

After forming the nitride semiconductor layers on the substrate 10 in the process described above, the wafer is taken out of a reaction apparatus and is subjected to heat treatment at 400°C or higher in an atmosphere that includes oxygen and/or nitrogen. This process removes hydrogen that is bonded in the p-type layer, so as to form the p-type nitride semiconductor layers that show p-type conductivity.

Then the p-type electrode 14 that achieves ohmic contact is formed on the surface of the p-type contact layer. The p-type electrode may be formed by CVD process, sputtering, vapor deposition or the like. The p-type electrode is preferably formed from the material described previously. Sheet resistance can be decreased by forming in multiple layer structure of two or more layers with the total thickness of 50000 Å (5 μm) or less, compared with a singular layer structure having a uniform thickness.

The p-type electrode may be formed in various shapes such as rectangular, stripes, square or lattice in plan view. For example, the p-type electrode 14 may be formed over the entire surface of the p-type semiconductor layer, then openings 18 are formed in dots as shown in Fig. 9A and Fig. 9B. The p-type electrode may also be formed in such shapes as rhombic, parallelogram, mesh, stripes or comb, or such shapes as shown in Fig. 9C and Fig. 9D. A branching shape such that a single stem branches into a plurality of portions as shown in Fig. 8A and Fig. 10A may also be employed. Plurality of branch electrodes that are electrically connected may be formed in stripes while the p-type electrode has openings 18 as shown in Fig. 10B. Moreover, circular pattern may be employed. By using such a p-type electrode structure in combination with the substrate having the protrusions formed thereon, the efficiency of extracting light can be further improved.

In the case of p-type electrode having a plurality of through holes that reach the surface of the p-type semiconductor layer and are surrounded by the electrodes, area S of the portion surrounded by the outermost periphery of the p electrode (total area of the electrode including the openings) and total length L of the circumference of the openings preferably satisfy a relation $L/S \geq 0.024\ \mu m/\mu m^2$. This enables to make a semiconductor light emitting diode that allows efficient emission of light from the surface of the p-type semiconductor layer and has a low value of Vf.

The plurality of openings preferably have substantially identical shapes, which makes it easier to form the openings and achieves uniform light emission in the surface. It is also preferable that each of the plurality of openings has substantially the same area, which also contributes to achieving uniform light emission in the surface.

The p electrode 14 is an ohmic electrode used for supplying current to the device through ohmic contact with the surface of the p-type nitride semiconductor layer 13. In a nitride semiconductor device, it is a common practice to form a p pad electrode 15 for connection by wire bonding, besides the p electrode 14 for ohmic contact, and connect the p pad electrode 15 and the p electrode 14 that is an ohmic electrode. The p pad electrode 15 may be either provided on the p-side layer 13, or provided outside of the p-side layer 13 with metal wiring, for example, via an insulating film on the n-type layer 11 whereon the n-type electrode 16 is formed. When the p pad electrode 15 is formed on the p-side layer 13, the p pad electrode 15 may partially overlap the p electrode 14, or the p pad electrode 15 may be formed on the p electrode 14. Since the p pad electrode 15 is provided for the purpose of packaging with wires, it may have any thickness as long as it does not damage the semiconductor device when mounting. In case light is extracted from the side where the p-type electrode 15 is formed, it is necessary to form the p-type electrode 15 as small as possible.

The p-type electrode 15 is preferably made of a material that bonds well. Specifically, Co, Fe, Rh, Ru, Ti, V, Cr, Zr, Nb, Mo, Hf, Ta, W, Re, Mn, Al, Zn, Pt, Au, Ru, Pd or Rh may be used. Preferably, at least one kind selected from among a group consisting of Ag, Al, Pt, Cu, Ni, Ti, Au and Rh and oxide, nitride and the like thereof are used. More preferably, at least one kind selected from among a group consisting of Ag, Al and Pt is used. The p pad electrode may be made in single layer, alloy or multiple layers.

The n electrode 16 is formed on the surface of the n-type contact layer. For the n electrode 16, in addition to the electrode described above, W/Al, Ti/Al, Ti/Al/Ni/Au, W/Al/W/Pt/Au or Al/Pt/Au or the like may be used. Thickness of the n electrode 16 is preferably in a range from 0.1 to 1.5 $\mu$m. The n electrode 16 serves as a pad electrode for bonding as well as making ohmic contact. The n electrode 16 may also be formed in two layers of a pad electrode for bonding and an ohmic electrode that makes ohmic contact with the n-side layer 11, which may be formed at the same time in substantially the same shape. The n electrode for ohmic contact and the n pad electrode may also be formed one on another in different processes in different shapes.

Forming the electrode on the nitride semiconductor layer and then applying heat treatment makes it possible to accelerate alloy formation, achieve good ohmic contact with the semiconductor layer, and decrease the contact resistance between the semiconductor layer and the electrode. Temperature of heat treatment is preferably in a range from 200 to 1200°C, more preferably in a range from 300 to 900°C and most preferably in a range from 450 to 650°C. It is preferable that the ambient gas includes oxygen and/or nitrogen. The heat treatment may also be carried out in an ambient gas that includes inert gas such as Ar or in air atmosphere.

The semiconductor light emitting diode of the present invention may have a protective film 17 formed from $SiO_2$, $ZrO_2$, $TiO_2$, $Al_2O_3$, or an oxide that includes at least one element selected from among a group consisting of V, Zr, Nb, Hf, Ta or SiN, BN, SiC, AlN, AlGaN, etc. continuously on the side face of the device where the nitride semiconductor layers are stacked. The protective film is preferably an insulating film, which enables it to make a semiconductor device of high reliability. When the insulating film is provided on the surface of the p-type layer where the electrode is not formed, it is made possible to effectively suppress the migration of the electrode.

Then the wafer is divided by scribing or dicing into the chips of nitride semiconductor light emitting diode whereon the electrodes are formed as shown in Fig. 6.

This embodiment has been described for a case where light is extracted from the surface of the nitride semiconductor layer where the electrode is formed, although light may also be extracted from the substrate side. In this case, the p-side pad electrode 15 is preferably formed in oval shape as shown in Fig. 8B. A metallization layer (bump) is formed on the p-side pad electrode 15, instead of wire, for the connection with external electrodes or the like, for face down mounting as shown in Fig. 22B. The metallization layer may be made of Ag, Au, Sn, In, Bi, Cu, Zn or the like. In the case of face down mounting, the pad electrode is heated and expands in volume which, together with the pressure applied, causes the material that makes the pad electrode likely to flow toward the side face. In the nitride semiconductor light emitting diode of this embodiment, however, such trouble can be prevented since the electrode is alloyed as described above. The structure of this embodiment also has high heat dissipating characteristic and improved reliability.

The semiconductor light emitting diode of the present invention, in the case of gallium nitride-based LED (which includes at least gallium and nitrogen), for example, white light can be emitted with high output power by applying a mixture of fluorescent material and a resin to the surface of the light emitting diode whereon the electrode has been formed.

The light emitting diode 100 of the present invention may have such a structure, that is with the electrodes 14 and 16, one piece each, of the layers 11, 13 of the first and second conductivity types provided on the same side of the substrate, as shown in Fig. 8A, Fig. 8B, Fig. 9A, Fig. 9B and Fig. 10A. Alternatively, as shown in Fig. 8C,

Fig. 10B, Fig. 22A and Fig. 25A, one or both of the electrodes 14, 16 of the layers 11, 13 of different conductivity types is formed in plurality in one light emitting diode.

As explained in Fig. 25B, structure of the light emitting element is such that a light emitting portion 151 having the layers 11, 13 of the first and second conductivity types and preferably the active layer 12 interposed therebetween, a non-light emitting portion 152, where the layer of first conductivity type is exposed and electrode is provided, are provided in the substrate surface. The electrodes 14, 16 of the layers 11, 13 of different conductivity types are provided in plurality, making pairs. The electrode 14 and 16 have extended portions 14x and 16x, respectively, so that the light emitting portion 151 is interposed by the extended portions 14x and 16x. The light emitting diode can be divided into a functional part 157 which receives electric current and functions as the light emitting element and a non-functional part 158 that is mostly passive such as the portion surrounding the light emitting element. The functional part 157 includes at least one light emitting portion 151 and the non-light emitting portion 152 where electrodes are formed. The non-functional part 158 consists mainly of the non-light emitting portion 152.

The light emitting diode shown in Figs. 8C, 10B and 25A has a plurality of light emitting portions 151 provided on the substrate, and the light emitting portions 151 are connected to each other, for example, as shown in Figs. 25A and 25B. The electrodes 16 of the layer 11 of the first conductivity type, namely the electrode forming portions 152 are also provided in plurality. The light emitting diode 100 shown in Fig. 22A, in contrast, has a plurality of light emitting portions 151, but the light emitting portions 151 are separate from each other. The plurality of electrodes of the electrode forming portion 152 are also provided separately. In this way, plurality of the light emitting portions may be provided while being separated from or connected to each other in the light emitting diode 100 (or functional portion 157).

According to the present invention, as shown in Fig. 25B, transverse propagation of light in the element 101, particularly in the layer 11 of the first conductivity type that constitutes the light emitting portion 151 is suppressed by the protrusions 20 formed on the surface of the substrate 10, thus enabling to extract light efficiently. Particularly in a region where the layer of the first conductivity type is exposed, since a strong optical waveguide is formed by air (or a protective film), the layer of the first conductivity type and substrate, transverse propagation of light is likely to occur. Even in such a region, transverse propagation of light can be changed into longitudinal direction by providing the protrusions 20 on the substrate, so as to extract light efficiently in the direction perpendicular to the substrate surface (on the side where the element is formed, or on the opposite side where the substrate is exposed).

A light propagating region exists on the substrate side from the exposed portion 11s of the layer of the first conductivity type, also in the non-functional portion 158. Therefore, light propagation loss can be reduced also in the non-functional portion 158 by providing the protrusions 20 on the substrate.

In the case of a light emitting diode that emits light from the electrode forming surface thereof, an electrode 14 that is permeable to light is provided by means of translucent material or an opening in the light emitting portion 151. Even in such a case, the electrode 16 and a pad 16b of the layer 11 of the first conductivity type, or a pad electrode 15 and a pad 15b of the layer of the second conductivity type are not transparent in most cases. When this is the case, light is extracted from a region where the non-transparent electrode is not formed. Therefore, it is particularly preferable that protrusions are provided on the substrate in the region where the non-transparent electrode is not formed (for example, the region of the non-light emitting portion 152 where the non-transparent electrode is not formed). When light is extracted from the electrode forming surface, while it is important that the electrode 14 formed on the light emitting portion 151 is permeable to light, other electrodes may also be made permeable to light. For example, the electrode 16 of the layer 11 of the first conductivity type and also the pad electrodes may be made permeable to light.

In the light emitting diode that has large area and a plurality of light emitting portions as shown in Figs. 8C, 10B, 22A and 25A, distribution of light intensity within plane is likely to occur. For example, there occurs difference in light intensity in the light emitting portions 151, the non-functional portion 152 where the electrode 16 is formed and the non-functional portion 158 around the element. Difference in light intensity may also occur among the non-functional portions 152. As a result, light intensity is likely to be distributed unevenly throughout the chip. In the light emitting diode of the present invention, uneven distribution of light intensity is mitigated by forming the protrusions 20 on the substrate surface. When the chip area increases, the region where the layer of the first conductivity type increases, and therefore propagation and loss of light tend to increase. This problem is also improved by forming the protrusions on the substrate surface. Thus the present invention is preferably applied to a light emitting diode that has large area and a plurality of light emitting portions.

In the case of a light emitting diode that emits light from the back of the substrate, it is preferable to form the protrusions over the entire surface of the substrate. In case the electrode forming surface of the light emitting diode 100 is connected to a base 104 (or element mounting surface or the like) as shown in Fig. 22B, for example, light can be extracted satisfactorily from the back surface of the substrate 10 by providing the protrusions 20 over the entire surface of the substrate 10.

In the light emitting diode of the present invention, recess-and-protrusion section 6x, 6y that functions as light extracting and light reflecting portion may be provided on the electrode forming surface as shown in Fig. 25B. Specifically, the recess-and-protrusion section 6x, 6y is formed on the surface of the semiconductor layer 101 outside the light emitting portion 151, preferably along the side face of the light emitting portion 151. The recess-and-protrusion section 6x, 6y can be formed by partial etching of the semiconductor layer 101. For example, when the n-type layer 11 that becomes the electrode 16 forming surface by etching, the recess-and-protrusion section 6x, 6y may be formed at the same time.

The light emitting diode 100 shown in Fig. 25A is a variation of the light emitting diode shown in Fig. 10B where recess-and-protrusion section 6x, 6y is provided. Sectional view of Fig. 25B schematically shows a section along line A-A of the light emitting diode shown in Fig. 25A.

As shown in Fig. 25B, the recess-and-protrusion section 6x is provided in a non-current injected portion 158 (non-functional portion) along the periphery of the light emitting diode. The recess-and-protrusion section 6y, on the other hand, is provided in a functional portion (current injected portion) 157 between the electrode 16 of the layer of the first conductivity type and the light emitting portion 151. More specifically, the recess-and-protrusion section 6y is provided in the light emitting diode (functional portion 157) along the side face of the light emitting portion 151 that is provided in singularity or plurality, between the electrode 16 and the light emitting portion 151.

The recess-and-protrusion section 6x reflects light that emerges from the light emitting diode mainly sideways, namely light that propagates horizontally from the light emitting portion 151, and directs the light in the vertical direction, namely in a direction substantially perpendicular to the electrode forming surface. This increases the component of light perpendicular to the electrode forming surface. The recess-and-protrusion section 6y that is provided in the functional portion 157, on the other hand, has the function to prevent light from being absorbed by the electrode 16 or being entrapped in other light emitting portion that is adjacent thereto, in addition to the function similar to that of the recess-and-protrusion section 6x. As a result, extraction loss of light can be reduced and the efficiency of light emission can be improved.

In the light emitting diode of the present invention, it is preferable to provide the recess-and-protrusion section 6y between the light emitting portion 151 and the electrode 16, and to provide the protrusions 20 on the substrate surface that overlaps thereon. Particularly, in case the electrode 16 that is provided in a part of the non-light emitting portion 152 shields light emitted from the adjacent light emitting portion 151, light can be effectively extracted by the cooperation of the recess-and-protrusion section 6y and the protrusions 20 to the outside of the LED , especially in a direction perpendicular to the electrode forming surface. The recess-and-protrusion section 6y also has favorable effect on light propagating from the substrate side. That is, the recess-and-protrusion section 6y provided on the electrode forming portion 152 makes it difficult for light propagating from the substrate side to propagate toward the side face of the light emitting portion, thereby suppressing the light loss due to the electrode and the light emitting portion.

Side face of the recess-and-protrusion section 6x, 6y may also be formed in a shape similar to that of the side face of the protrusions 20 provided on the substrate surface. In this case, a method similar to that of forming the protrusions 20 on the substrate may be employed. The recess-and-protrusion section 6x, 6y formed on the semiconductor layer 101 has the function of extracting light that propagates in the layer, and the function to advantageously reflect the light that is extracted from the light emitting portion 151 located nearby to the outside. When the recess-and-protrusion section 6x, 6y is formed in a shape similar to that of the side face of the protrusions provided on the substrate surface, contact area of the bottom of the recess-and-protrusion and the inside of the element increases, thereby enabling it to extract more light from the inside of the element. Moreover, since the inclination angle of the side face of the recess-and-protrusion section 6x, 6y becomes smaller on the top face side, it is made possible to advantageously reflect the light, that propagates from the adjacent light emitting portion 151, in a direction perpendicular to the substrate surface.

In case a plurality of light emitting portions having complicated shape and/or structure are provided as shown in Figs. 8C, 10B, 22A and 25A, greater loss occurs when extracting light. The loss can be decreased by forming the functional recess-and-protrusion section shown as 6x, 6y. Also in a light emitting diode where the light intensity is unevenly concentrated in a particular direction, uneven distribution of light can be improved by providing the protrusions 20 on the substrate and the recess-and-protrusion section on the semiconductor layer, so that the light emitting diode having high directivity can be obtained. It is preferable to provide the recess-and-protrusion section like 6x, 6y so as to surround the light emitting portion 151 in the functional portion 157 of the light emitting diode as shown in Fig. 25B. It is also preferable to provide the recess-and-protrusion section 6x, 6y so as to surround the electrode 16 that is provided in conjunction with the light emitting portion 151. It is more preferable to provide the recess-and-protrusion section 6x, 6y on substantially the entire periphery. Particularly in case the light emitting portion is surrounded by other light emitting portions as shown in Fig. 25A, light tends to be trapped as the light emitting portion is surrounded by the adjacent light emitting portions. This loss can also be mitigated by the recess-and-protrusion section 6x, 6y. Most preferably, as shown in Fig. 25A, 25B, the recess-and-protrusion section 6x, 6y is provided so as to surround the light emitting portion 151 on almost the entire periphery, and also surround the electrode 16 on almost the entire periphery thereof.

As described previously, the recess-and-protrusion section 6x, 6y may be formed at the same time when the electrode forming surface 11s of the layer 11 of first conductivity type is exposed by etching. This provides an advantage with respect to the manufacturing process, since the recess-and-protrusion section 6x, 6y separated from the current injection electrode (for example, 14) and the light emitting portion 151 can be easily formed.

Bottom of the recess-and-protrusion section 6x, 6y may or may not correspond to the electrode forming surface 11s. For example, when the bottom of the recess-and-protrusion section 6x, 6y is located in the layer 11b of first conductivity type that is deeper than the electrode forming surface, light that propagates horizontally in the base layer 1a and light reflected from the substrate 10 can be extracted efficiently. It is particularly preferable that the recess-and-protrusion section 6x, 6y penetrates the layer 11b of first conductivity type and reaches the base layer 11a, namely reaches the depth where the non-functional portion is partly provided, and more preferably the recess-and-protrusion section 6x, 6y is formed at such a depth where the substrate is exposed. This makes it possible to isolate the layer 11b of first conductivity type and the base layer 11a, so that light propagating therein can be extracted efficiently. At this time, if the recess-and-protrusion section 6x, 6y is provided in the element 157 at the depth where the layer 11b of first conductivity type is partially or entirely removed, current diffusion path is interrupted. Therefore, it is preferable to divide the recess-and-protrusion section 6y in a plurality of regions in order to secure the current diffusion path. By providing the recess-and-protrusion section 6y in a fragmentary condition when viewed from above, the region between the portions of the recess-and-protrusion section 6y can be made the current diffusion path.

Various plan-view configurations and arrangements of the recess-and-protrusion section 6x, 6y may be employed similarly to the protrusions of the substrate. Fig. 25A shows triangular arrangement of circles similar to that of the protrusions shown in Fig. 19A. Light that has propagated horizontally in the diode emerges from the side faces of the device in various directions. Therefore, it is preferable to provide the recess-and-protrusion section 6x, 6y so as to effectively obstruct the emergence of light

in all directions from the side faces of the light emitting diode. Specifically, it is preferable to provide the recess-and-protrusion section 6x, 6y periodically in two rows, more preferably three rows or more along the side face of the light emitting element as shown in Fig. 25A.

Moreover, it is preferable to make the plan-view configuration of the recess-and-protrusion section 6x, 6y in substantially circular or oval shape so as to advantageously reflect light incident in various directions. Among the side faces of the recess-and-protrusion section 6x, 6y, the side face that faces the light emitting element is preferably a curved surface. [Embodiment 4 (light emitting diode)]

The fourth embodiment is an element stack 103 comprising the light emitting diode 100 mounted on a stack base 104 on the electrode forming surface thereof. Also the light emitting device made by packaging the light emitting diode 100 or the element stack 103 will be described.

(Element stack)

Fig. 22B is a schematic sectional view of the element stack 103. The base 104 has a plurality of connection electrodes (not shown) each corresponding to the electrodes 14, 16 of the light emitting diode 100, while being electrically insulated from each other. The electrodes and the light emitting structure that are separated from each other on the light emitting diode side may also be electrically connected with each other by means of the electrodes of the base 104 side.

An element further to the light emitting diode 100 may also be provided on the base 104. Here, current, electrostatic protective element is formed in the base 104 as indicated by the equivalent circuit diagram of Fig. 22C, as shown in Fig. 22B. The current, electrostatic protective element is constituted from a p-type layer (the layer of the first conductivity type) 115a and a n-type layer (the layer of the second conductivity type) 115b provided in the base 104. Two or more element portions may be provided on the base 104 and connected with the electrodes of the light emitting diode 100 outside of the base and the mounting base 201 (Fig. 24). The protective element may be mounted on a mounting portion 222 in the light emitting device 200 and connected with the light emitting diode (refer to Fig. 24).

The electrodes 14, 16 on the light emitting diode 100 side and the electrodes of the base 104 are connected via connecting member 114. Alternatively, a part of the electrodes on the light emitting diode 100 side or part of the electrode 112 on the base 104 side may be used as the connecting member. For example, a connecting layer may be formed instead of the pads 16b, 15b of the light emitting diode 100.

The base 104 may also be a sub mount such as heat sink that does not have element structure. The base 104 and the outside may be connected through connection electrode by wire bonding or the like. The electrodes of the element portion of the base 104 or the electrodes that connects the inside and the outside of the base may also be formed on the mounting surface and used as the electrodes or connection layer 114 for connecting the light emitting diode.

(Light emitting device 200)

Fig. 23 and Fig. 24 show light emitting devices comprising the light emitting diode 100 or the element stack 103 on a device base. In the example shown in Fig. 24, two leads 210a and 210b are fastened onto the device base 220. One of the leads, 210a, is the mount lead. The mount lead 210a functions as the mounting base 201, and the light emitting diode 100 (stack 103) is mounted via the connection layer 114 (or the bonding layer 204) in a housing portion (recess) 202 of the device base 201. A side face 203 of the housing portion 202 of the mounting base 201 and a side face 221 of an opening 205 of the device base 220 function as light reflectors. The mounting base 201 that is the mount lead may also be used as a heat sink 205 for the light emitting diode and connected to an external heat sink. The device base 220 also has the opening 225 in the light extracting surface 223, so that the top face of the mounting base 201 is exposed through the opening 225 as a terrace 222. The protective element and other elements may be mounted on the terrace 222. The recess 202 of the mounting base 201 and the inside of the opening 225 of the device base 220 are filled with a translucent sealing member 230. The lead electrode 210b comprises an inner lead 212a provided inside of the device base 220 and an external lead 212b that is an extension thereof to the outside of the device base 220, so as to be connected with the outside thereby. The light emitting diode 100 (stack 103) is electrically connected to the leads 210a and 210b via a wire 250 or the connection member 204.

In the example shown in Fig. 23, the light emitting diode 100 is mounted by means of a bonding member 204 on the mounting base 201 that is insulated from the leads 210a and 210b. A reflecting portion is provided on the recess side face 203 of the mounting base 201 that houses the light emitting diode 100. The mounting base 201 may also be connected to an external heat sink as the heat sink 205. The light emitting diode 100 is connected by the wire 250 to the leads 211a and 211b. The leads 210a and 210b are electrically connected to the outside via external leads 211a and 212b. Separation of the mounting base 201 and the lead 210 makes the light emitting device of excellent thermal design. The recess 202 of the mounting base and the opening of the device base 220 may be sealed with the translucent sealing member 230. Light emission with desired directivity can be obtained by providing an appropriate optical system (lens) in the light extracting portion. The lens may be optically connected with the sealing member 230. Or, alternatively, the sealing member 230 itself may be formed in the shape of lens.

(Light converting member)

A light converting member 106 or a light conversion layer 231 may be provided in the light emitting device as shown in Fig. 23. The light converting member 106 or the light conversion layer 231 absorbs a part of the light emitted by the light emitting diode 100 and emits light of a different wavelength, and may contain a fluorescent material. The light converting member 106 or the light conversion layer 231 is formed so as to cover a part of the light emitting diode 100 or as a whole thereof. Alternatively, the light converting member may also be formed as a coating film 105 that covers a part of the stack base 104 as shown in Fig. 24. For the binder of the fluorescent material, an oxide or a hydroxide that includes at least one element selected from a group consisting of Si, Al, Ga, Ti, Ge, P, B, Zr, Y, Sn, Pb or an alkaline earth metal is preferably used. The binder can be produced from an organometallic compound that includes at least one element selected from a group consisting of Si, Al, Ga, Ti, Ge, P, B, Zr, Y, Sn, Pb or an alkaline earth metal (preferably plus oxygen). The organometallic compound includes a compound having an alkyl group and an allyl group. Examples of the organometallic compound include metal alkoxide, metal diketonate, metal diketonate complex and metal carboxylate.

The light converting member may also be provided as part of the sealing member 230 of the light emitting device 200. For example, the light converting member may be provided as a layer 231 provided on the sealing member 230a or between the sealing members 230a and 230b, apart from the light emitting diode 100, as shown in Fig. 23. Moreover, the entire sealing member 230 may also be used as the light converting layer by dispersing the light converting member in the sealing member 230. The light converting member may also be provided as a sedimentation layer in the recess (housing portion) of the device base 220 or the mounting base 201. Furthermore, as shown in Fig. 24, the light converting member may be included in the film 105 that covers the substrate where the protrusions are provided and/or the light emitting diode 100.

In case the coating film is provided on the surface of the substrate opposite to the diode forming surface, namely the back of the substrate and the side face of the substrate, if there is a significant difference in the intensity of light emerging from the side face and the back surface of the substrate, color of the light produced by blending the converted light and the light emitted by the light emitting diode varies depending on the direction (color unevenness). Particularly when two or more fluorescent materials, specifically two or more kinds of fluorescent material having different wavelengths of converted light are used for the light converting member, the problem of color unevenness becomes profound. The substrate having the protrusions 20 provided in the light emitting diode of the present invention as described above can suppress the color unevenness. While the coating film 105 of the chip has been described, similar effects can be achieved also in the case of light converting member in the sealing member, or in the case of extracting light from the light emitting diode side.

Examples of the fluorescent material described above are as follows. As the fluorescent material that emits green light, $SrAl_2O_4$:Eu, $Y_2SiO_5$:Ce, Tb, $MgAl_{11}O_{19}$:Ce, Tb, $Sr_7Al_{12}O_{25}$:Eu, (at least one of Mg, Ca, Sr and Ba) $Ga_2S_4$:Eu may be used. As the fluorescent material that emits blue light, $Sr_5(PO_4)_3Cl$:Eu; $(SrCaBa)_5(PO_4)_3Cl$:Eu; $(BaCa)_5(PO_4)_3Cl$:Eu; (at least one of Mg, Ca, Sr and Ba)$_2B_5O_9Cl$:Eu, Mn; (at least one of Mg, Ca, Sr and Ba) $(PO_4)_6Cl_2$:Eu, Mn may be used. As the fluorescent material that emits red light, $Y_2O_2S$:Eu; $La_2O_2S$:Eu; $Y_2O_3$:Eu; $Gd_2O_2S$:Eu may be used. The composition that includes YAG makes it possible to emit white light so as to greatly broaden the applications including the light source for illumination. YAG is a material represented by $(Y_{1-x}Gd_x)_3(Al_{1-y}Ga_y)_5O_{12}$:R (R is at least one element selected from Ce, Tb, Pr, Sm, Eu, Dy, Ho, and satisfies $0 < R < 0.5$), for example, $(Y_{0.8}Gd_{0.2})_3Al_5O_{12}$:Ce, $Y_3(Al_{0.8}Ga_{0.2})_5O_{12}$:Ce.

While nitride-based fluorescent material is used as the fluorescent material that emits reddish light in this embodiment, the light emitting diode of the present invention may also be provided with the YAG-based fluorescent material and a fluorescent material that can emit reddish light. Fluorescent materials that can emit reddish light are those which emit light upon excitation by light of wavelength from 400 to 600 nm, for example, $Y_2O_2S$:Eu; $La_2O_2S$:Eu; CaS:Eu; SrS:Eu; ZnS:Mn; ZnCdS:Ag, Al; ZnCdS:Cu, Al; etc. Use of the YAG-based fluorescent material and the fluorescent material that can emit reddish light enables to improve the color rendering performance of the light emitting diode.

The YAG-based fluorescent material formed as described above and the fluorescent material that can emit reddish light represented by nitride-based fluorescent material can be used in such a manner that two or more kinds thereof exist in one color conversion layer at the lateral side face of the light emitting diode, or one or more kinds thereof exists in each of two color conversion layers. With such a constitution, light of mixed color can be obtained through mixing of light emitted by different kinds of fluorescent material.

Selecting the fluorescent materials as described above enables it to make a light emitting diode that can emit light with various wavelengths with high efficiency of extracting light. The light emitting diode of the present invention is not limited to the visible region but may also be used for emitting ultraviolet ray together with a fluorescent material that is excited by the ultraviolet ray and emits visible light. Further, it can be applied to light of various wavelengths and electromagnetic radiation.

[Examples]

Now examples of the present invention will be described, but the present invention is not limited to these examples and may be applied to various other forms on the basis of the technical idea of the present invention.

Characteristics of the semiconductor light emitting diodes having protrusions of forms A, B and C to be described below were evaluated with the results as shown in Figs. 20, 21.

Sapphire substrates having principal plane in C plane and orientation flat surface in A plane are used.

In Example A, protrusions having a shape of equilateral triangle measuring about 5 μm in one side are formed at a distance of 2 μm (distance between adjacent sides) on the substrate surface. The protrusions are disposed in such an arrangement as sides of adjacent protrusions 20 oppose in substantially parallel to each other as shown in Fig. 19D. A parallelogram enclosed by dashed line 43 having interior angles of about 60º and 120º is regarded as unit cell that is repeated in the directions of axes 51, 52 periodically at equal intervals. Sides of the protrusions are formed in parallel to M-plane.

The protrusions are formed by a method shown in Fig. 2, Fig. 18. First, the protective film 25 that makes a mask is formed from $SiO_2$ on the substrate and is shaped in a desired configuration by photolithography and RIE as shown in Fig. 2B, Fig. 18A. Then RIE etching is carried out by using $Cl_2/SiCl_4$ as shown in Fig. 2C, Fig. 18B (first step). Depth of etching is set to about 1 μm so that the protective mask 25 is almost totally removed.

Then etching is continued so as to form the protrusions having two inclined surfaces as shown in Fig. 2D, Fig. 18C (second step). This results in the formation of the protrusions 20 having the first sloped surface 22 and the second sloped surface 23 as shown in Fig. 5A. Then as will be described later in Example 1, the base layer made of GaN in thickness of about 4 μm, the n-type layer such as n-type contact layer, the active layer and the p-type layer are formed on the substrate to make the semiconductor light emitting diode.

The n-type layer is partially exposed to form the n-type electrode therein. The transparent electrode of Ni/Au is formed over substantially the entire surface of the p-type layer thereby making the LED.

Example B is a variation of example A where the protrusions of the substrate are formed in circular shape as shown in Example 1, Fig. 4A, Fig. 19A and Fig. 19B. Protrusions having diameter of 4 μm are arranged at intervals of 1.5 μm. A parallelogram enclosed by dashed line having interior angles of about 60º and 120º is regarded as unit cell 53 that is repeated in the directions of axes 51, 52 periodically as shown in Fig. 19A.

Example C is a variation of the substrate manufacturing process of Example B where the second step of etching is followed by RIE etching with $CF_4$ as the third step so as to form the side face (curved surface protruding toward the outside) as shown in Fig. 18D, Fig. 15 and Fig. 16A.

The following results are obtained through observation of the surface and measurement of the LED characteristics of the Examples A, B and C having the protrusions formed in different patterns as described above. Electrostatic destruction characteristic is shown in Fig. 20. Graph 61 shows the electrostatic withstanding voltage in the forward direction and graph 62 shows the electrostatic withstanding voltage in the backward direction. Examples A and B shows substantially the same electrostatic withstanding voltage in the forward direction, with Example B showing less data dispersion in the characteristics than Example A. Example C shows remarkably higher electrostatic withstanding voltage than Examples A and B. It can be seen that Example C shows small data dispersion comparable to that of Example B.

In terms of electrostatic withstanding voltage in the backward direction, too, Example A and Example B are comparable similarly to the case of forward direction, while Example C showing greatly improved electrostatic withstanding voltage. It can be seen that circular shapes of Examples B and C show less data dispersion in the characteristics than the triangular shape of Example A. Electrostatic withstanding voltage was measured under the conditions of 200 pF and 0 Ω. Breakdown voltage was measured on 10 pieces of each Example. Mean value, maximum value (maximum value is evaluated as "2500 V" if a sample is not destroyed at 2500 V) and minimum value of the measurements are plotted as shown in the graph of Fig. 20.

Measurements of luminance of the light emitting diode chips in the Examples show that Example B has slightly higher luminance than Example A as shown in Fig. 21. Output power is significantly higher in Example C than in Examples A and B, showing improvement of about 14% over Example A. With regards to Vf, Example B shows a value 0.02 V higher and Example C shows a value about 0.06 V higher than that of Example A. Variability of wavelength of emitted light within a wafer is comparable among the Examples.

Conditions of the wafers whereon the semiconductor is formed are observed with an optical microscope,for pits and are observed with TEM for threading dislocation, in order to compare the crystallinity among the Examples. Example A shows many pits with a high density, showing unsatisfactory crystal growth in a large region. Example B shows less pits as a whole than Example A, showing unsatisfactory crystal growth in a smaller region. In Example C, pits are hardly observed, and unsatisfactory crystal growth is observed in only smaller region. In Example A, voids 44 are observed at near the center of opposing sides of the triangular protrusions as shown in Fig. 19D. Observation of a cross section shows that occurrence of threading dislocation is less and crystallinity is better in Example A than in Example B. Inclination angle $\theta_m$ of the entire sloped surface of the protrusions observed with SEM is from about 65º to 70º in Example B and from about 45º to 50º in Example C.

This suggests that smaller inclination angle increases the effect of extracting light and improves the efficiency of light emission in Example C. In Example C, it is supposed that the notch 27a shown in Fig. 18E is smoothed in the third step, and the side faces of the protrusions are smoothed (refer to Fig. 16) so as to form the curved surface 26, thus resulting in reduced pits in the semiconductor layer, reduced threading dislocation and reduced unsatisfactory growth. As a result, higher yield, less variability and higher output power are obtained in Example B than in Example A, and in Example C than in Example B.

Observation of the inclination angle $\theta_m$ of the entire sloped surface of the protrusion and surface condition of the side face of the protrusion while changing the etching condition in Example C shows as follows. When the duration of etching in the third step is made longer, the inclination angle continues to decrease while craters appear due to damage by etching on the top face of the protrusions, flat surface between the protrusions and the side face of the protrusions, with deteriorating crystallinity. Thus it is desirable to set a proper duration of etching. Then the etching gas used in the third step is changed. With Ar gas, shape of protrusions and electrostatic withstanding voltage that are intermediate between Examples A and C are obtained, and the inclination angle of the protrusions is about 60°. When $SiCl_4$ is used as the etching gas, the inclination angle is about 70º, slightly decreasing from the second step, while only a part on the top face side is turned into a curved surface. When etching with $SiCl_4$ gas is added following the third step of Example C, protrusions having inclination angle of about 50º, comparable to that of Example C are obtained. When $SiCl_4/Cl_2$ gas is used in the etching of the third step, inclination angle of about 58º, which is larger than that of Example C, is obtained. A decreasing trend of the radius of curvature of the curved surface on the side face of the protrusions is also observed. From the findings described above, it is preferable to use $CF_4$ and Ar as the etching gas in the third step.

Example 1

A sapphire substrate of which principal plane lies in C plane (0001) having orientation flat in A-plane (11-20) is used as the substrate. First, a SiO2 film 25 is formed on the sapphire substrate 10 to make an etching mask as shown in Fig. 2A.

Then a round photo mask having diameter of 5 $\mu$m is used to etch the protective film 25 made of SiO2 and the sapphire substrate 10 to a depth of 1 $\mu$m by RIE as shown in Figs. 2B, 2C. After removing the protective film 25, surface of the sapphire substrate 10 is further etched so as to form a repetitive pattern of protrusions 20, shown in Fig. 2D, having sloped surfaces formed in two steps (regions that are not etched are indicated by hatching). Diameter of the top surface of the protrusions 20 is 3 $\mu$m and distance between adjacent protrusions 20 is 1.5 $\mu$m. Angle of inclination $\theta_1$ of the first sloped surface 22 on the side face of the protrusions 20 is 70°, and angle of inclination $\theta_2$ of the second sloped surface 23 is 20° (Fig. 12).

On the sapphire substrate 10 whereon the repetitive pattern of protrusions 20 has been formed, a low-temperature growth buffer layer of $Al_xGa_{1-x}N$ ($0 \leq x \leq 1$) is formed to a thickness of 100 Å (10 nm), a GaN layer is formed to a thickness of 3 $\mu$m, a Si-doped GaN layer to a thickness of 4 $\mu$m and a GaN layer is formed to a thickness of 3000 Å (300 nm), as the n-type semiconductor layers. Next, the active layer of multiple quantum well structure is formed to make the light emitting region by forming 6 well layers of InGaN each 60 Å (6 nm) thick and 7 barrier layers of Si-doped GaN each 250 Å (25 nm) thick alternately. The barrier layer to be formed last may be undoped GaN. By forming the first layer made of undoped GaN on the low-temperature growth buffer layer, the protrusions 20 can be embedded more uniformly so as to obtain high crystallinity of the semiconductor layer to be formed thereon.

After forming the active layer of multiple quantum well structure, 200 Å (20 nm) of Mg-doped AlGaN, 1000 Å (100 nm) of undoped GaN and 200 Å (20 nm) of Mg-doped GaN are grown as the p-type semiconductor layer. The undoped GaN layer formed as the p-type semiconductor layer shows the property of p-type due to Mg diffusing therein from the adjacent layer.

Then the Si-doped GaN layer is exposed by etching from the Mg-doped GaN, the p-type semiconductor layer, the active layer and part of the n-type semiconductor layer, so as to form the n electrode.

Then transparent p electrode made of Ni/Au is formed over the entire surface of the p-type semiconductor layer, and the p pad electrode made of W/Pt/Au is formed on the transparent p electrode at a position opposing the exposed surface of the n-type semiconductor layer. The n electrode made of W/Pt/Au is formed on the exposed surface of the n-type semiconductor layer.

Last, the wafer is divided into rectangular chips so as to obtain semiconductor LED chips measuring 350

μm square. The semiconductor chip is mounted on a lead frame that has a reflector, thereby making a bullet-shaped LED. The LED emits light having wavelength of 400 nm with output power of 14.0 mW for a forward current of 20 mA.

Comparative Example 1

A bullet-shaped LED was made similar to Example 1 except for forming recess or protrusion in single step on the surface of a sapphire substrate as a Comparative Example. Output power of the LED was 9.8 mW for a forward current of 20 mA.

Example 2

A sapphire substrate of which principal plane lies in C plane (0001) having orientation flat in A-plane (11-20) is used as the substrate. A protective film is used to form circular protrusions having diameter of 3 μm on the sapphire substrate 10. Diameter of the top surface of the protrusion is 2 μm and distance between adjacent protrusions is 1.0 μm. Angle of inclination $\theta_1$ of the sloped surface on the side face of the protrusion is 70°, and angle of inclination $\theta_2$ is 20°. The protrusions are formed in a pattern shown in Fig. 7B. With other respects, this Example is similar to Example 1. Output power of the LED thus obtained was 14.0 mW for a forward current of 20 mA.

Example 3

Projections are formed on a substrate under the following conditions. With other respects, this Example is similar to Example 1. Photo mask having a shape of equilateral triangle measuring 5 μm along one side is aligned so that one side of the equilateral triangle is perpendicular to the orientation flat. After etching the protective film 25 made of $SiO_2$ and the sapphire substrate 10 to a depth of 1 μm by RIE so that the sides of the equilateral triangle become substantially parallel to M-planes (1-100), (01-10) and (-1010) of sapphire as shown in Figs. 2B, 2C, the protective film 25 is removed. Surface of the sapphire substrate 10 is further dry etched so as to form the repetitive pattern of protrusions 20 shown in Fig. 2D. Length a of one side of the top surface of the protrusion is 2 μm and distance b between adjacent protrusions is 1.5 μm. Angle of inclination $\theta_1$ of the side face of the protrusion is 70°, and angle of inclination $\theta_2$ is 20° (Fig. 13). Output power of the LED thus obtained was 12.0 mW for a forward current of 20 mA.

The present invention has been fully described by way of preferred embodiments while making reference to the accompanying drawings. Various variations and modifications of the present invention are apparent to those skilled in the art. Such variations and modifications are understood to fall within the scope of the present invention to the extent that does not deviate from the appended claims.

**Claims**

**1.** A semiconductor light-emitting diode (LED), comprising:

a substrate having protrusions formed on the surface thereof; and
semiconductor layers made of material different from that of said substrate and provided over the surface of said substrate,
wherein a side face of said protrusions includes at least two surfaces having different inclination angles where the side face of said protrusions protrudes toward the outside of said protrusions;
wherein the top face of said protrusions is substantially flat; and
wherein the side face of said protrusions has at least a first sloped surface and a second sloped surface, from the bottom of the substrate,

**characterised in that**:

surface roughness $Ra_1$ of said first sloped surface is larger than surface roughness $Ra_2$ of said second sloped surface.

**2.** The semiconductor light-emitting diode according to claim 1,
wherein said semiconductor layers is formed from a first semiconductor crystal (41) grown from the top face of said protrusions and a second semiconductor crystal (42) grown from the region between said protrusions.

**3.** The semiconductor light-emitting diode according to any one of claim 1 or 2, wherein the side face of said protrusions has at least a first sloped surface and a second sloped surface, from the bottom of the substrate, with inclination angle $\theta_1$ of said first sloped surface being larger than inclination angle $\theta_2$ of said second sloped surface.

**4.** The semiconductor light-emitting diode according to any one of claims 1 to 3, wherein said protrusions have a polygonal shape that is constituted from straight line segments which cross a plane that is substantially parallel to a stable growth plane of said semiconductor layer, in plan view.

**5.** The semiconductor light-emitting diode according to any one of claims 1 to 4, wherein said protrusions are formed in repetitive pattern.

**6.** The semiconductor light-emitting diode according to any one of claims 1 to 5, wherein said substrate is made of a material selected from the groups consisting of sapphire, Si, SiC and spinel.

**7.** The semiconductor light-emitting diode according to any one of claims 1 to 6, wherein said substrate is a sapphire substrate having C plane (0001).

**8.** The semiconductor light-emitting diode according to any one of claims 1 to 7, wherein said protrusions have circular, triangular, parallelogram or hexagonal profile in plan view.

**9.** The semiconductor light-emitting diode according to claim 2, wherein the angle of inclination $\theta_1$ of said first sloped surface is larger than 45° and smaller than 90°.

**10.** The semiconductor light-emitting diode according to any one of claims 1 to 9, wherein the side face of said protrusions has a curved surface.

**11.** The semiconductor light-emitting diode according to claim 10, wherein the side face of said protrusions has inclination angle $Ra_b$ on the bottom side larger than inclination angle $Ra_u$ on the top face side.

**12.** The semiconductor light-emitting diode according to any one of claims 1 to 11, wherein the side face of said protrusions has notches and width of said notches is larger on the bottom side than on the top face side and/or the number of said notches is larger on the bottom side than on the top face side.

**13.** The semiconductor light-emitting diode according to claim 1, wherein the protrusions are separated from each other and disposed periodically, wherein width of cross section of said protrusions is larger on the bottom side than on the top face side, and inclination angle of the side face of said protrusions is smaller on the top face side than on the bottom side; and wherein, with a circle that is, in the substrate surface plane, circumscribed with the side faces of two closest protrusions being referred to as the first circle, a circle that is, in the substrate surface plane, circumscribed with the side faces of at least three protrusions being referred to as the second circle and a circle that is, in a plane including the top surface of said protrusions, circumscribed with the side faces of two closest protrusions being referred to as the third circle, the diameter of said second circle is larger than the diameter of said first circle and smaller than the diameter of said third circle.

**14.** The semiconductor light-emitting diode according to claim 13, wherein said third circle and said second circle overlap each other.

**15.** The semiconductor light-emitting diode according to claim 13 or 14, wherein the side face of said protrusions has a curved surface that is convex toward the outside.

**16.** The semiconductor light-emitting diode according to any one of claims 13 to 15, wherein the bottom of said protrusions is circular, and said protrusions are disposed periodically at substantially the same intervals in two axial directions that intersect with an angle of about 60° in the substrate surface.

**17.** A method of manufacturing a light emitting diode (LED) with a substrate that has a plurality of protrusions, comprising:

a first step of dry etching a part of the substrate with a protective film provided on the substrate and forming protrusions having side faces;
a second step of dry etching the side faces and at least a part of the top faces of said protrusions that are exposed after removing the protective film, so as to make the inclination angle of the side face of said protrusions on the bottom side larger than the inclination angle on the top face side;
a first crystal-growing step of growing a first semiconductor crystal (41) from the top face of said protrusions and growing a second semiconductor crystal (42) from the region between said protrusions, so that said first semiconductor crystal (41) and said second semiconductor crystal (42) are separated with each other in said substrate plane;
a second crystal-growing step of growing a flat semiconductor layer on said substrate;
wherein the top face of said protrusions of said substrate formed in the second step is substantially flat, and the top face of said first semiconductor crystal and said second semiconductor crystal formed in the first crystal-growing step is substantially flat.

**18.** The method of manufacturing a light emitting diode (LED) according to claim 17, wherein said second semiconductor crystal (42) formed in the first crystal-growing step has such a thickness that reaches the top face of said protrusions.

**19.** The method of manufacturing a light emitting diode (LED) according to claim 17 or 18, wherein said second step is followed by a third step where the side faces and at least a part of the top faces of said protrusions are etched, so as to turn the side faces into curved surfaces.

**20.** The method of manufacturing a light emitting diode (LED) according to any one of claims 17 to 19, wherein the protective film is also removed in said first step of etching.

**21.** The method of manufacturing a light emitting diode (LED) according to claim 20, wherein said protrusions are provided in plurality, and top faces and/or bottom of said protrusions are circular.

## Patentansprüche

**1.** Halbleiterleuchtdiode (LED), Folgendes umfassend:

ein Substrat mit Vorsprüngen, die auf der Oberfläche von diesem ausgebildet sind; und
Halbleiterschichten, die aus einem anderen Material als dem des Substrats gebildet sind und die über der Oberfläche des Substrats vorgesehen sind,
wobei eine Seitenfläche der Vorsprünge zumindest zwei Oberflächen einschließt, die unterschiedliche Neigungswinkel aufweisen, wobei die Seitenfläche der Vorsprünge in Richtung auf die Außenseite der Vorsprünge hervorsteht;
wobei die Oberseite der Vorsprünge im Wesentlichen einen flachen Zustand aufweist; und
wobei die Seitenfläche der Vorsprünge zumindest eine - von der Unterseite des Substrats - erste geneigte Oberfläche und eine zweite geneigte Oberfläche aufweist,

**dadurch gekennzeichnet, dass**:

eine Oberflächenrauigkeit $Ra_1$ der ersten geneigten Oberfläche größer ist als eine Oberflächenrauigkeit $Ra_2$ der zweiten geneigten Oberfläche.

**2.** Halbleiterleuchtdiode nach Anspruch 1,
wobei die Halbleiterschichten gebildet sind aus einem ersten Halbleiterkristall (41), aufgewachsen von der Oberseite der Vorsprünge, und einem zweiten Halbleiterkristall (42), aufgewachsen aus dem Bereich zwischen den Vorsprüngen.

**3.** Halbleiterleuchtdiode nach einem der Ansprüche 1 oder 2, wobei die Seitenfläche der Vorsprünge - von der Unterseite des Substrats - zumindest eine erste geneigte Oberfläche und eine zweite geneigte Oberfläche aufweist, wobei ein Neigungswinkel $\theta_1$ der ersten geneigten Oberfläche größer ist als ein Neigungswinkel $\theta_2$ der zweiten geneigten Oberfläche.

**4.** Halbleiterleuchtdiode nach einem der Ansprüche 1 bis 3, wobei die Vorsprünge eine polygonale Form aufweisen, welche von geraden Liniensegmenten gebildet wird, die eine Ebene durchqueren, welche in der Draufsicht im Wesentlichen parallel zu einer stabilen Wachstumsebene der Halbleiterschicht angeordnet ist.

**5.** Halbleiterleuchtdiode nach einem der Ansprüche 1 bis 4, wobei die Vorsprünge in einem sich wiederholenden Muster gebildet sind.

**6.** Halbleiterleuchtdiode nach einem der Ansprüche 1 bis 5, wobei das Substrat aus einem Material gebildet ist, ausgewählt aus den Gruppen, bestehend aus Saphir, Si, SiC und Spinell.

**7.** Halbleiterleuchtdiode nach einem der Ansprüche 1 bis 6, wobei das Substrat ein Saphirsubstrat mit einer C-Ebene (0001) ist.

**8.** Halbleiterleuchtdiode nach einem der Ansprüche 1 bis 7, wobei die Vorsprünge in einer Draufsicht kreisförmige, dreieckige, hexagonale oder Parallelogramm-Profile aufweisen.

**9.** Halbleiterleuchtdiode nach Anspruch 2, wobei der Neigungswinkel $\theta_1$ der ersten geneigten Oberfläche größer als 45° und kleiner als 90° ist.

**10.** Halbleiterleuchtdiode nach einem der Ansprüche 1 bis 9, wobei die Seitenfläche der Vorsprünge eine gekrümmte Oberfläche aufweist.

**11.** Halbleiterleuchtdiode nach Anspruch 10, wobei die Seitenfläche der Vorsprünge einen Neigungswinkel $Ra_b$ auf der Unterseite aufweist, der größer ist als ein Neigungswinkel $Ra_u$ auf der oberen Stirnseite.

**12.** Halbleiterleuchtdiode nach einem der Ansprüche 1 bis 11, wobei die Seitenfläche der Vorsprünge Einkerbungen aufweist, und eine Breite der Einkerbungen an der Unterseite größer ist als an der oberen Stirnseite, und / oder die Anzahl der Einkerbungen auf der Unterseite größer ist als an der oberen Stirnseite.

**13.** Halbleiterleuchtdiode nach Anspruch 1, wobei die Vorsprünge voneinander getrennt sind und in regelmäßigen Abständen angeordnet sind, wobei eine Breite des Querschnitts der Vorsprünge auf der Unterseite größer ist als an der Stirnseite, und ein Neigungswinkel der Seitenfläche der Vorsprünge auf der oberen Stirnseite kleiner ist als auf der Unterseite; und
wobei, mit einem Kreis, der - in der Ebene der Substratoberfläche, abgegrenzt mit den Seitenflächen von zwei am nächsten liegenden Vorsprüngen - als der erste Kreis bezeichnet wird, mit einem Kreis, der - in der Ebene der Substratoberfläche, abgegrenzt mit den Seitenflächen von zumindest drei Vorsprüngen - als der zweite Kreis bezeichnet wird, und mit einem Kreis, der - in einer Ebene, welche die Oberseite der Vorsprünge einschließt, abgegrenzt mit den Seitenflächen von zwei am nächsten liegenden Vorsprüngen - als der dritte Kreis bezeichnet wird, der Durchmesser des zweiten Kreises größer ist als der Durchmesser des ersten Kreises und kleiner ist als der Durchmesser des dritten Kreises.

**14.** Halbleiterleuchtdiode nach Anspruch 13, wobei der dritte Kreis und der zweite Kreis einander überlappen.

**15.** Halbleiterleuchtdiode nach Anspruch 13 oder 14, wobei die Seitenfläche der Vorsprünge eine gekrümmte Oberfläche aufweist, die einen nach außen hin konvex geformten Zustand aufweist.

**16.** Halbleiterleuchtdiode nach einem der Ansprüche 13 bis 15, wobei der Boden der Vorsprünge kreisförmig gebildet ist, und die Vorsprünge in regelmäßigen Abständen mit im Wesentlichen gleichen Abständen in zwei axialen Richtungen angeordnet sind, die sich in einem Winkel von etwa 60° in der Substratoberfläche schneiden.

**17.** Verfahren zum Herstellen einer Leuchtdiode (LED), die ein Substrat umfasst, das eine Vielzahl von Vorsprüngen aufweist, Folgendes umfassend:

einen ersten Schritt des Trockenätzens eines Teils des Substrats mit einem Schutzfilm, der auf dem Substrat vorgesehen ist, und des Bildens von Vorsprüngen, welche Seitenflächen aufweisen;
einen zweiten Schritt des Trockenätzens der Seitenflächen und zumindest eines Teils der Oberseiten der Vorsprünge, die nach dem Entfernen des Schutzfilms freiliegend eingerichtet sind, um so den Neigungswinkel der Seitenfläche der Vorsprünge auf der Unterseite größer zu bilden, als den Neigungswinkel auf der oberen Stirnseite;
einen ersten Kristallzüchtungsschritt zum Aufwachsen eines ersten Halbleiterkristalls (41) von der Oberseite der Vorsprünge und das Aufwachsen eines zweiten Halbleiterkristalls (42) aus dem Bereich zwischen den Vorsprüngen, so dass das erste Halbleiterkristall (41) und das zweite Halbleiterkristall (42) in der Substratebene voneinander getrennt eingerichtet sind;
einen zweiten Kristallzüchtungsschritt zum Aufwachsen einer flachen Halbleiterschicht auf dem Substrat;
wobei die Oberseite der Vorsprünge des Substrats, gebildet in dem zweiten Schritt, einen im Wesentlichen flachen Zustand aufweist, und die Oberseite des ersten Halbleiterkristalls und des zweiten Halbleiterkristalls, gebildet in dem ersten Kristallzüchtungsschritt, einen im Wesentlichen flachen Zustand aufweist.

**18.** Verfahren zum Herstellen einer Leuchtdiode (LED) nach Anspruch 17, wobei das zweite Halbleiterkristall (42), gebildet in dem ersten Kristallzüchtungsschritt, eine solche Dicke aufweist, dass dieses die Oberseite der Vorsprünge erreicht.

**19.** Verfahren zum Herstellen einer lichtemittierenden Diode (LED) nach Anspruch 17 oder Anspruch 18, wobei dem zweiten Schritt ein dritter Schritt folgt, in dem die Seitenflächen und zumindest ein Teil der Oberseite der Vorsprünge einen geätzten Zustand aufweisen, um die Seitenflächen zu gebogenen Flächen umzubilden.

**20.** Verfahren zum Herstellen einer Leuchtdiode (LED) nach einem der Ansprüche 17 bis 19, wobei der Schutzfilm auch in dem ersten Schritt des Ätzens entfernt wird.

**21.** Verfahren zum Herstellen einer Leuchtdiode (LED) nach Anspruch 20, wobei eine Mehrzahl von Vorsprüngen gebildet ist, und wobei die Oberseiten und / oder die Unterseiten der Vorsprünge einen kreisförmigen Zustand aufweisen.

## Revendications

**1.** Diode électroluminescente (DEL) à semi-conducteurs, comprenant :

un substrat comportant des protubérances formées sur la surface de celui-ci ; et
des couches semi-conductrices réalisées en un matériau différent de celui dudit substrat et prévues sur la surface dudit substrat,
dans laquelle une face latérale desdites protubérances comprend au moins deux surfaces ayant différents angles d'inclinaison où la face latérale desdites protubérances fait saillie vers l'extérieur desdites protubérances ;
dans laquelle la face supérieure desdites protubérances est sensiblement plate ; et
dans laquelle la face latérale desdites protubérances a au moins une première surface inclinée et une deuxième surface inclinée, par rapport au fond du substrat,

**caractérisée en ce que** :

la rugosité de surface $Ra_1$ de ladite première surface inclinée est supérieure à la rugosité de surface $Ra_2$ de ladite deuxième surface inclinée.

**2.** Diode électroluminescente à semi-conducteurs selon la revendication 1, dans laquelle lesdites couches semi-conductrices sont formées à partir d'un premier cristal semi-conducteur (41) développé à partir de la face supérieure desdites protubérances et d'un deuxième cristal semi-conducteur (42) développé à partir de la région entre lesdites protubérances.

3. Diode électroluminescente à semi-conducteurs selon l'une quelconque des revendications 1 ou 2, dans laquelle la face latérale desdites protubérances a au moins une première surface inclinée et une deuxième surface inclinée, par rapport au fond du substrat, l'angle d'inclinaison $\theta_1$ de ladite première surface inclinée étant supérieur à l'angle d'inclinaison $\theta_2$ de ladite deuxième surface inclinée.

4. Diode électroluminescente à semi-conducteurs selon l'une quelconque des revendications 1 à 3, dans laquelle lesdites protubérances ont une forme polygonale qui est constituée à partir de segments de droite qui croisent un plan qui est sensiblement parallèle à un plan de croissance stable de ladite couche semi-conductrice, en vue plane.

5. Diode électroluminescente à semi-conducteurs selon l'une quelconque des revendications 1 à 4, dans laquelle lesdites protubérances sont formées en un motif répétitif.

6. Diode électroluminescente à semi-conducteurs selon l'une quelconque des revendications 1 à 5, dans laquelle ledit substrat est réalisé en un matériau sélectionné dans les groupes consistant en le saphir, le Si, le SiC et le spinelle.

7. Diode électroluminescente à semi-conducteurs selon l'une quelconque des revendications 1 à 6, dans laquelle ledit substrat est un substrat en saphir ayant un plan C (0001).

8. Diode électroluminescente à semi-conducteurs selon l'une quelconque des revendications 1 à 7, dans laquelle lesdites protubérances ont un profil en vue plane circulaire, triangulaire, de parallélogramme ou hexagonal.

9. Diode électroluminescente à semi-conducteurs selon la revendication 2, dans laquelle l'angle d'inclinaison $\theta_1$ de ladite première surface inclinée est supérieur à 45° et inférieur à 90°.

10. Diode électroluminescente à semi-conducteurs selon l'une quelconque des revendications 1 à 9, dans laquelle la face latérale desdites protubérances a une surface incurvée.

11. Diode électroluminescente à semi-conducteurs selon la revendication 10, dans laquelle la face latérale desdites protubérances a un angle d'inclinaison $Ra_b$ du côté de fond supérieur à un angle d'inclinaison $Ra_u$ du côté de face supérieure.

12. Diode électroluminescente à semi-conducteurs selon l'une quelconque des revendications 1 à 11, dans laquelle la face latérale desdites protubérances comporte des encoches et une largeur desdites encoches est plus grande du côté de fond que du côté de face supérieure et/ou le nombre desdites encoches est plus grand du côté de fond que du côté de face supérieure.

13. Diode électroluminescente à semi-conducteurs selon la revendication 1, dans laquelle les protubérances sont séparées les unes des autres et disposées périodiquement, dans laquelle la largeur de la section transversale desdites protubérances est plus grande du côté de fond que du côté de face supérieure, et l'angle d'inclinaison de la face latérale desdites protubérances est plus petit du côté de face supérieure que du côté de fond ; et
dans laquelle, avec un cercle qui est, dans le plan de surface de substrat, circonscrit par les faces latérales de deux protubérances les plus proches, appelé premier cercle, un cercle qui est, dans le plan de surface de substrat, circonscrit par les faces latérales d'au moins trois protubérances, appelé deuxième cercle, et un cercle qui est, dans un plan comprenant la surface supérieure desdites protubérances, circonscrit par les faces latérales de deux protubérances les plus proches, appelé troisième cercle, le diamètre dudit deuxième cercle est supérieur au diamètre dudit premier cercle et inférieur au diamètre dudit troisième cercle.

14. Diode électroluminescente à semi-conducteurs selon la revendication 13, dans laquelle ledit troisième cercle et ledit deuxième cercle se superposent mutuellement.

15. Diode électroluminescente à semi-conducteurs selon la revendication 13 ou 14, dans laquelle la face latérale desdites protubérances a une surface incurvée qui est convexe vers l'extérieur.

16. Diode électroluminescente à semi-conducteurs selon l'une quelconque des revendications 13 à 15, dans laquelle le fond desdites protubérances est circulaire, et lesdites protubérances sont disposées périodiquement sensiblement aux mêmes intervalles dans deux directions axiales qui se croisent avec un angle d'environ 60° dans la surface de substrat.

17. Procédé de fabrication d'une diode électroluminescente (DEL) avec un substrat qui comporte une pluralité de protubérances, comprenant :

une première étape de gravure à sec d'une partie du substrat avec un film de protection prévu sur le substrat et de formation de protubérances ayant des faces latérales ;
une deuxième étape de gravure à sec des faces latérales et d'au moins une partie des faces supérieures desdites protubérances qui sont exposées après le retrait du film de protection, de manière à rendre l'angle d'inclinaison de la face latérale desdites protubérances du côté de fond supérieur à l'angle d'inclinaison du côté de face supérieure ;
une première étape de développement de cristal pour développer un premier cristal semi-conducteur (41) à partir de la face supérieure desdites protubérances et pour développer un deuxième cristal semi-conducteur (42) à partir de la région entre lesdites protubérances, de sorte que ledit premier cristal semi-conducteur (41) et ledit deuxième cristal semi-conducteur (42) soient séparés l'un de l'autre dans ledit plan de substrat ;
une deuxième étape de développement de cristal pour développer une couche semi-conductrice plate sur ledit substrat ;
dans lequel la face supérieure desdites protubérances dudit substrat formées à la deuxième étape est sensiblement plate, et la face supérieure dudit premier cristal semi-conducteur et dudit deuxième cristal semi-conducteur formés à la première étape de développement de cristal est sensiblement plate.

**18.** Procédé de fabrication d'une diode électroluminescente (DEL) selon la revendication 17, dans lequel ledit deuxième cristal semi-conducteur (42) formé à la première étape de développement de cristal a une épaisseur telle qu'il atteint la face supérieure desdites protubérances.

**19.** Procédé de fabrication d'une diode électroluminescente (DEL) selon la revendication 17 ou 18, dans lequel ladite deuxième étape est suivie d'une troisième étape où les faces latérales et au moins une partie des faces supérieures desdites protubérances sont gravées, de manière à transformer les faces latérales en surfaces incurvées.

**20.** Procédé de fabrication d'une diode électroluminescente (DEL) selon l'une quelconque des revendications 17 à 19, dans lequel le film de protection est également retiré à ladite première étape de gravure.

**21.** Procédé de fabrication d'une diode électroluminescente (DEL) selon la revendication 20, dans lequel lesdites protubérances sont prévues en une pluralité, et les faces supérieure et/ou inférieure desdites protubérances sont circulaires.

*Fig. 1*

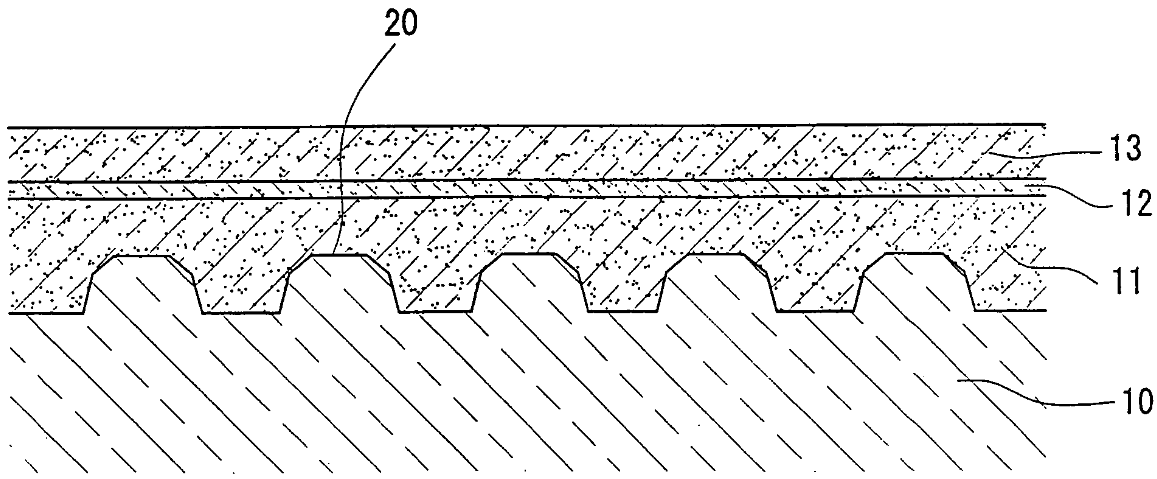

Fig. 2A

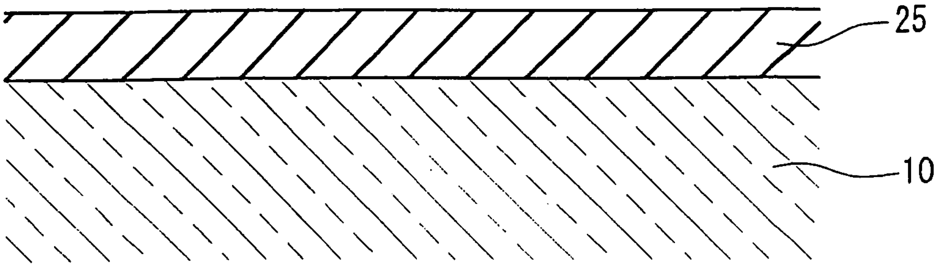


Fig. 2B

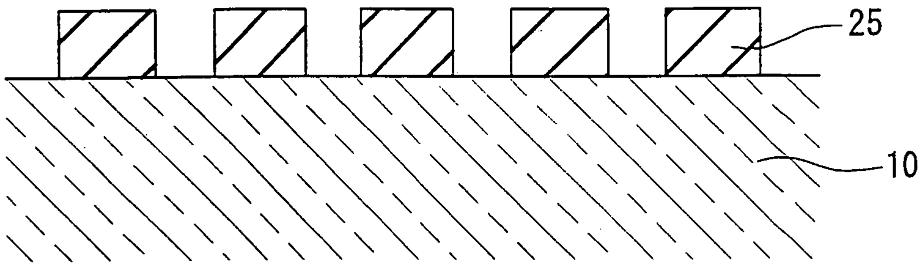


Fig. 2C

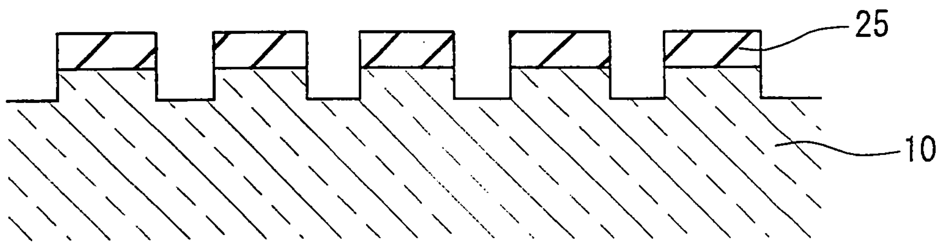


Fig. 2D

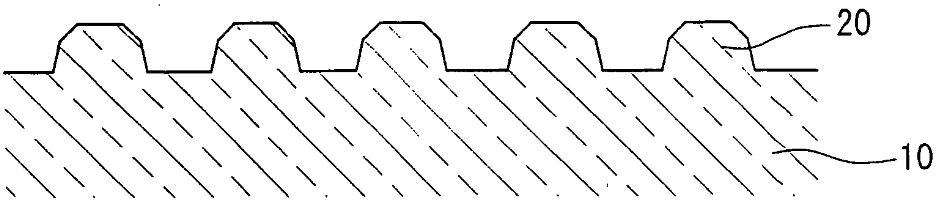


Fig. 2E

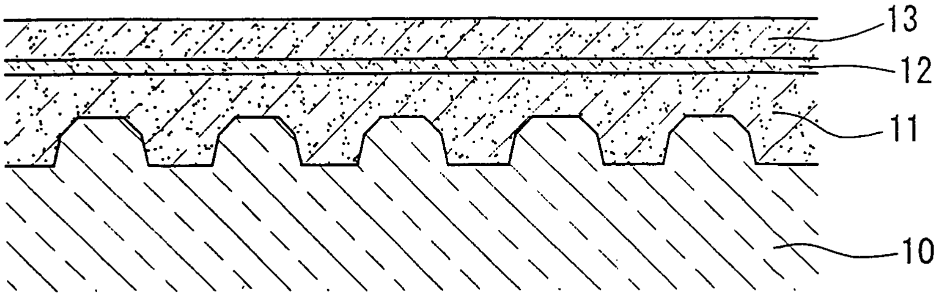

Fig.3A

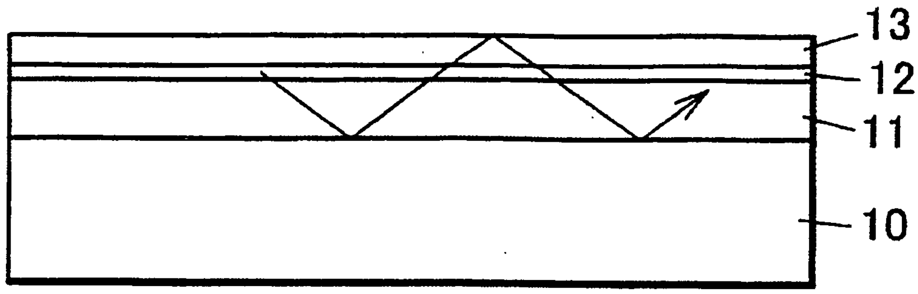


Fig.3B

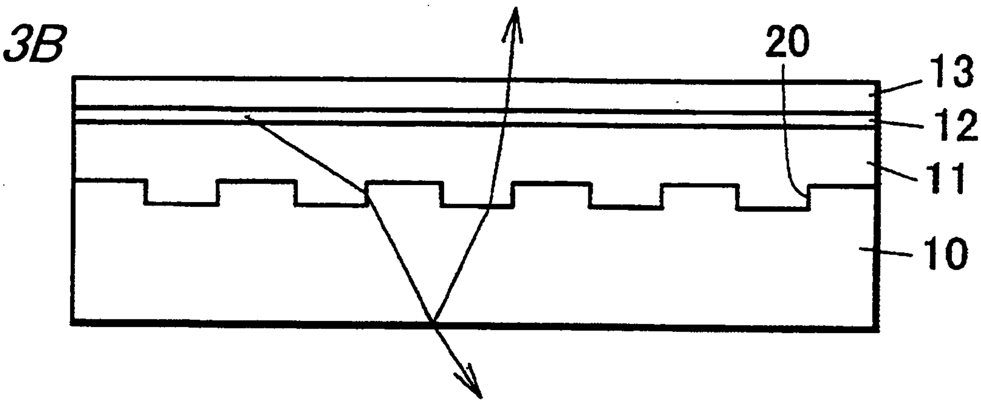


Fig.3C

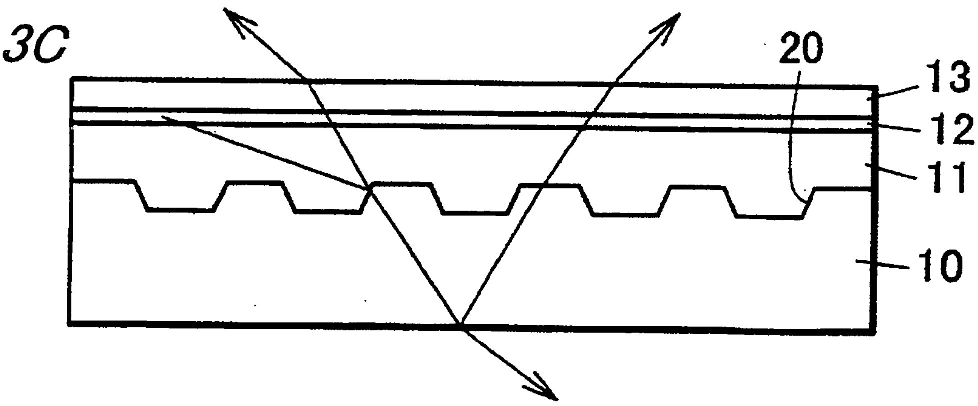


Fig.3D

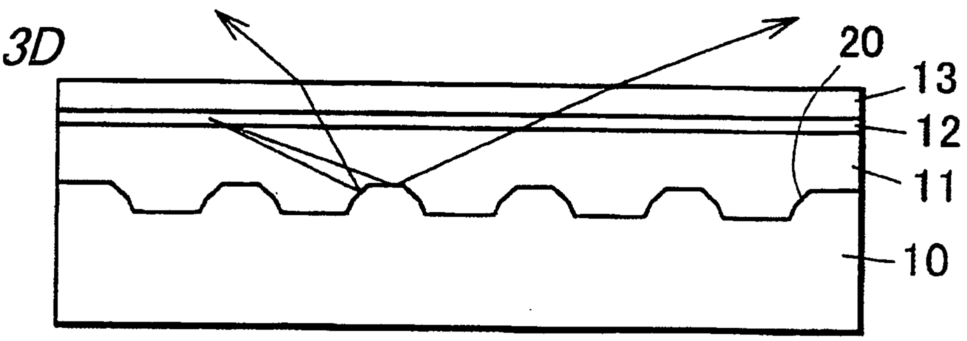

Fig. 4A

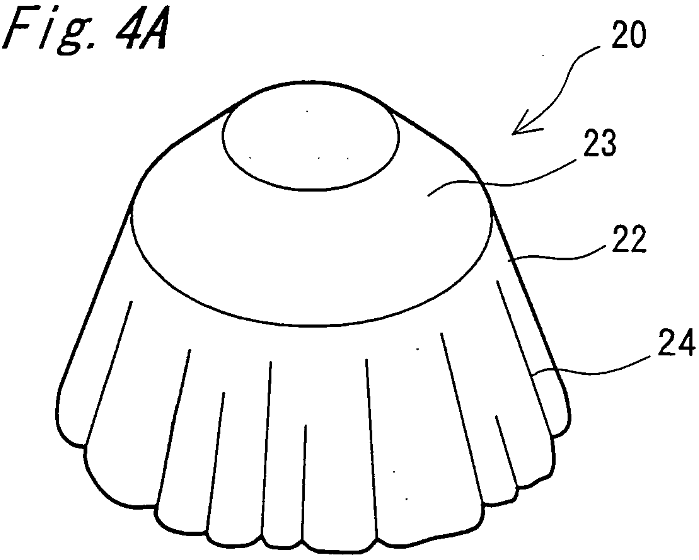


Fig. 4B

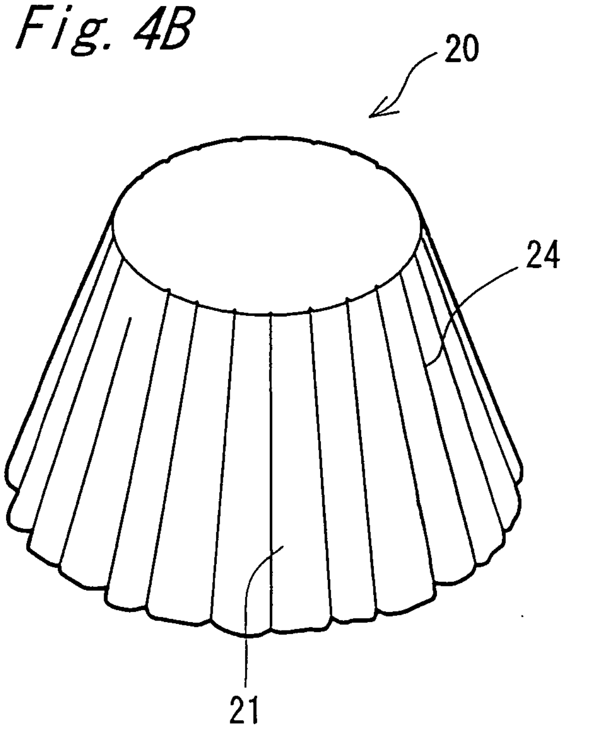


Fig. 4C

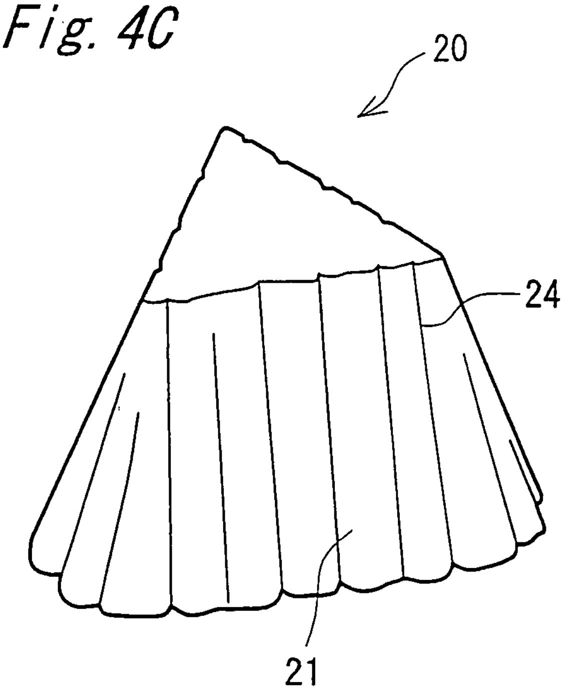

Fig. 5A

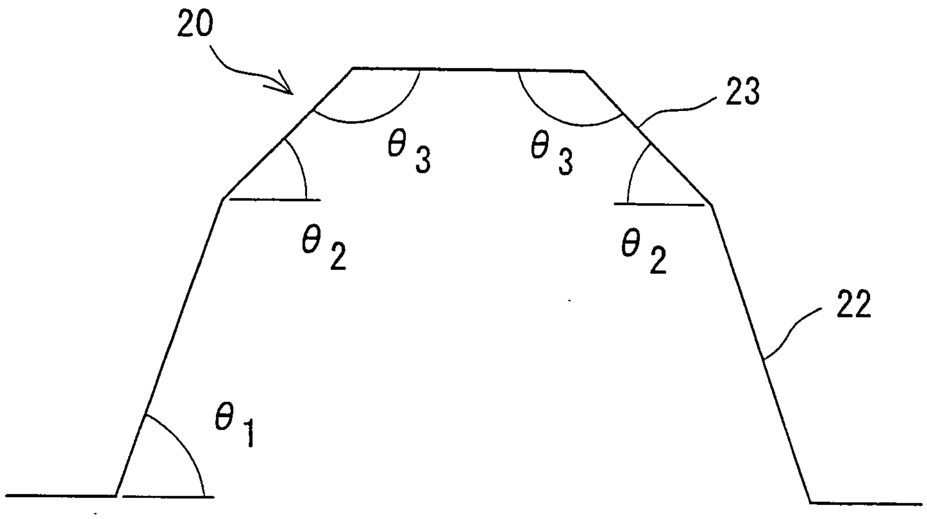


Fig. 5B

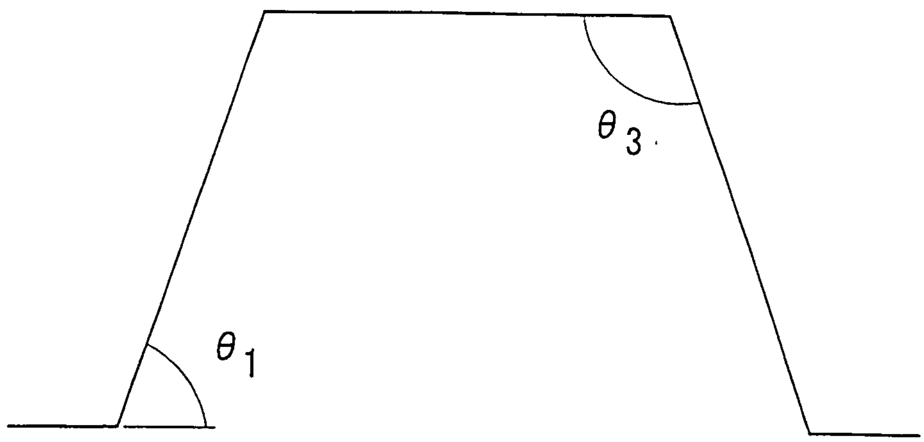

*Fig. 6*

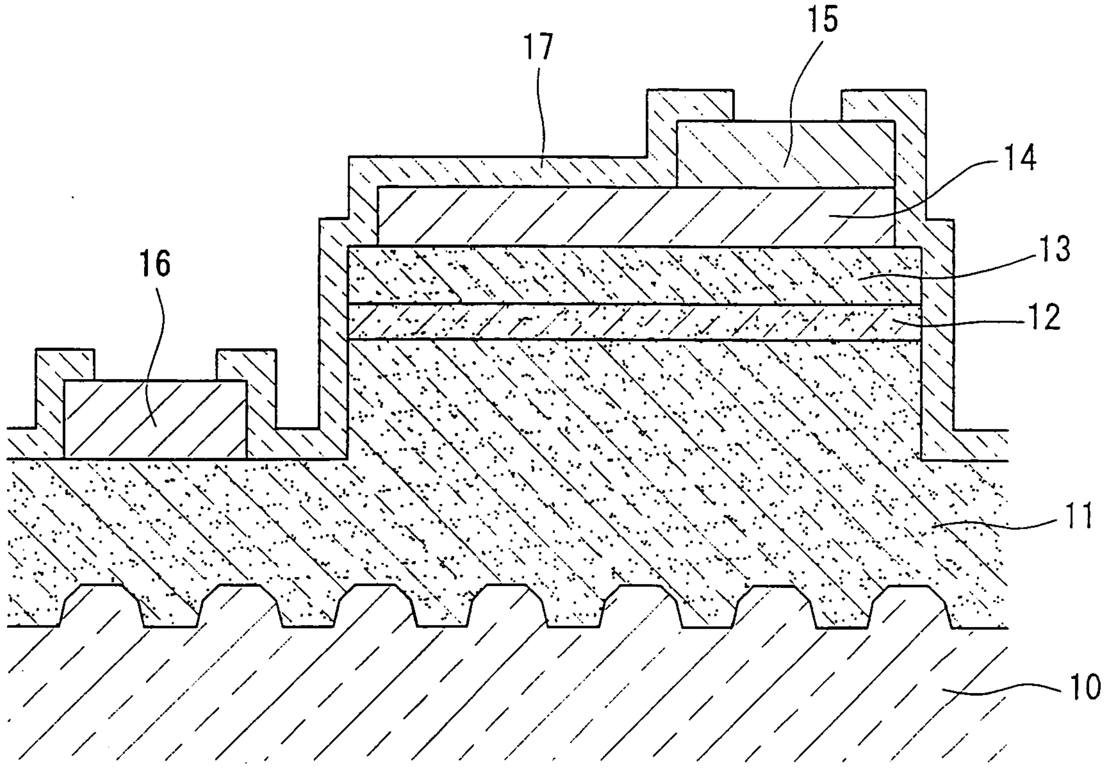

Fig. 7A

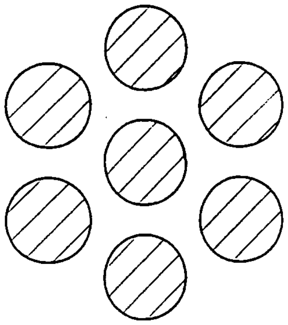

Fig. 7E

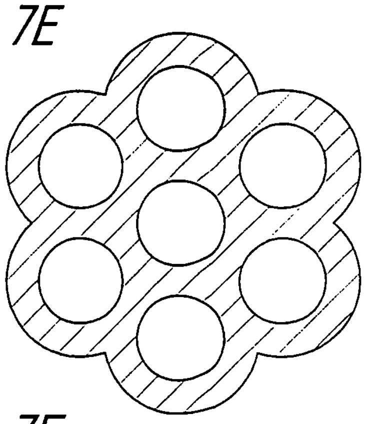

Fig. 7B

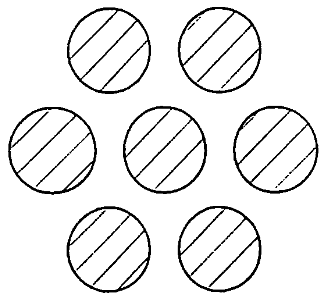

Fig. 7F

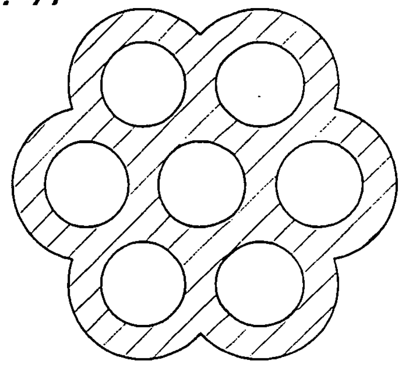

Fig. 7C

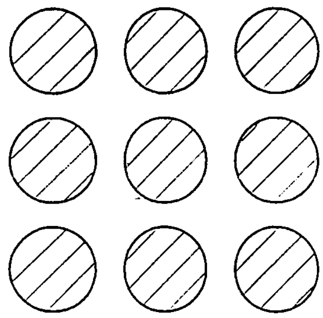

Fig. 7G

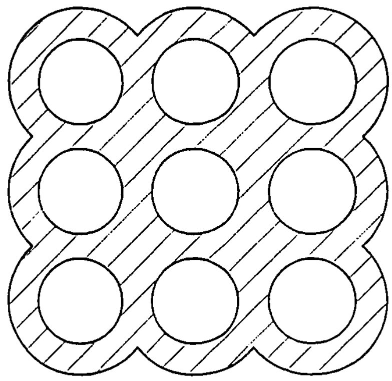

Fig. 7D

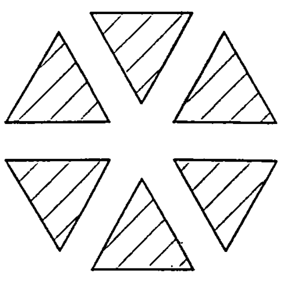

Fig. 7H

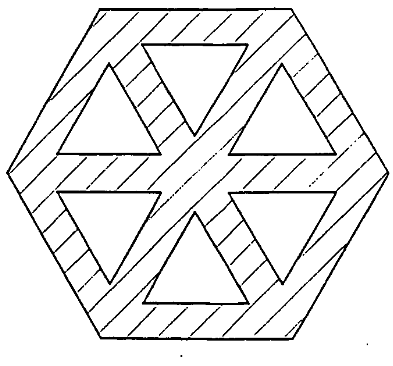

Fig.8A

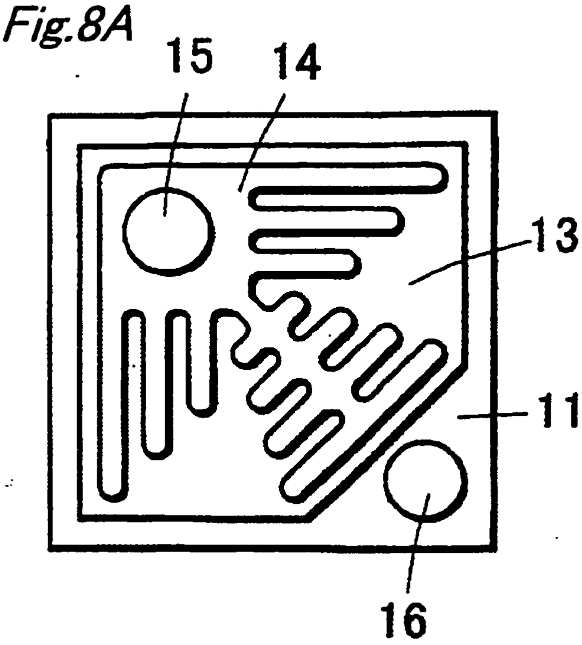


Fig.8B

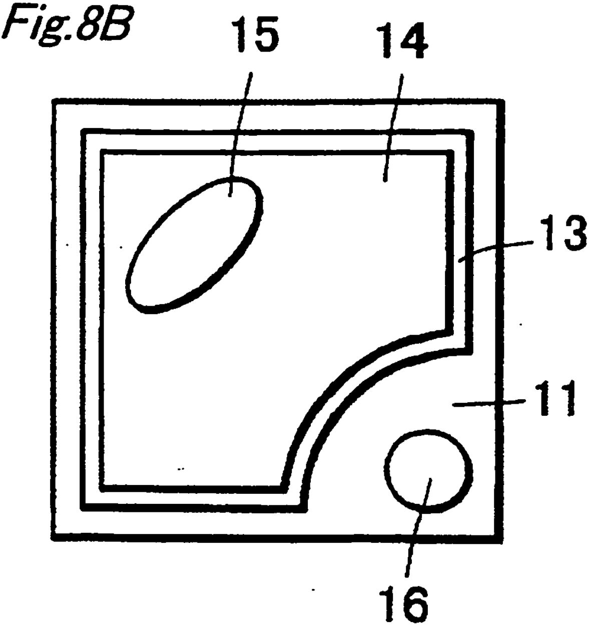


Fig.8C

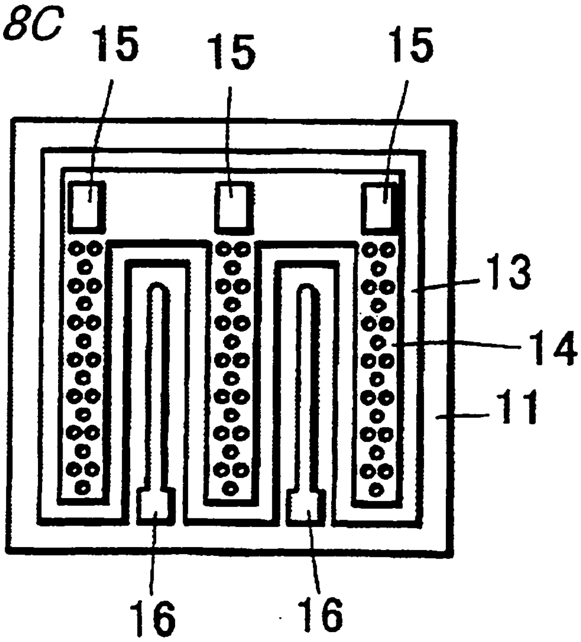

Fig.9A

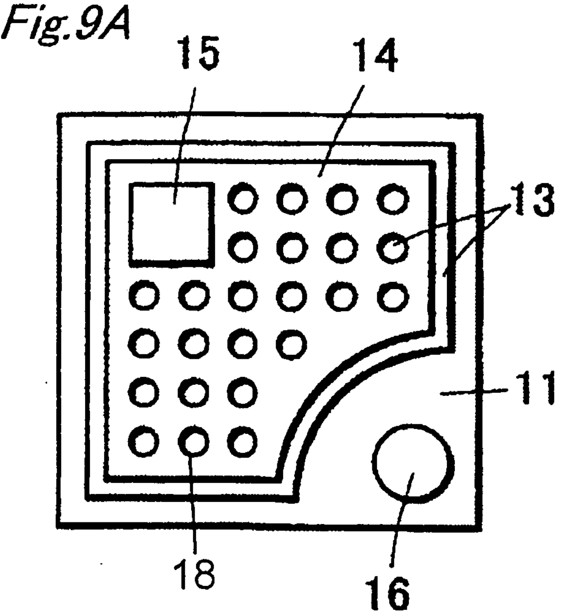


Fig.9B

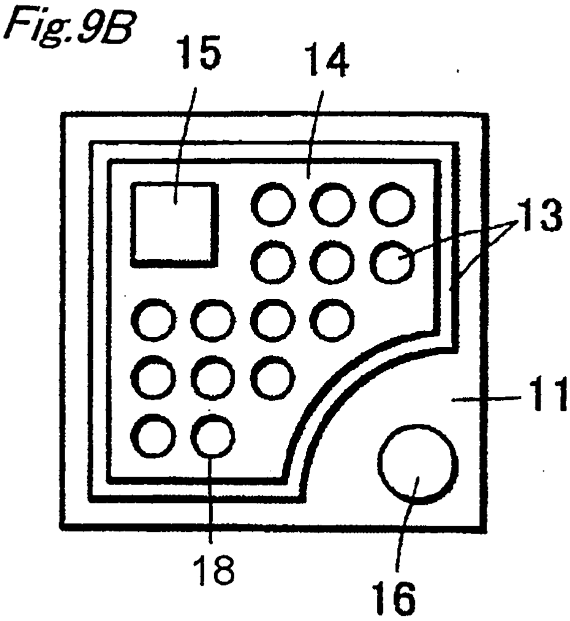


Fig.9C

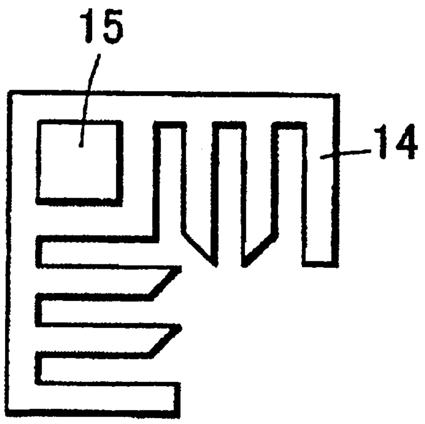


Fig.9D

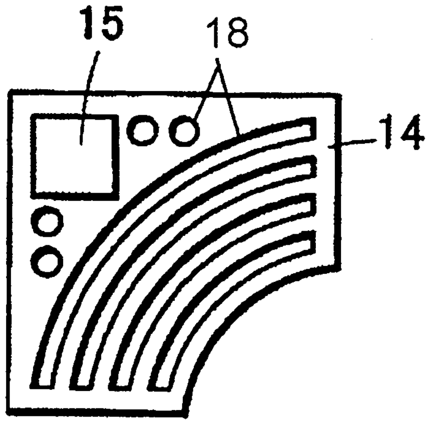

Fig. 10A

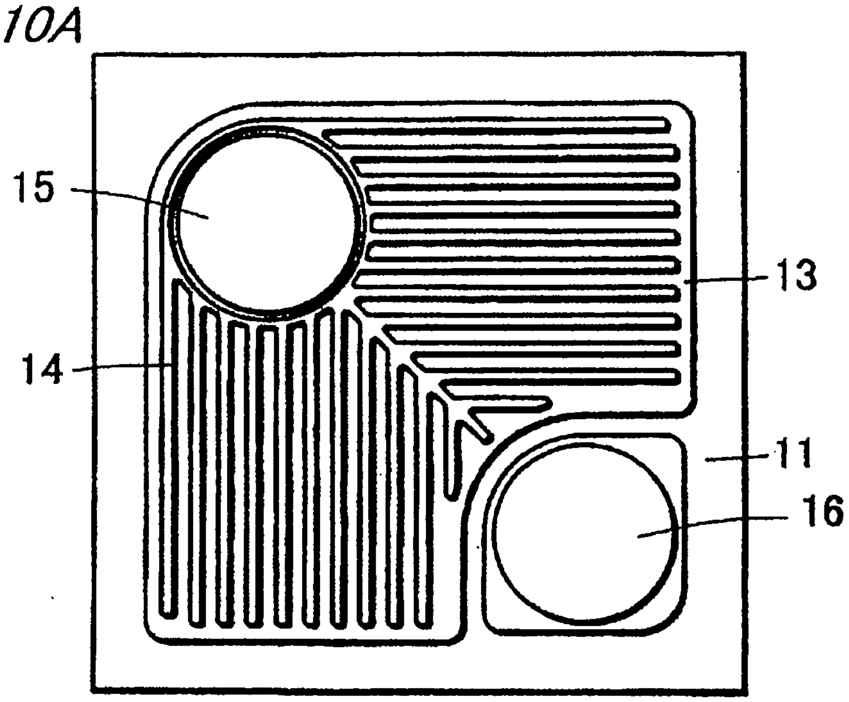


Fig. 10B

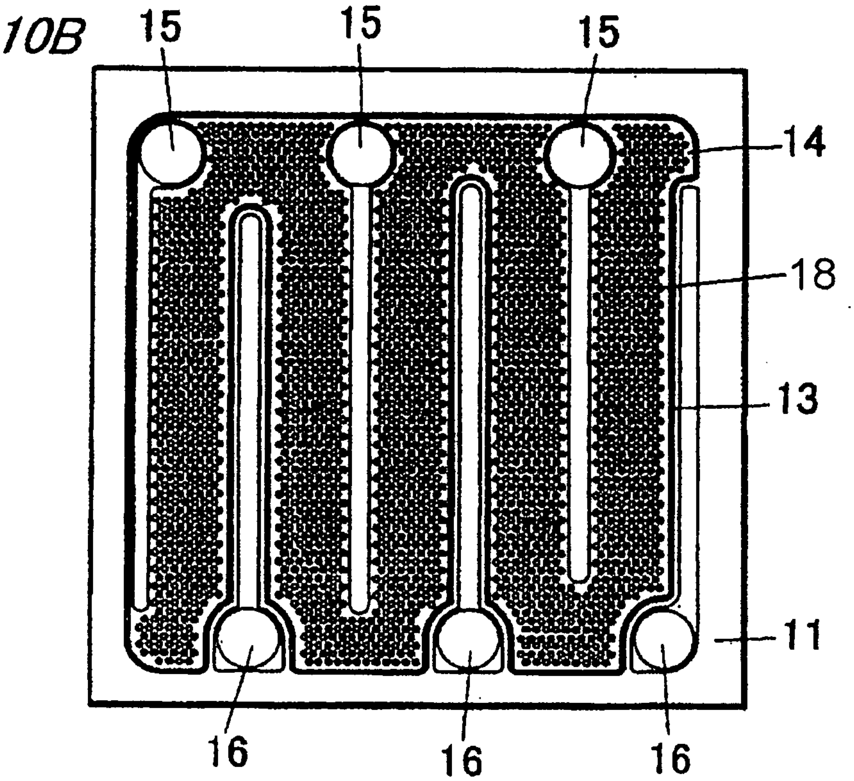

Fig. 11A

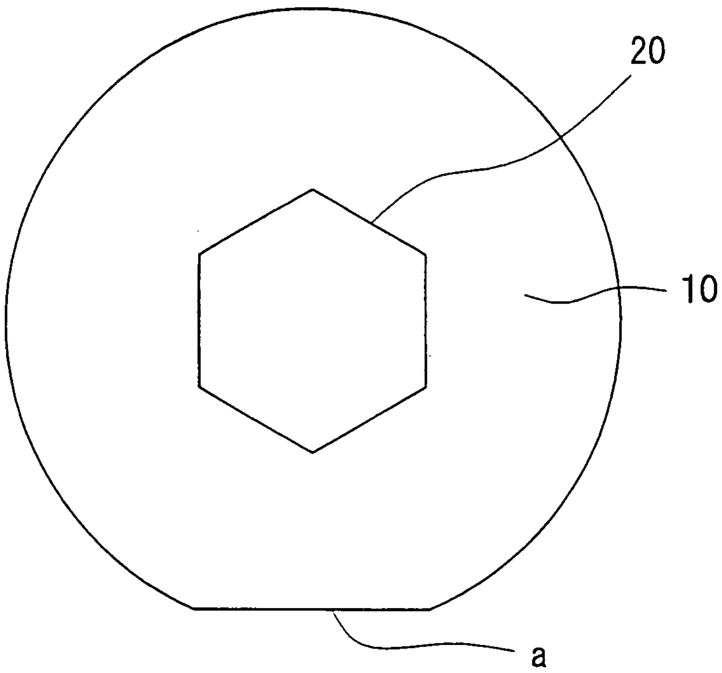


Fig. 11B

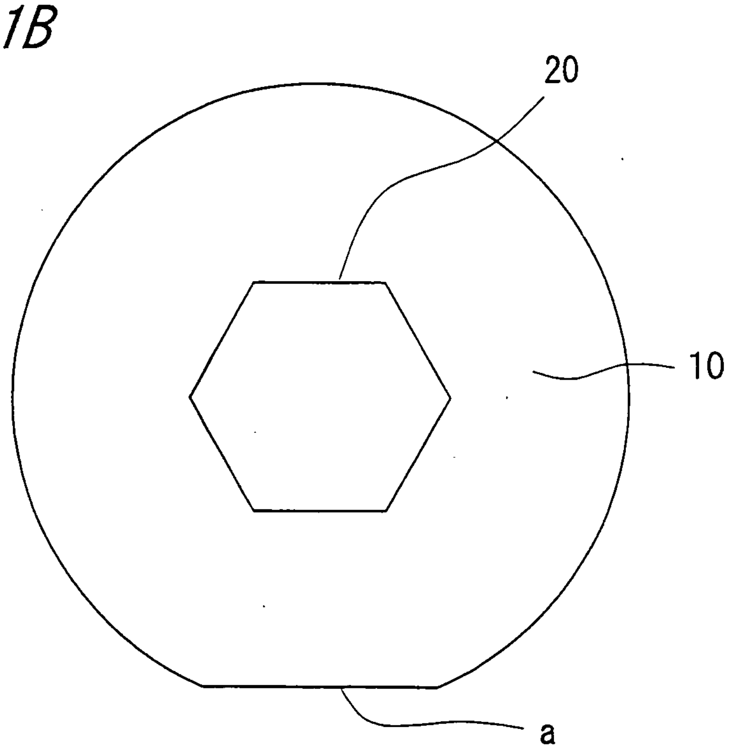

*Fig.12*

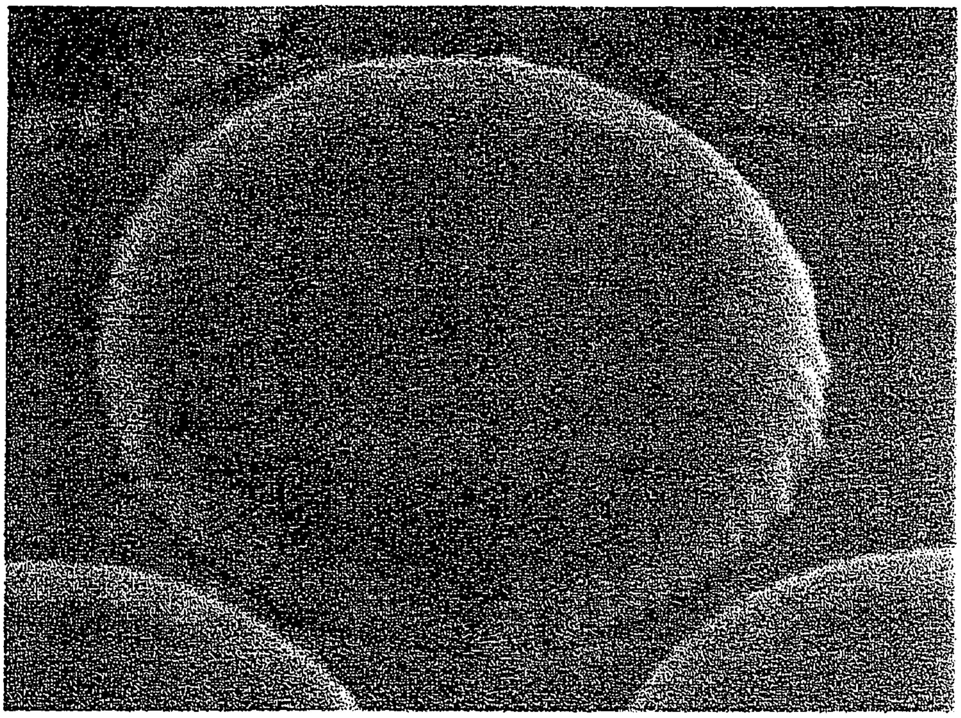

*Fig.13*

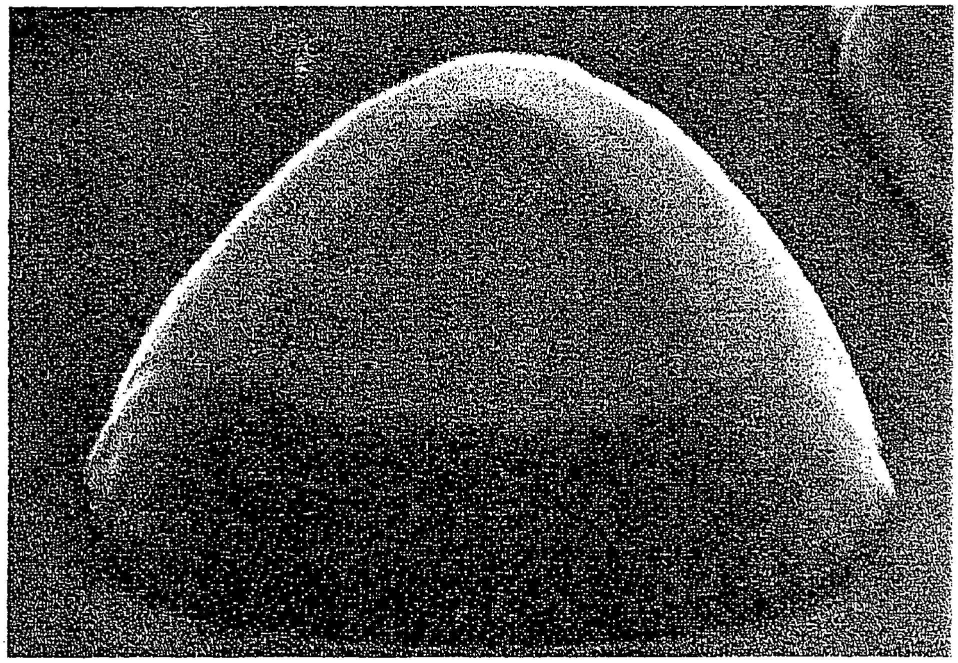

Fig.14

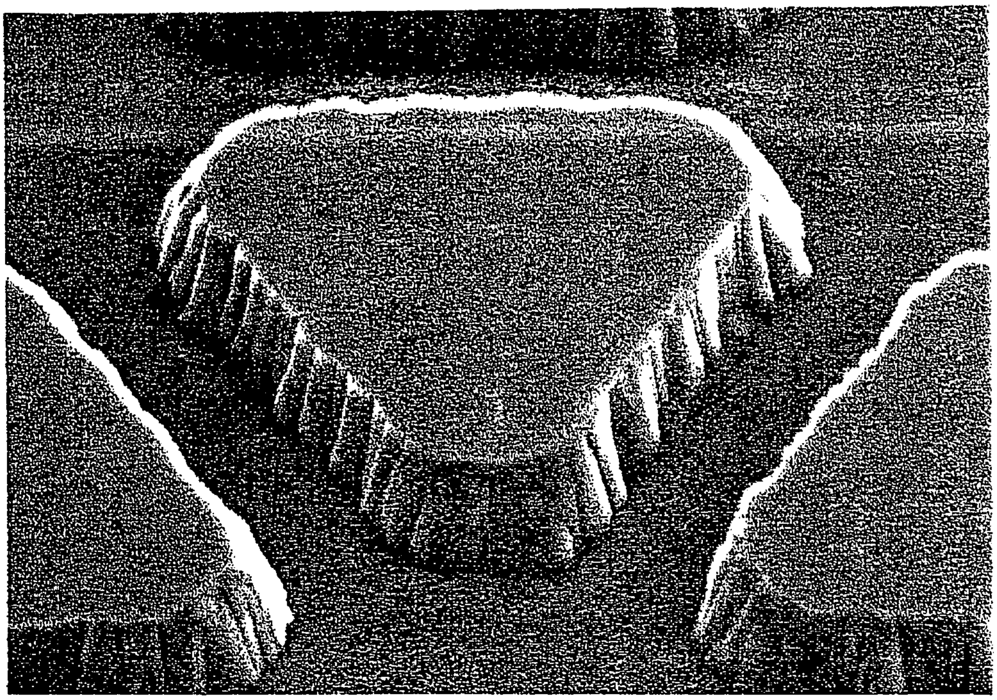

Fig. 15

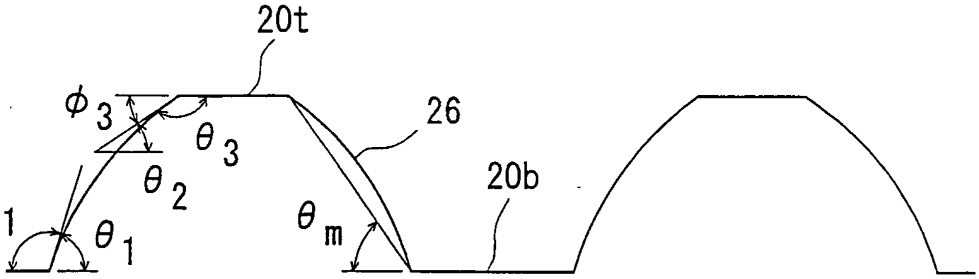


Fig. 16A

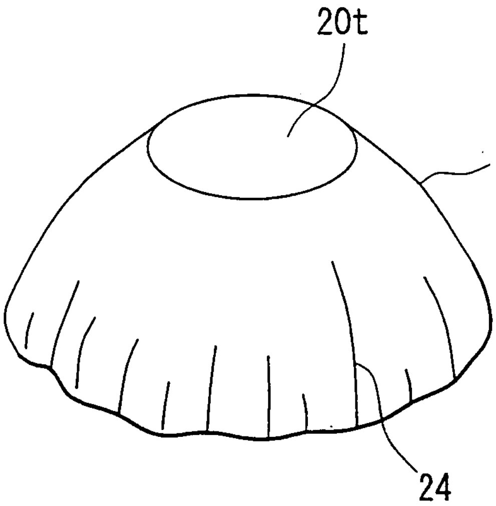


Fig. 16B

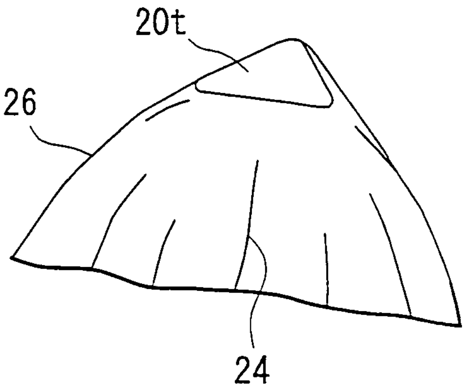

*Fig. 17A*

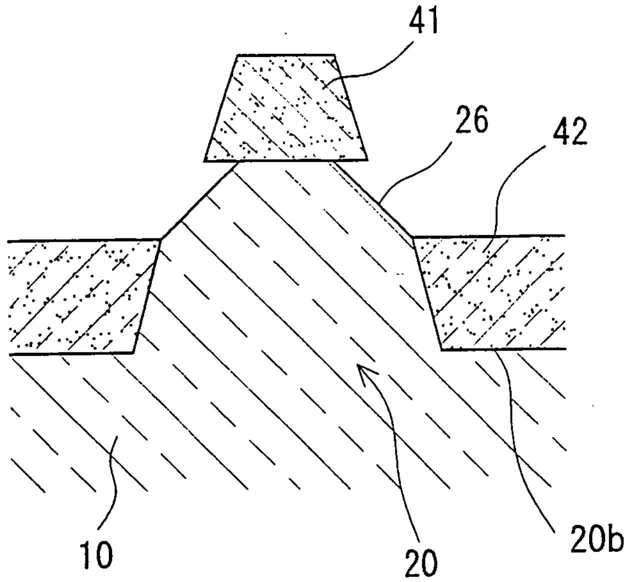


*Fig. 17B*

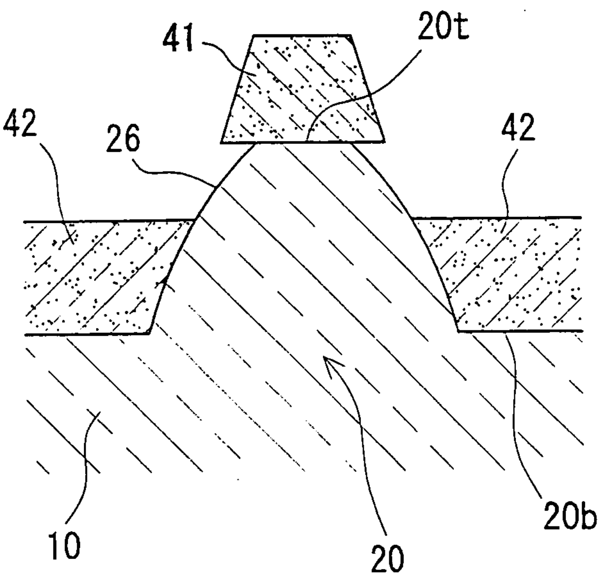

Fig. 18A

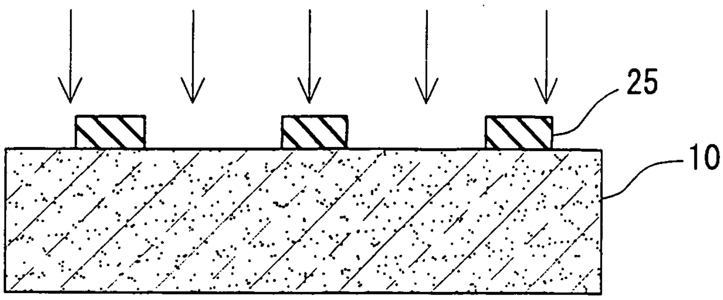


Fig. 18B

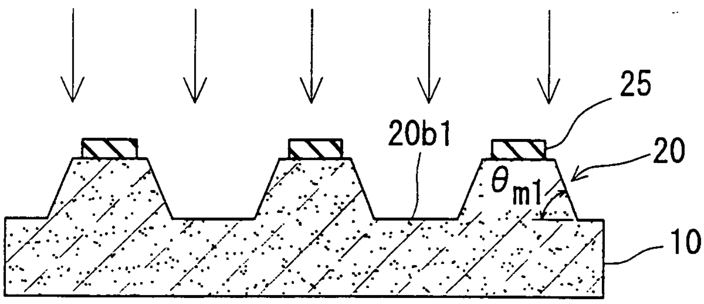


Fig. 18C

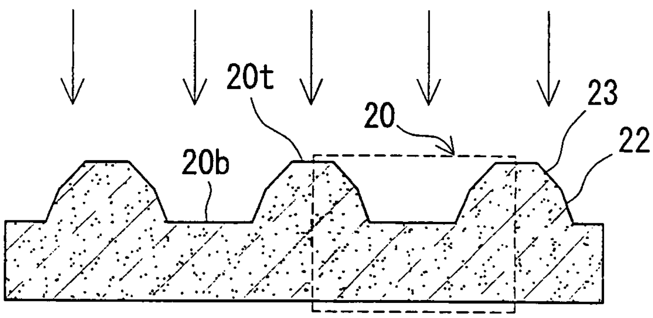


Fig. 18D

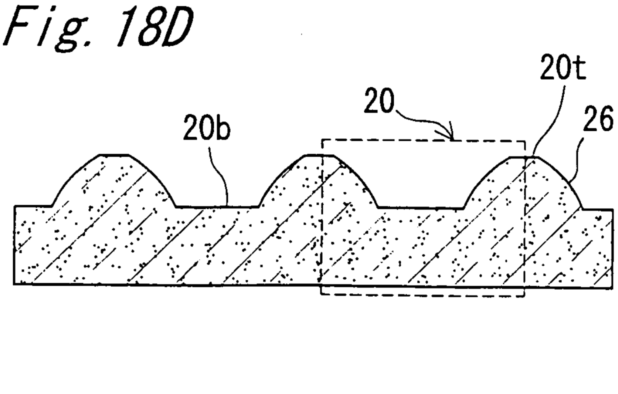


Fig. 18E

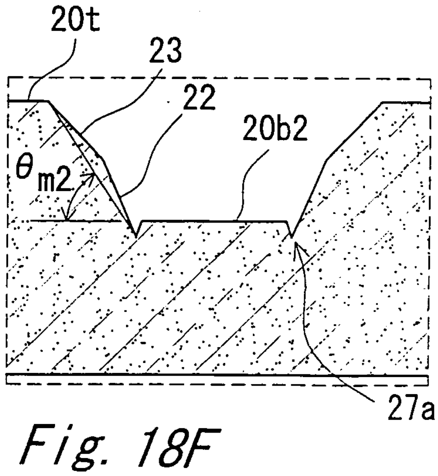


Fig. 18F

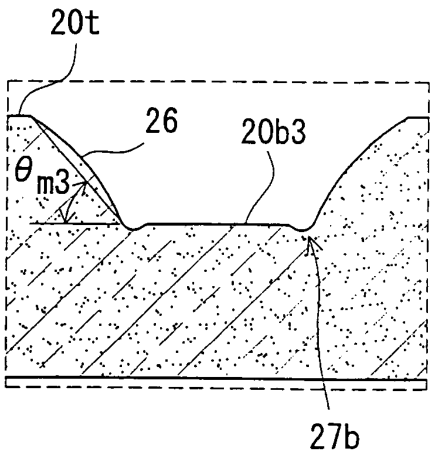

Fig. 19A

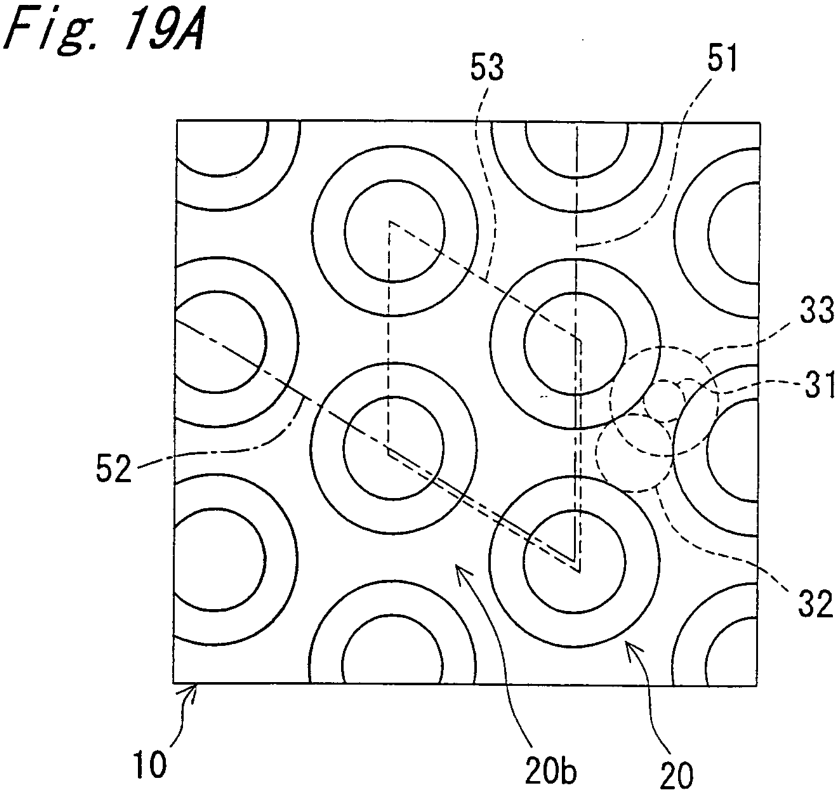


Fig. 19B

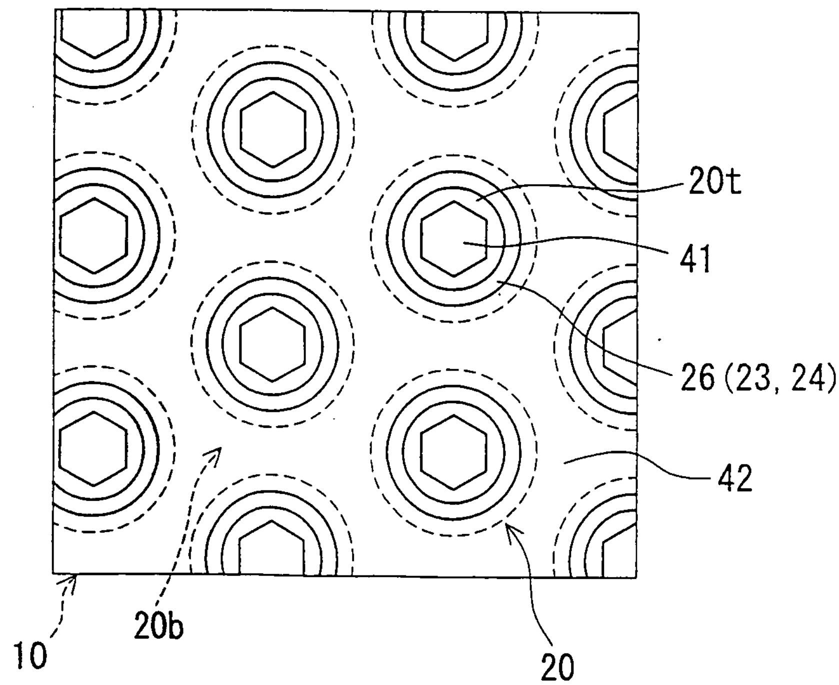

Fig. 19C

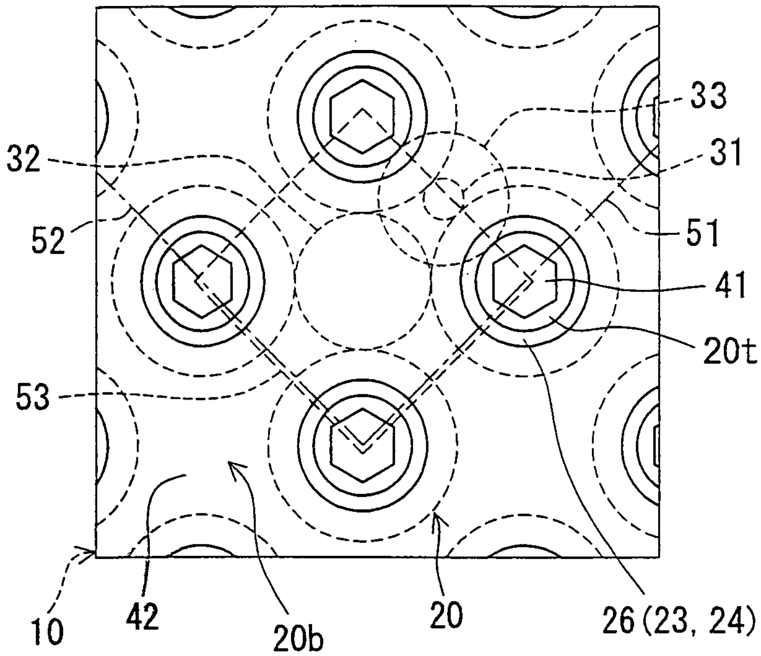


Fig. 19D

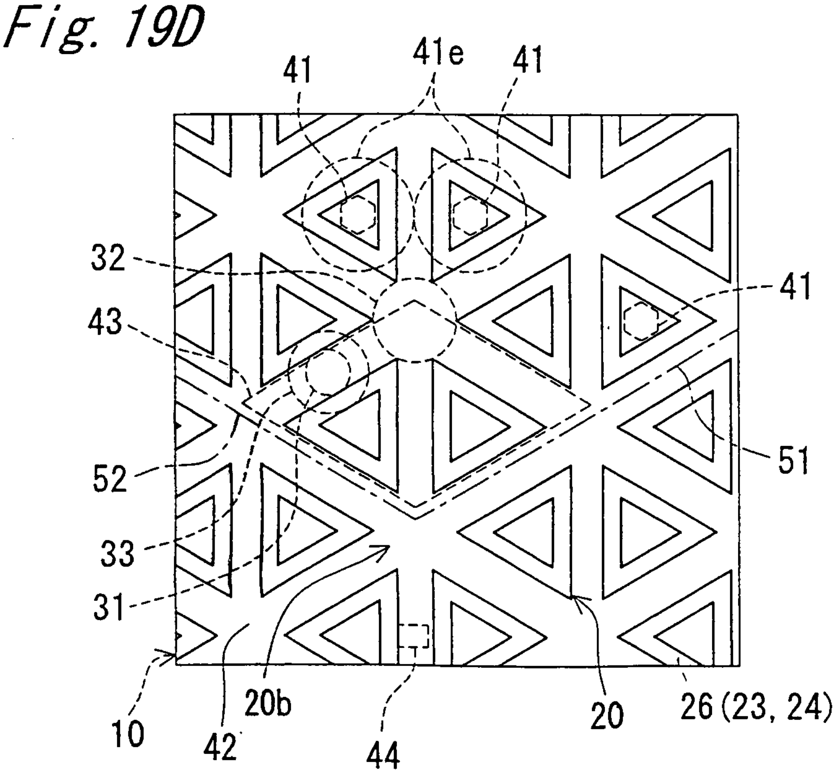

Fig. 20

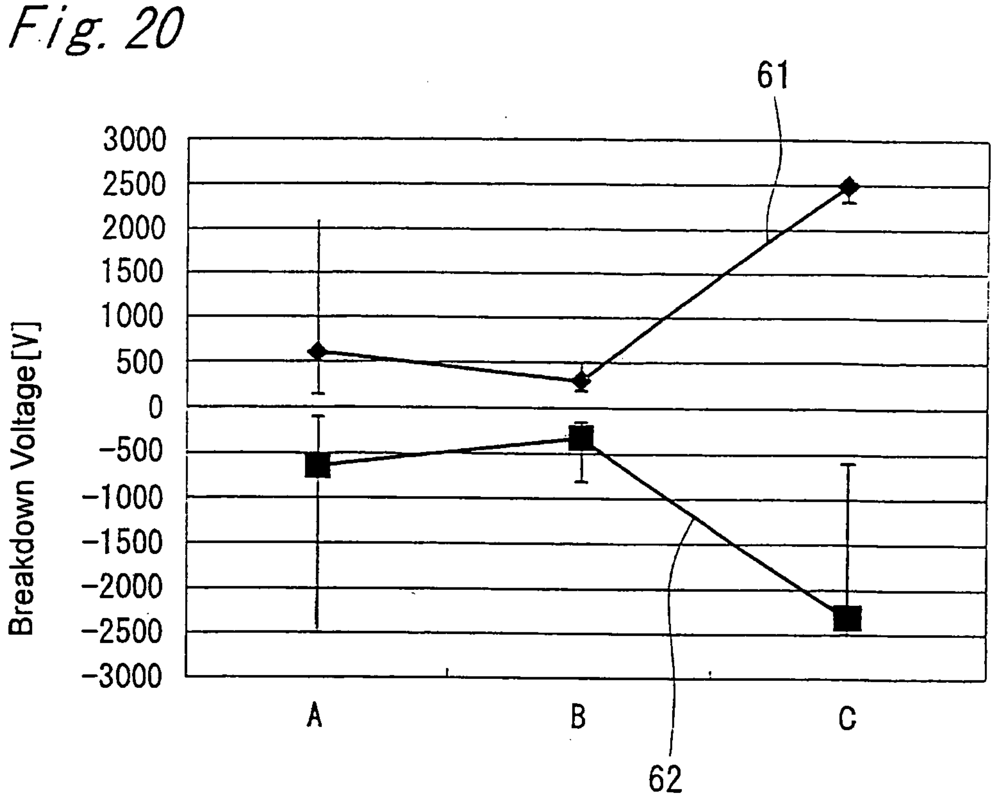
61
3000
2500
2000
1500
1000
500
0
-500
-1000
-1500
-2000
-2500
-3000
Breakdown Voltage [V]
A
B
C
62

Fig. 21

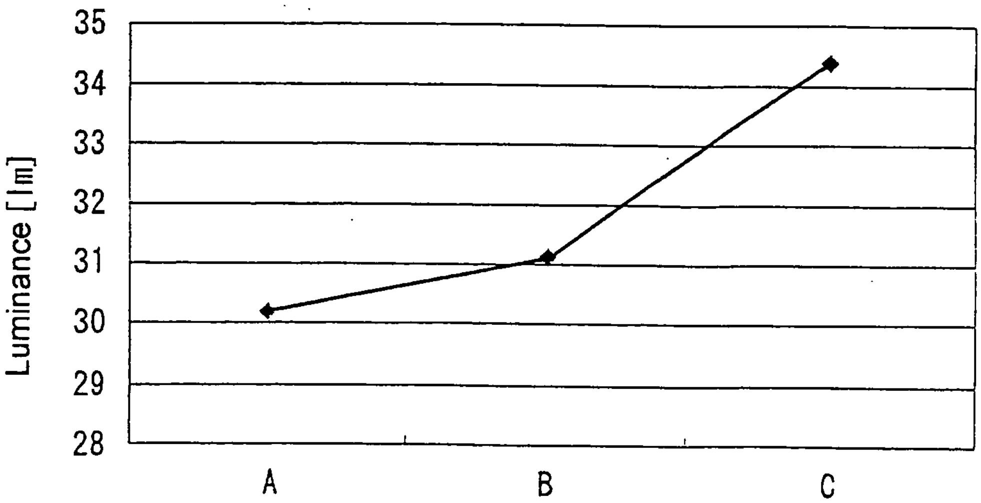
35
34
33
32
31
30
29
28
Luminance [lm]
A
B
C

Fig. 22A

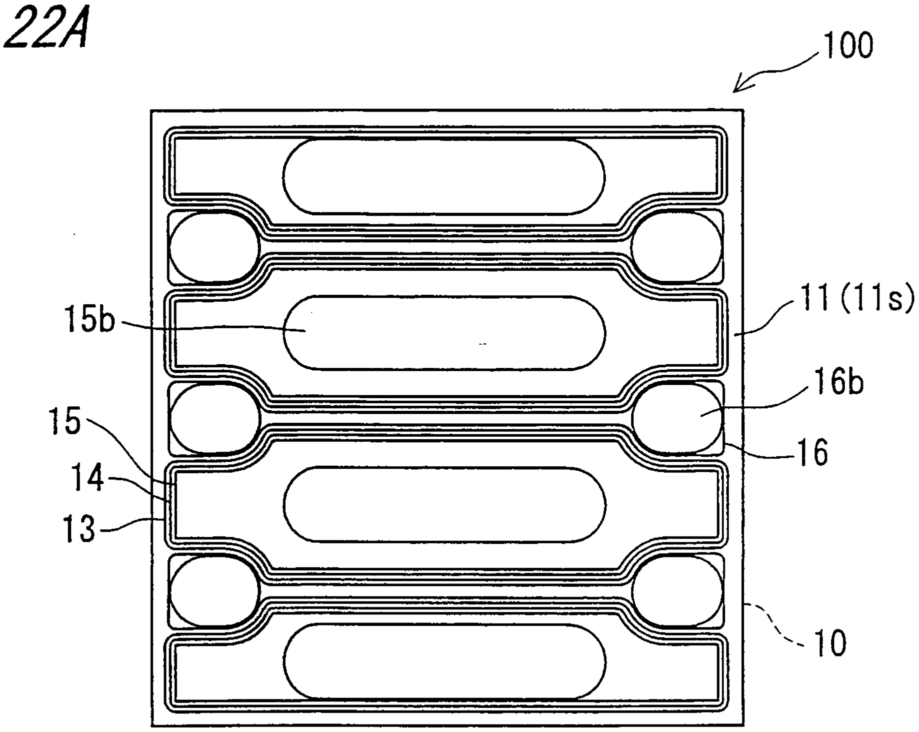


Fig. 22B

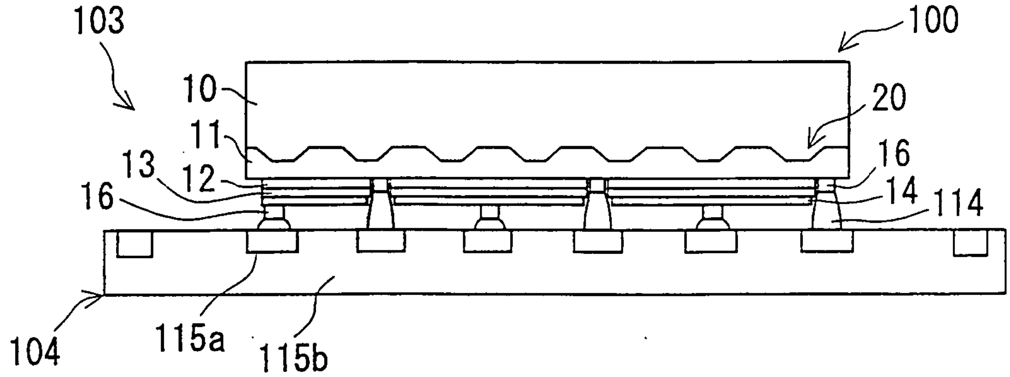


Fig. 22C

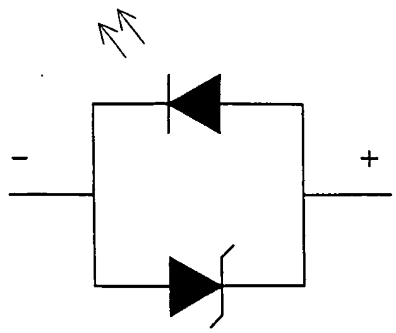

Fig. 23

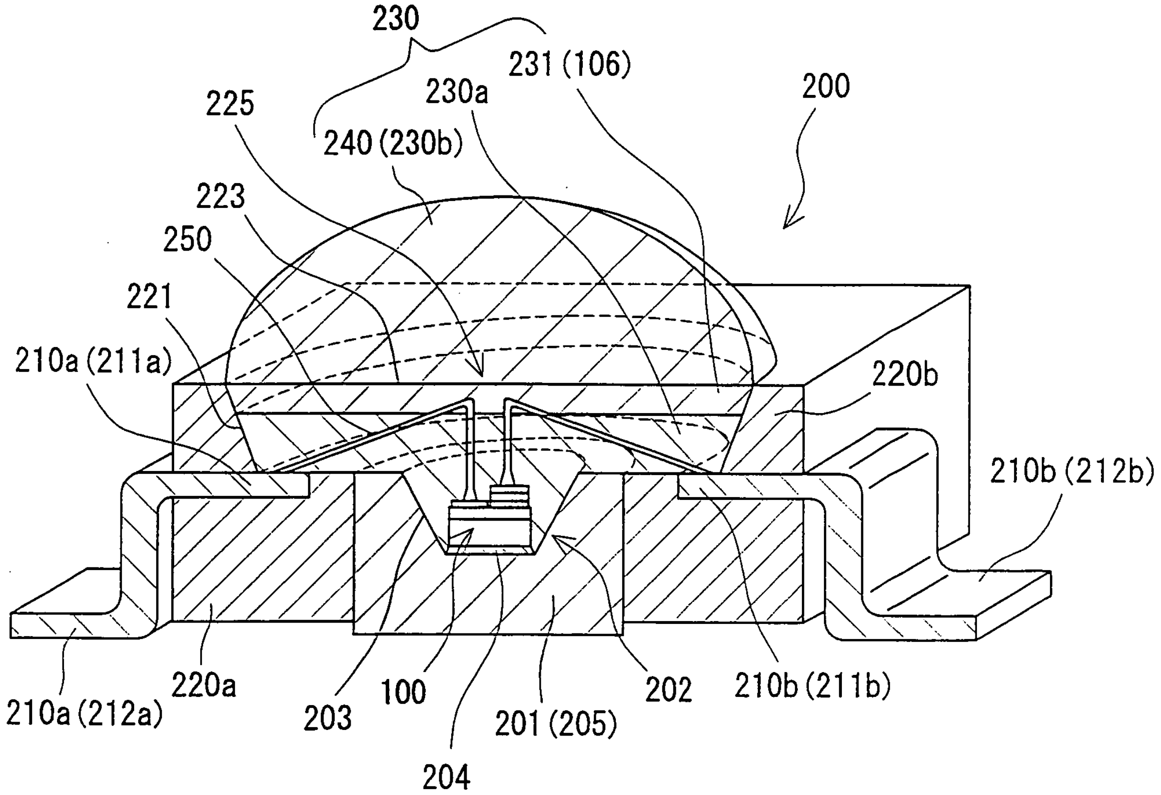
230
231 (106)
230a
225
200
240 (230b)
223
250
221
210a (211a)
220b
210b (212b)
220a
210a (212a)
203
100
201 (205)
202
210b (211b)
204

Fig. 24

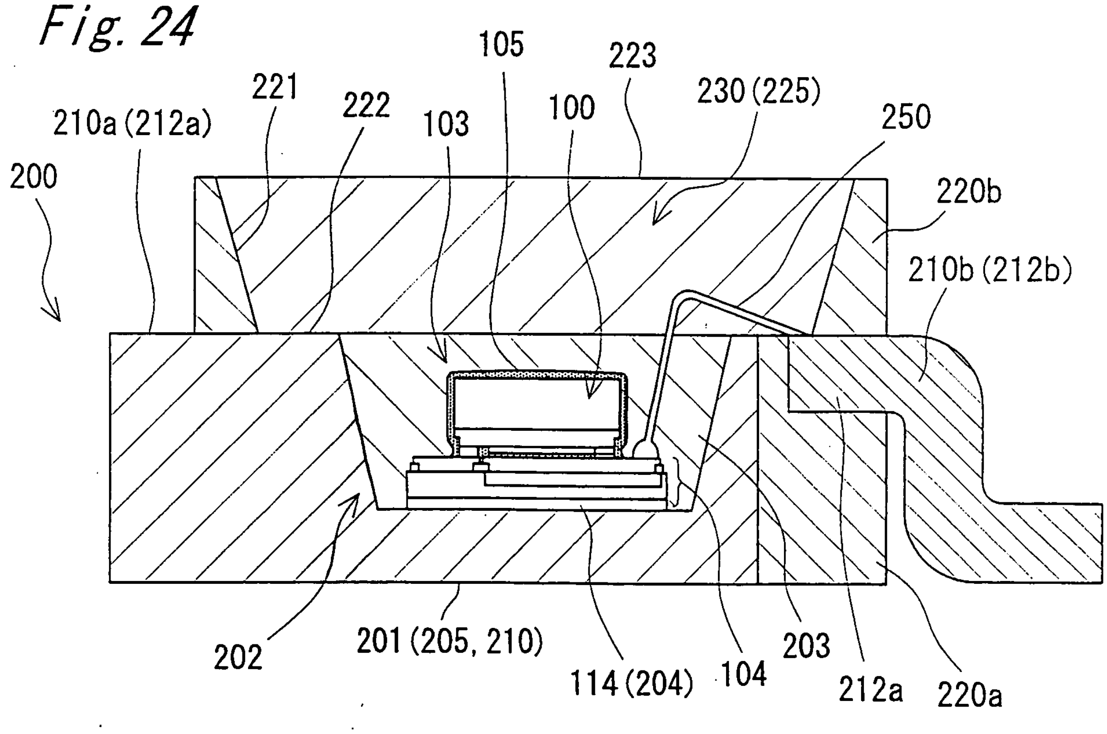
105
223
221
222
103
100
230 (225)
250
210a (212a)
200
220b
210b (212b)
202
201 (205, 210)
114 (204)
104
203
212a
220a

*Fig. 25A*

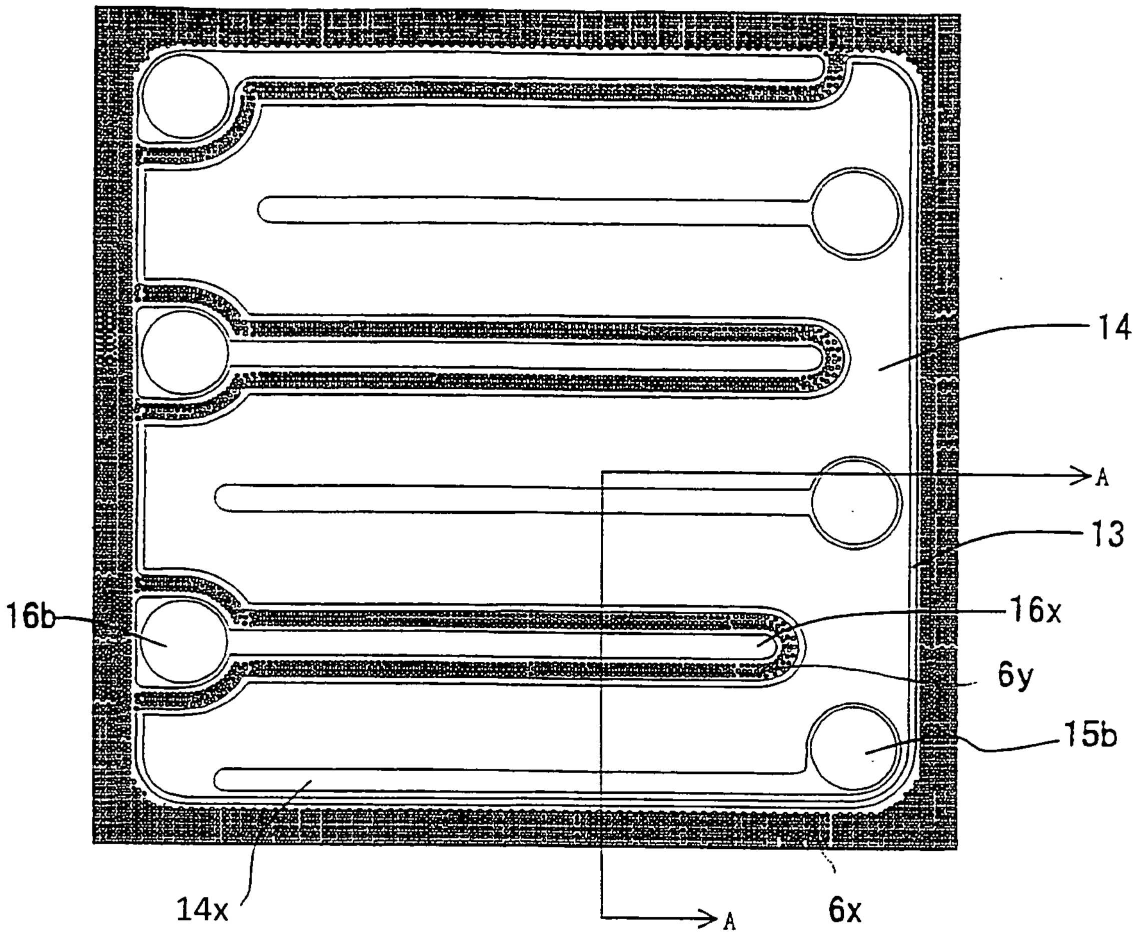

Fig. 25B

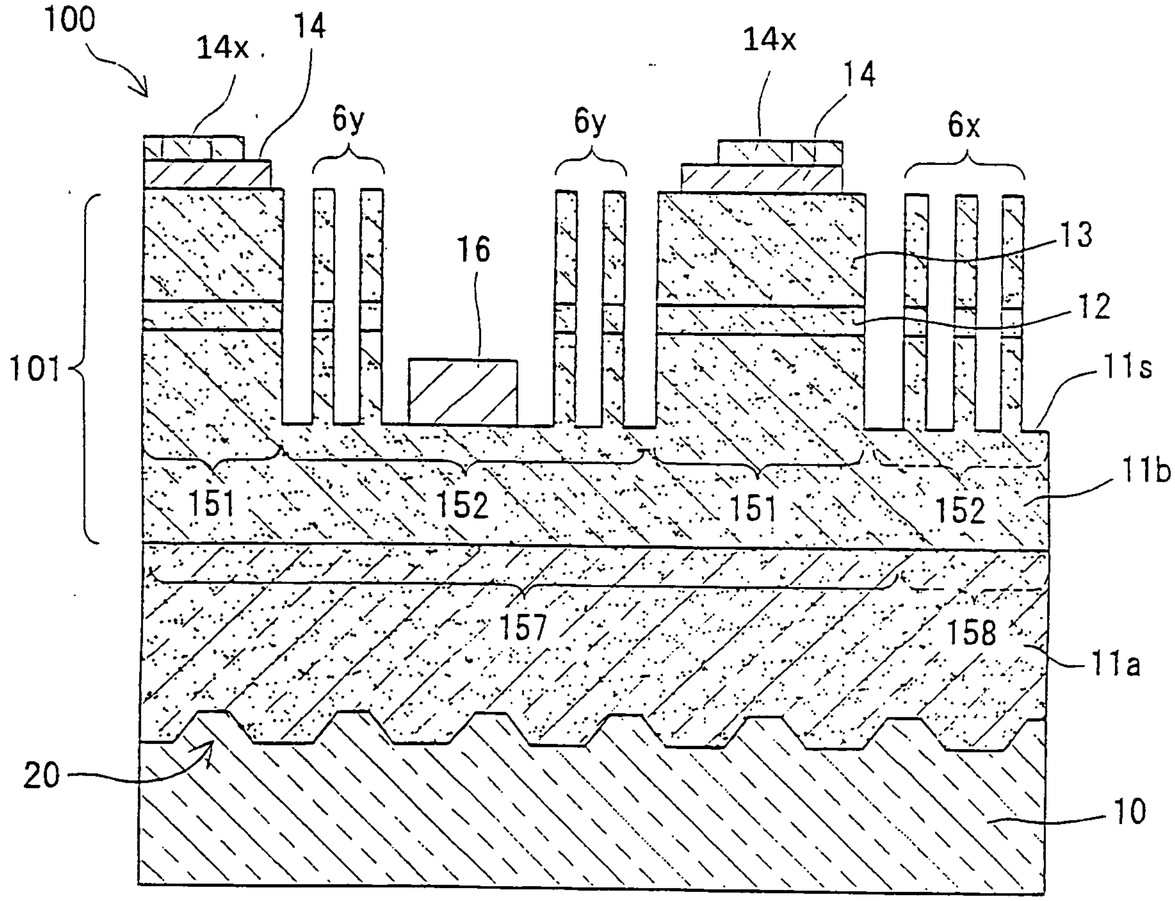
100
14x
14
6y
6y
14x
14
6x
16
13
12
101
11s
151
152
151
152
11b
157
158
11a
20
10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20030057444 A1
- WO 02103813 A1
- JP 11274568 A
- JP H11274568 A


### Non-patent literature cited in the description


- **YAMADA M. et al.** InGaN-Based Near-Ultraviolet and Blue-Light-Emitting Diodes with High External Quantum Efficiency Using a Patterned Sapphire Substrate and a Mesh Electrode. *Japanese Journal of Applied Physics,* 15 December 2002, vol. 41 (12B), L1431-L1433
- **GUAN J. J. et al.** Chemical Processing and Materials Compatibility of High-K Dielectric Materials for Advanced Gate Stacks. *Solid State Phenomena,* 2001, vol. 76-77, 19-22